# EUROPÄISCHE PATENTSCHRIFT

(11) **EP 4 294 767 B1**
(45) Veröffentlichungstag und Bekanntmachung des Hinweises auf die Patenterteilung: **06.11.2024**
(21) Anmeldenummer: 22707087.7
(22) Anmeldetag: 18.02.2022
(51) Int. Cl.: C03B 23/035, C03B 25/02, C03B 40/00, C03C 17/06, B81B 7/00, B81C 1/00, C03C 17/00, C03C 27/00, H01L 25/16, H01L 31/0203, H01L 33/44, H01L 33/48, H01L 33/58, H01L 33/62, H01S 5/02208, H01S 5/02257, H01S 5/0683

(54) **VERFAHREN ZUR HERSTELLUNG EINES DECKELSUBSTRATS, VERFAHREN ZUR HERSTELLUNG EINES HERMETISCH GEHÄUSTEN, OPTOELEKTRONISCHEN BAUELEMENTS UND HERMETISCH GEHÄUSTES, OPTOELEKTRONISCHES BAUELEMENT**
METHOD FOR PRODUCING A COVER SUBSTRATE, METHOD FOR PRODUCING A HERMETICALLY ENCLOSED, OPTOELECTRONIC COMPONENT AND HERMETICALLY ENCLOSED OPTOELECTRONIC COMPONENT
PROCÉDÉ DE PRODUCTION D'UN SUBSTRAT DE COUVERTURE, PROCÉDÉ DE PRODUCTION D'UN COMPOSANT OPTOÉLECTRONIQUE HERMÉTIQUEMENT FERMÉ ET COMPOSANT OPTOÉLECTRONIQUE HERMÉTIQUEMENT FERMÉ

(30) Priorität: 19.02.2021 EP 21158288
(43) Veröffentlichungstag der Anmeldung: 27.12.2023
(73) Patentinhaber: Fraunhofer-Gesellschaft zur Förderung der angewandten Forschung e.V., 80686 München (DE)
(72) Erfinder: REINERT, Wolfgang, 25524 Itzehoe (DE); STENCHLY, Vanessa, 25524 Itzehoe (DE); QUENZER, Hans-Joachim, 25524 Itzehoe (DE); KÄHLER, Dirk, 25524 Itzehoe (DE)
(74) Vertreter: Hersina, Günter
(86) Internationale Anmeldenummer: PCT/EP2022/054057
(87) Internationale Veröffentlichungsnummer: WO 2022/175439

(56) Entgegenhaltungen:
- WO-A1-2019/020708
- DE-A1- 2 524 731

## Beschreibung

### Technisches Gebiet

Die vorliegende Erfindung bezieht sich auf ein Verfahren zur Herstellung eines Deckelsubstrats, wie z. B. zur Herstellung eines Deckelsubstrats zum Häusen (= Unterbringen in einem Gehäuse) eines oder einer Mehrzahl von optischen oder optoelektronischen Bauelementen, wobei ein bei dem Herstellungsverfahren geformtes Abdeckungssubstrat das Deckelsubstrat mit zumindest einem Deckelelement bildet. Die vorliegende Erfindung bezieht sich ferner auf ein Verfahren zur Herstellung eines hermetisch gehäusten, optischen oder optoelektronischen Bauelements, wobei die Herstellung einzeln (auf Einzelsubstratebene) oder auf Waferebene durchgeführt werden kann. Die vorliegende Erfindung bezieht sich ferner auf ein hermetisch gehäustes, optisches oder optoelektronisches Bauelement, das mit diesem Herstellungsverfahren hergestellt bzw. gehäust wird.

Beispielsweise wird ein Verkappungskonzept für optische oder optoelektronische Bauelemente, wie z. B. für LEDs oder Laserdioden, bereitgestellt, wobei das Herstellungsverfahren auf Waferebene und/oder Einzelsubstratebene durchgeführt werden kann, um die optoelektronischen Bauelemente mit einem Deckelsubstrat mit optisch passiven (= optisch neutralen), seitlichen Fensterbereichen zu häusen.

### Technischer Hintergrund

Momentan finden beispielsweise blaue und grüne Laserdioden immer breitere Einsatzfelder. Etabliert und weit verbreitet ist die Verwendung blauer Laserdioden als entscheidende Komponente beim Auslesen hochdichter, optischer Speichermedien, wie z. B. Blu-ray. Inzwischen zeichnen sich vielfältige weitere Anwendungen leistungsstarker blauer und grüner Laserdioden ab, wie etwa als RGB-Quellen in mobilen Bild- und Videoprojektionen (Projektoren). Sowohl grüne als auch blaue Laserdioden sollten immer hermetisch dicht in einem Gehäuse verpackt (gehäust) werden. Es ist möglich, derartige Laserdioden mit einer Verkappungstechnologie mit speziellen TO-Headern (z. B. TO 38) mit integriertem optischen Fenster und Kupferwärmesenke zu verkappen.

Neben den genannten Consumer-Anwendungen gibt es auf dem Gebiet der medizinischen und industriellen Spektroskopie ebenfalls einen Bedarf an hermetisch verkapselten Halbleiter-basierten Lichtquellen mit besonders guter Wärmeabfuhr und organikfreiem Gehäuse, um die erforderlichen hohen Lebensdauern zu garantieren.

Die DE 25 24 731 A1 bezieht sich auf ein Verfahren zur Herstellung eines Gegenstands aus Glas mit mindestens einem gewölbten Teil.

Die WO 2019/020708 A1 bezieht auf eine MEMS-Spiegelanordnung und auf ein Verfahren zur Herstellung einer MEMS-Spiegelanordnung.

Die der vorliegenden Erfindung zugrundeliegende Aufgabe besteht daher darin, ein verbessertes Verfahren zur Herstellung eines Deckelsubstrats, z. B. zur Verkappung von optoelektronischen (strahlungsemittierenden oder strahlungsempfindlichen) Bauelementen bereitzustellen, und ferner ein verbessertes Verfahren zur Herstellung eines hermetisch gehäusten, optoelektronischen Bauelements bereitzustellen, wodurch dementsprechend gehäuste, optoelektronische Bauelemente mit verbesserten Eigenschaften geschaffen werden können.

Diese Aufgabe wird durch den Gegenstand der unabhängigen Patentansprüche gelöst.

Spezifische Ausgestaltungen, Implementierungen und Weiterbildungen der vorliegenden Anmeldung sind in den abhängigen Patentansprüchen definiert.

### Überblick über das erfindungsgemäße Konzept (= Verfahren und Vorrichtung)

Die vorliegende Erfindung basiert auf der Erkenntnis, dass mit den gezeigten Herstellungsverfahren ein Deckelsubstrat mit Glasabschlussdeckelelementen für die Häusung von optoelektronischen Bauelementen erhalten und bereitgestellt werden können, wobei die Deckelelemente seitlich sehr dünne optische (= optisch neutrale) Glasfensterflächen (zur lateralen Abstrahlung) aufweisen. Die optische Brechkraft sehr dünner optischer Glasfenster ist so gering, dass (häufig) keine optisch plane Fläche erforderlich ist, um einen Glasabschlussdeckel für die Gehäusung (Häusung) von optoelektronischen (strahlungsemittierenden oder strahlungsempfindlichen) Bauelementen (Halbleiterbauelementen) herzustellen. Diese dünnwandigen Fensterflächen verhalten sich optisch passiv bzw. optisch neutral (= haben keinen optischen Effekt). Insbesondere ist dann keine Planarität erforderlich, wenn die Dickenänderungen des Fensters hinreichend klein sind. Da (relevante) Laserdioden im Wesentlichen immer eine Variation in deren Winkelverteilung (Divergenzanteil) der Emission haben, spielen auch kleine Veränderungen keine (wesentliche) Rolle für die optischen Eigenschaften des Gehäuses. Sofern die von den Halbleiteremittern abgegebene Strahlung (bzw. die von den Halbleiter-Empfängern empfangene Strahlung) kollimiert, fokussiert oder umgelenkt werden soll, geschieht dies durch zusätzliche optische Bauelemente, die entweder innerhalb der versiegelten Gehäusung oder außerhalb auf einer sogenannten optischen Bank montiert sind.

Eine weitere Erkenntnis der vorliegenden Erfindung besteht zudem darin, dass ein solches Deckelsubstrat für ein verbessertes, gehäustes, optoelektronisches (strahlungsemittierendes oder strahlungsempfangenes) Bauelement (Halbleiterbauelement) besonders vorteilhaft auf Waferebene mit deutlich vereinfachtem Aufwand hergestellt werden kann. Nutzt man ein Formsubstrat zum Ausformen von Deckelsubstraten durch Glasfließverfahren, können optisch weitgehend neutrale Fensterbereiche in einem Deckelsubstrat ausgebildet werden, womit man empfindliche Strahlungsquellen oder Strahlungsempfänger anschließend hermetisch dicht verkappen kann.

Ein Formsubstrat ist beispielsweise ein Substrat mit einer Form, Kontur oder Topographie, wie z. B. ein topographisch strukturiertes Substrat.

Gemäß Ausführungsbeispielen kann somit ein solches Deckelsubstrat (= geformtes Abdeckungssubstrat) für ein verbessertes, gehäustes optoelektronisches Bauelement besonders vorteilhaft auf Waferebene mit deutlich vereinfachtem Aufwand hergestellt werden, weil z. B. nur ein (einziges) Glasmaterial eingesetzt wird. Nutzt man ein Formsubstrat zum Ausformen von Deckelsubstraten durch Glasfließverfahren, können ferner eine große Anzahl von Glaskappen mit gleichartig geformten, optisch neutralen Fensterbereichen in einem Deckelsubstrat ausgebildet werden, womit empfindliche optoelektronische Bauelemente, z. B. empfindliche Strahlungsquellen oder Empfangselemente, anschließend hermetisch dicht verkappt werden können. Sofern Gründe der Aufbautechnik es erfordern, können diese geformten Glas-Deckelsubstrate auch vereinzelt werden und die Deckel können für eine Einzelverkappung auf bestimmten Trägersubstraten sowohl auf Waferwie auch auf Einzelsubstratebene eingesetzt werden.

Somit kann erreicht werden, dass die gehäusten, optoelektronischen (strahlungsemittierenden und/oder strahlungsempfindlichen) Bauelemente (Halbleiterbauelemente) eine lange Lebensdauer bei gleichbleibend guter Strahl- und Leistungsqualität aufweisen. Insbesondere kann eine Eintrübung des Auslassfensters und eine Beschädigung der Laserfacetten verringert oder verhindert werden, da eine Einwirkung von Wasserdampf und/oder flüchtiger organischer Komponenten unter Einwirkung der extrem intensiven und energiereichen Laserstrahlung verringert oder verhindert werden kann. Zudem kann die Wärmeabfuhr aus dem Gehäuse verbessert werden. Ferner können aufgrund eines relativ niedrigen Herstellungsaufwands niedrige Herstellungskosten erreicht werden.

### Kurzbeschreibung der Zeichnungen und Figuren

Bevorzugte Ausführungsbeispiele der vorliegenden Erfindung werden nachfolgend unter Bezugnahme auf den beiliegenden Zeichnungen und Figuren näher erläutert. Es zeigen:
- Fig. 1: ein schematisches Flussdiagramm des erfindungsgemäßen Herstellungsverfahrens gemäß einem Ausführungsbeispiel;
- Fig. 2-6: beispielhafte prinzipielle Ablaufdiagrame des erfindungsgemäßen Herstellungsverfahrens gemäß weiteren Ausführungsbeispielen;
- Fig. 7: ein schematisches Flussdiagramm des erfindungsgemäßen Verfahrens zur Herstellung eines hermetisch gehäusten, optoelektronischen Bauelements gemäß einem weiteren Ausführungsbeispiel;
- Fig. 8-10: beispielhafte prinzipielle Ablaufdiagramme des erfindungsgemäßen Verfahrens zur Herstellung eines hermetisch gehäusten, optoelektronischen Bauelements gemäß weiteren Ausführungsbeispielen; und
- Fig. 11-16: beispielhafte Ausführungsformen für ein hermetisch gehäustes, optoelektronisches Bauelement gemäß weiteren Ausführungsbeispielen, die beispielsweise jeweils mit dem hier beschriebenen Herstellungsverfahren hergestellt werden.

Bevor nachfolgend Ausführungsbeispiele der vorliegenden Erfindung im Detail anhand der Zeichnungen näher erläutert werden, wird darauf hingewiesen, dass identische, funktionsgleiche oder gleichwirkende Elemente, Objekte, Funktionsblöcke und/oder Verfahrensschritte in den unterschiedlichen Figuren mit den gleichen Bezugszeichen versehen sind, so dass die in unterschiedlichen Ausführungsbeispielen dargestellte Beschreibung dieser Elemente, Objekte, Funktionsblöcke und/oder Verfahrensschritte (mit gleichen Bezugszeichen) untereinander austauschbar ist bzw. aufeinander angewendet werden kann.

### Detaillierte Beschreibung der Figuren und Ausführungsbeispiele

In der nachfolgenden Beschreibung bedeutet die Beschreibung eines Elements aus einem Halleitermaterial, dass das Element ein Halbleitermaterial aufweist, d.h. zumindest teilweise oder auch vollständig aus dem Halbleitermaterial gebildet ist. In der nachfolgenden Beschreibung bedeutet die Beschreibung eines Elements aus einem Glasmaterial, dass das Element ein Glasmaterial aufweist, d.h. zumindest teilweise oder auch vollständig aus dem Glasmaterial gebildet ist.

Es versteht sich, dass, wenn ein Element als mit einem anderen Element "verbunden" oder "gekoppelt" bezeichnet wird, es direkt mit dem anderen Element verbunden oder gekoppelt sein kann oder Zwischenelemente vorhanden sein können. Wenn im Gegensatz ein Element als "direkt" mit einem anderen Element "verbunden" oder "gekoppelt" bezeichnet wird, sind keine Zwischenelemente vorhanden. Sonstige zum Beschreiben des Verhältnisses zwischen Elementen benutzten Ausdrücke sollten auf gleichartige Weise ausgelegt werden (z.B. "zwischen" gegenüber "direkt zwischen", "benachbart" gegenüber "direkt benachbart" usw.).

Zur Vereinfachung der Beschreibung der unterschiedlichen Ausführungsbeispiele weisen zumindest einige der Figuren ein kartesisches Koordinatensystem x, y, z auf, wobei die Richtungen x, y, z orthogonal zueinander angeordnet sind. Bei den Ausführungsbeispielen entspricht die x-y-Ebene dem Hauptoberflächenbereich eines Trägers bzw. Substrats (= Referenzebene = x-y-Ebene), wobei die dazu vertikale Richtung nach oben bezüglich der Referenzebene (x-y-Ebene) der "+z"-Richtung entspricht, und wobei die Richtung vertikal nach unten bezüglich der Referenzebene (x-y-Ebene) der "-z"-Richtung entspricht. In der folgenden Beschreibung bedeutet der Ausdruck "lateral" eine Richtung parallel zu der x- und/oder y-Richtung, d. h. parallel zu der x-y-Ebene, wobei der Ausdruck "vertikal" eine Richtung parallel zu der +/- z-Richtung angibt.

Im Rahmen der vorliegenden Beschreibung sind in Klammern gesetzte Begriffe und/oder Textpassagen beispielhaft als weitere Erläuterungen, beispielhafte Ausgestaltungen, Ergänzungen und/oder beispielhafte Alternativen (zu dem voranstehenden Begriff oder der voranstehenden Textpassage) zu verstehen.

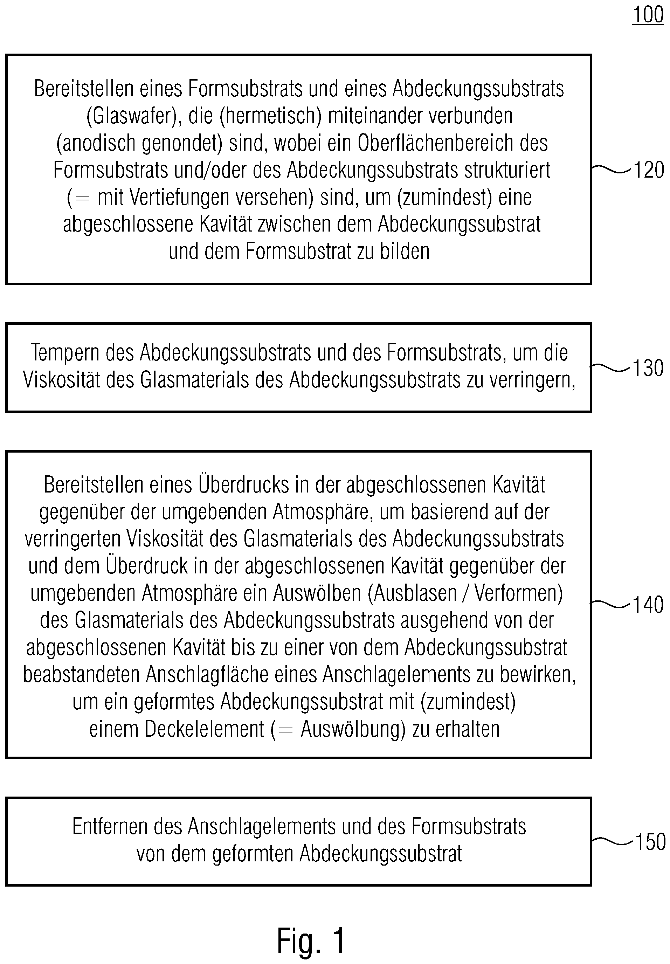

Fig. 1 zeigt nun beispielhaft ein prinzipielles Flussdiagramm des erfindungsgemäßen Herstellungsverfahrens 100 gemäß einem Ausführungsbeispiel. So zeigt das Flussdiagramm von Fig. 1 beispielsweise ein Verfahren 100 zur Herstellung eines Deckelsubstrats zum Häusen eines oder einer Mehrzahl von optischen oder optoelektronischen Bauelementen (Halbleiterbauelementen), wobei das geformte Abdeckungssubstrat dann das Deckelsubstrat mit dem zumindest einem Deckelelement zum Häusen des optoelektronischen Bauelements bildet. Ein optoelektronisches Bauelement (Halbleiterbauelement) ist beispielsweise ein strahlungsemittierendes und/oder strahlungsempfindliches Halbleiterbauelement, wie z. B. ein optoelektronisches Sendebauelement und/oder Empfangsbauelement.

Da für das erfindungsgemäße Verfahren zur Herstellung eines Deckelsubstrats zum Häusen eines oder einer Mehrzahl von optischen/optoelektronischen Bauelementen, z. B. auf Waferebene, ein ein Halbleitermaterial aufweisendes Formsubstrat eingesetzt wird, das beispielsweise als ein vorbearbeiteter Silizium-Wafer ausgebildet ist, wird im Nachfolgenden auch von einem Silizium-Formsubstrat oder Silizium-Wafer gesprochen. Es sollte aber deutlich werden, dass die Verwendung von Silizium als Material für das Formsubstrat (Halbleiter-Wafer) nur beispielhaft ist, wobei je nach Anwendungsfall bzw. Herstellungsprozess beispielsweise auch andere, geeignet prozessierbare Materialien oder Halbleitermaterialien für das Formsubstrat eingesetzt werden können.

Bezugnehmend auf das Verfahren 100 von Fig. 1 werden nun bei Schritt 120 ein Formsubstrat und ein Abdeckungssubstrat, die miteinander verbunden sind, bereitgestellt, wobei ein Oberflächenbereich des Formsubstrats und/oder des Abdeckungssubstrats strukturiert (ausgebildet) sind, um (zumindest) eine abgeschlossene Kavität zwischen dem Abdeckungssubstrat und dem Formsubstrat zu bilden.

Gemäß einem Ausführungsbeispiel kann das Formsubstrat als ein Halbleitersubstrat (Halbleiter-Wafer oder Silizium-Wafer) und das Abdeckungssubstrat als ein Glassubstrat bzw. Glaswafer ausgebildet sein. Gemäß einem Ausführungsbeispiel sind das Formsubstrat und das Abdeckungssubstrat hermetisch miteinander verbunden bzw. gefügt, wobei dies beispielsweise mit einem anodischen Bond-Vorgang oder auch einem anderen Fügevorgang erreicht werden kann. Ferner ist ein Oberflächenbereich des Formsubstrats und/oder des Abdeckungssubstrats mit einer Vertiefung bzw. mehreren Vertiefungen (Ausnehmungen) versehen, um die abgeschlossene Kavität zwischen dem Abdeckungssubstrat und dem Formsubstrat zu bilden.

Das Abdeckungssubstrat weist beispielsweise ein einziges homogenes Material bzw. Glasmaterial auf, um mit den folgenden Herstellungsschritten daraus das geformte Abdeckungssubstrat als Deckelsubstrat bzw. Glaskappen zu bilden.

Das Formsubstrat ist beispielsweise ein Substrat mit einer Form, Kontur oder Topographie, wie z. B. ein topographisch strukturiertes Substrat. Das Formsubstrat kann beispielsweise als ein Halbleiter-Wafer, z. B. ein Silizium-Wafer, ausgebildet sein, wobei die Oberflächenstrukturierung bzw. die Topographie des Formsubstrats mittels Halbleiterbearbeitungsprozessschritten (z. B. Siliziumbearbeitungsprozessschritten) sehr exakt erhalten werden kann. Solche Halbleiterbearbeitungsprozesse, wie z. B. fotolithographische Prozesse mit Nass- oder Trockenätzprozesse, werden technisch äußerst gut beherrscht. Ferner können auch mechanische Oberflächenbearbeitungsverfahren, z. B. für ein CNC-Fräsen, zum Bilden der Struktur in dem Formsubstrat angewendet werden. Ferner können neben Halbleitermaterialien, wie z. B. Si, SiGe, beispielsweise auch andere Materialien, wie z. B. AIN, SiC, hochschmelzendes Glas (z. B. Schott AF 32), für das Formsubstrat eingesetzt werden, die für ein fotolithographisches oder mechanisches Oberflächenbearbeitungsverfahren zum Bilden der Struktur in dem Formsubstrat geeignet sind und ferner bei den Tempervorgängen (Temperaturbehandlungsvorgängen) während des Verfahrens zur Herstellung des Deckelsubstrats ausreichend temperaturstabil sind.

Bei einem (nachfolgenden) Schritt 130 wird nun das Abdeckungssubstrat und das Formsubstrat getempert, das heißt einer Temperaturbehandlung unterzogen bzw. erhitzt (erwärmt), um die Viskosität des Glasmaterials des Abdeckungssubstrats zu verringern. Ferner wird bei einem Schritt 140 ein Überdruck in der (zumindest einen) abgeschlossenen Kavität bzw. den abgeschlossenen Kavitäten gegenüber der umgebenden Atmosphäre bereitgestellt, um basierend auf der verringerten Viskosität des Glasmaterials des Abdeckungssubstrats und dem Überdruck in der abgeschlossenen Kavität gegenüber der umgebenden Atmosphäre ein definiertes Auswölben, z. B. Ausblasen oder Verformen, des Glasmaterials des Abdeckungssubstrats ausgehend von der abgeschlossenen Kavität bis zu einer von dem Abdeckungssubstrat beabstandeten Anschlagfläche eines Anschlagelements zu bewirken. Das definierte Auswölben des Glasmaterials aufgrund des Überdrucks in der abgeschlossenen Kavität und der verringerten Viskosität des Glasmaterials kann auch als Ausblasen oder Verformen des Glasmaterials bezeichnet werden. Durch das definierte Auswölben des Glasmaterials des Abdeckungssubstrats wird somit ein geformtes Abdeckungssubstrat mit (zumindest) einem Deckelelement (= Auswölbung oder Verformung) erhalten. Als Deckelelement wird somit die erhaltene Auswölbung oder Verformung des geformten Abdeckungssubstrats (= Deckelsubstrat) bezeichnet.

Aufgrund des definierten Auswölbens des Glasmaterials des Abdeckungssubstrat werden in dem resultierenden Deckelement des geformten Abdeckungssubstrats Seitenflächen mit einer hohen Planarität (geringen Dickenänderungen der Seitenfenster) erhalten, so dass "optisch passive" Seitenfenster in den jeweiligen Deckelelementen des geformten Abdeckungssubstrats erhalten werden. Als optische Fensterflächen werden beispielsweise solche Bereiche des Deckelwafers angesehen, deren Wanddickenhomogenität über den vom Strahl ausgeleuchteten Bereich sich nicht mehr als 15% oder 10% unterscheidet. Die Wandstärke der optisch passiven (= neutralen) Seitenfenster in den jeweiligen Deckelelementen, d.h. im optisch durchstrahlten Bereich der Deckelelemente, wird beispielsweise mit dem dargestellten Herstellungsverfahren so dünn und gleichmäßig ausgeführt, dass der optische Einfluss auf die Strahldivergenz vernachlässigbar ist, d.h. beispielweise eine Divergenz von kleiner 0,5° oder auch kleiner 0,3°. Hierzu wird die Wandstärke der Seitenfenster in diesem Bereich nicht dicker als 200 µm, 120 µm oder 60 µm ausgebildet, zum Beispiel in einem Dickenbereich zwischen 5 und 200 µm, zwischen 5 und 120 µm oder zwischen 5 und 60 µm. Als Divergenz der Sende- und oder Empfangsstrahlung wird im Rahmen der vorliegenden Beschreibung die Aufweitung bzw. der Abstrahlwinkel der einfallenden oder ausgehenden Strahlung, z. B. eines Laserstrahls und/oder einer LED-Strahlung, bezeichnet.

Ein wichtiger Unterschied der optisch dünnen Seitenfenster zu einer Linse besteht nun darin, dass ein Fenster soweit wie möglich optisch neutral ist oder nur wie ein sehr langbrennweitige Linse (= Linse mit langer Brennweite) wirkt. Letzter Fall kann für Laser (als Lichtquellen) toleriert werden, da zum einen die Emissionswinkel der Laser selbst eine Schwankungsbreite besitzen und zum anderen ohnehin optische Linsen zur Strahlformung benötigt und einjustiert werden. Soweit auch hier eine niedrige Brechkraft und eine möglichst große Homogenität des Fensters vorliegt, können die optischen Fehler höherer Ordnung (coma, sphärische Aberration usw.) unterhalb einer kritischen Grenze liegen. So kann realisiert werden, dass die Wellenfronten durch die aufsummierten nicht globalen Zernicke-Koeffizienten (global: lateral, tilt, globaler focus; nicht global z.B. coma, sphärische Aberration usw.) eine Größe von ca. 150 nm RMS in der Wellenfront-Deformation nicht übersteigen. Dies kann bei der vorliegenden Herstellungstechnologie dadurch erreicht werden, dass das Fenster dünn ausgestaltet wird, wodurch die optische Brechkraft des Fensters reduziert wird und ferner herstellungsbedingt die Innen- und Außenflächen des Fensters immer ähnlicher werden. Beide Effekte führen zu deutlich verringerten optischen Fehlern.

Gemäß einem Ausführungsbeispiel wird also bei dem Schritt des Temperns und des Bereitstellens eines Überdrucks eine hohe Planarität der Oberflächen und eine hohe Parallelität der Innen- und Außenflächen der lateralen Seitenwandbereiche des Deckelelements des geformten Abdeckungssubstrats erreicht.

Bei einem nachfolgenden Schritt 150 wird nun das Anschlagelement und das Formsubstrat von dem geformten Abdeckungssubstrat entfernt, wobei nun das geformte Abdeckungssubstrat das Deckelsubstrat mit dem zumindest einem Deckelelement bildet. Wie die nachfolgenden Ausführungen noch zeigen werden, kann das Deckelsubstrat zum Häusen eines oder einer Mehrzahl von optischen oder optoelektronischen Bauelementen eingesetzt werden.

Wie im Vorhergehenden bereits angesprochen wurde, weist das Abdeckungssubstrat gemäß einem Ausführungsbeispiel ein einziges homogenes Material, wie z. B. ein Glasmaterial, auf, um das geformte Abdeckungssubstrat, das heißt das Deckelsubstrat bzw. die Glaskappe, aus einem einzigen umgebenden Material zu bilden. Somit sind auch die einzelnen Deckelelemente einteilig (einstückig) aus einem einzigen homogenen Material, z. B. dem Glasmaterial, ausgebildet.

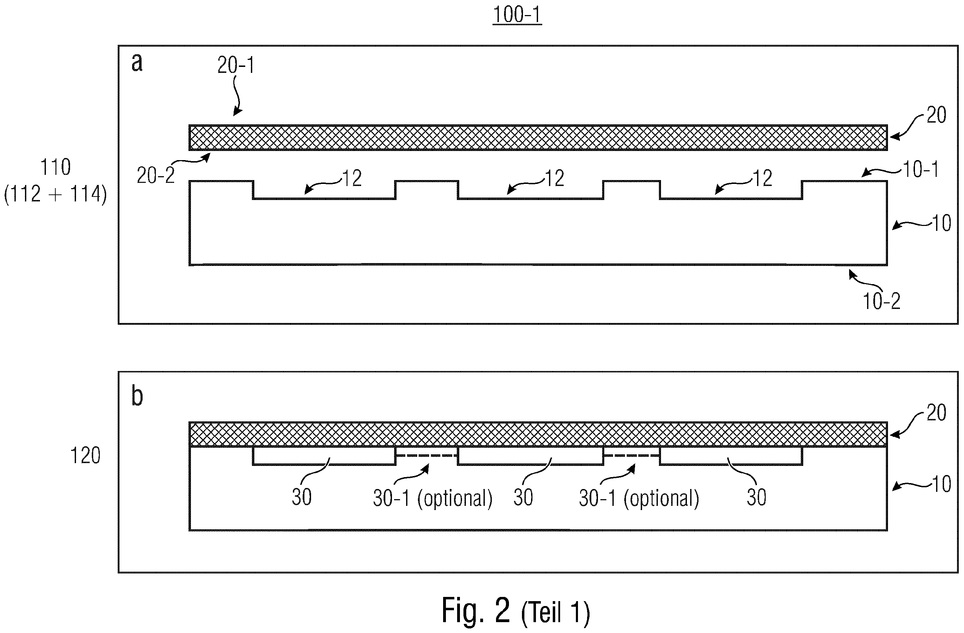

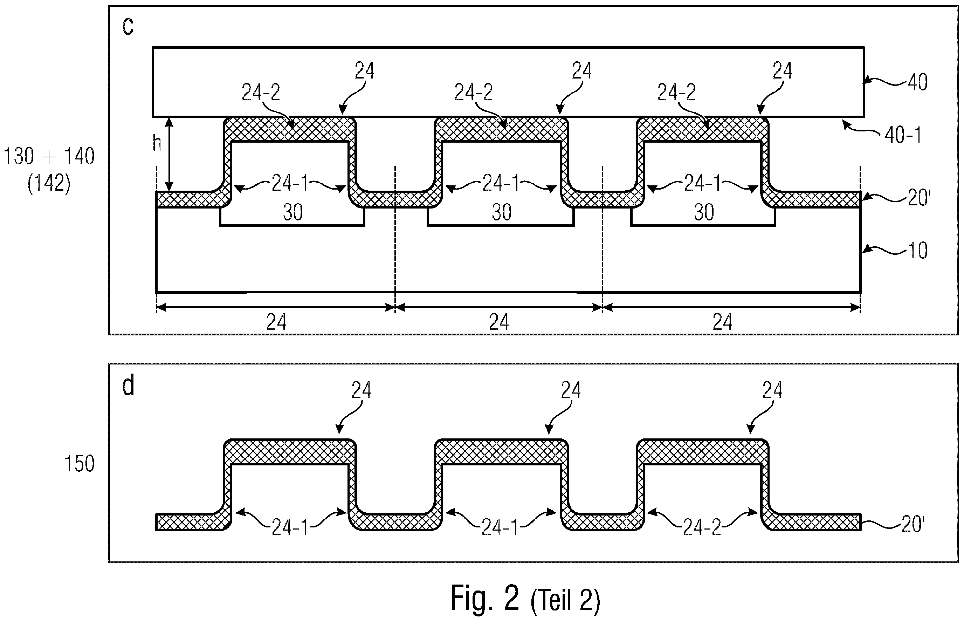

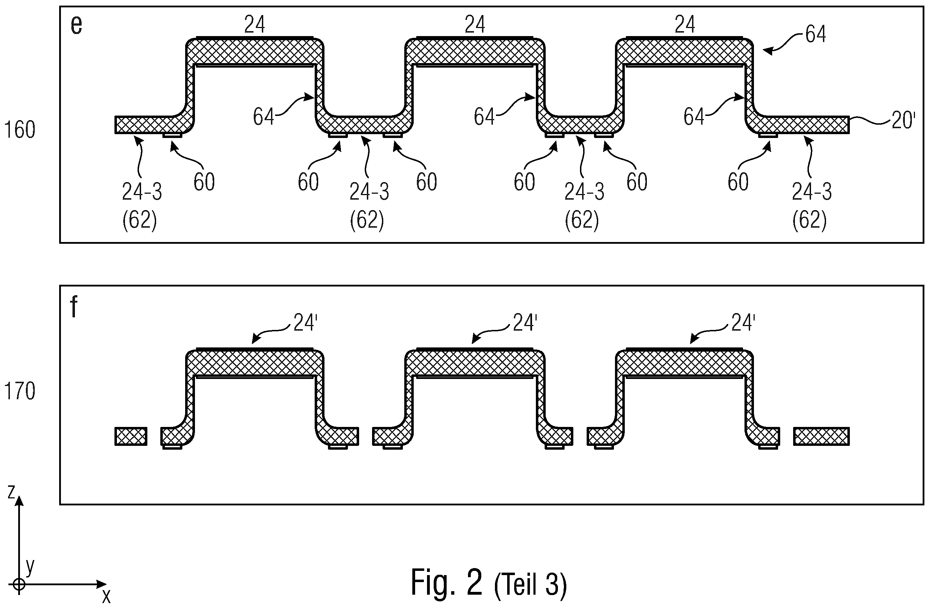

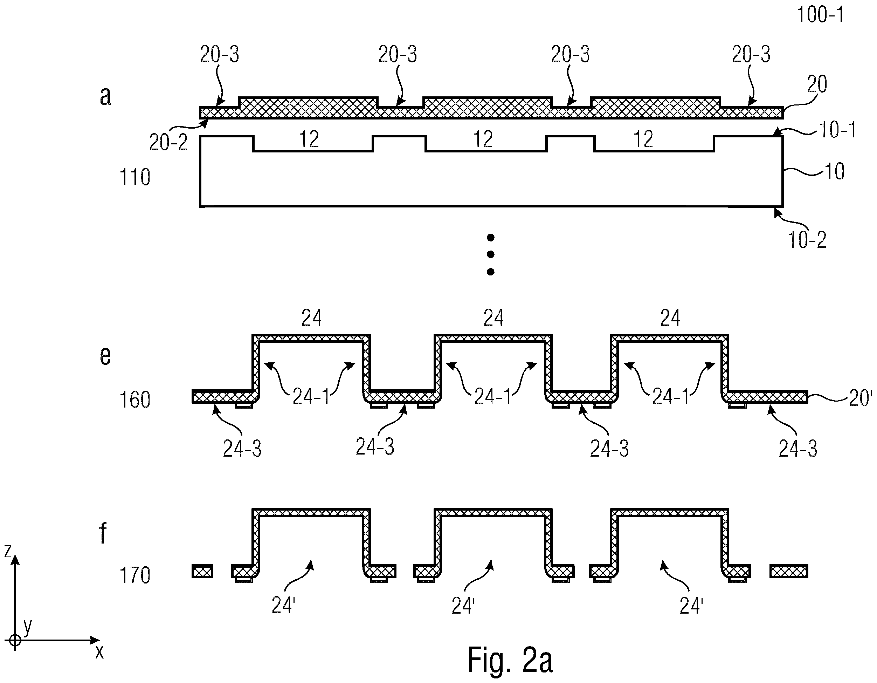

In diesem Zusammenhang wird beispielsweise auch auf die Fig. 2-6 und die zugehörige Beschreibung der prinzipiellen Ablaufdiagramme möglicher Implementierungen des erfindungsgemäßen Herstellungsverfahrens 100 verwiesen, bei denen diese Verfahrensschritte gezeigt bzw. umgesetzt werden.

Gemäß einem Ausführungsbeispiel kann nun der Schritt 120 des Bereitstellens des Formsubstrats und des Abdeckungssubstrats, die miteinander verbunden sind, folgende Schritte (Teilschritte) aufweisen. So wird zunächst in einem Schritt 110 das Formsubstrat, z. B. ein Silizium-Wafer, mit dem strukturierten (= mit Vertiefungen bzw. Ausnehmungen versehenen) Oberflächenbereich bereitgestellt. Ferner wird das Abdeckungssubstrat, z. B. ein Glaswafer, bereitgestellt.

Bei einem Schritt 112 wird das Abdeckungssubstrat auf dem strukturierten Oberflächenbereich des Formsubstrats angeordnet, wobei das Abdeckungssubstrat ein Glasmaterial aufweist. So kann beispielsweise der Oberflächenbereich des Abdeckungssubstrat, der an dem Formsubstrat anliegt (= diesem gegenüberliegt), eben bzw. plan (= ohne Ausnehmungen oder Vertiefungen) ausgebildet sein.

Bei einem Schritt 114 wird nun das Abdeckungssubstrat mit dem Formsubstrat verbunden bzw. gefügt, z. B. mittels anodischem Bonden oder einer anderen Fügetechnik hermetisch verbunden, um zumindest eine abgeschlossene Kavität (oder eine Mehrzahl von abgeschlossenen Kavitäten) zwischen dem Abdeckungssubstrat und dem Formsubstrat zu bilden. Dabei bildet die in dem Formsubstrat angeordnete Vertiefung bzw. bilden die in dem Formsubstrat angeordneten Vertiefungen dann jeweils die zumindest eine abgeschlossene Kavität zwischen dem Abdeckungssubstrat und dem Formsubstrat.

Gemäß einem weiteren Ausführungsbeispiel kann der Schritt 110 des Bereitstellens des Formsubstrats und des Abdeckungssubstrats ferner folgende Schritte bzw. Teilschritte aufweisen. So kann bei einem Schritt 112-1 das Formsubstrat, z. B. ein Silizium-Wafer, bereitgestellt werden. Bei einem Schritt 114-1 kann das Abdeckungssubstrat, z. B. ein Glaswafer, das einen strukturierten (= mit Vertiefungen versehenen) Oberflächenbereich aufweist, auf dem Formsubstrat angeordnet bzw. positioniert werden. So kann beispielsweise der Oberflächenbereich des Formsubstrats, der an dem Abdeckungssubstrat anliegt bzw. diesem gegenüberliegt, eine ebene bzw. plane Form aufweisen.

Bei dem Schritt 114 wird nun wieder das Abdeckungssubstrat mit dem Formsubstrat verbunden bzw. gefügt, z. B. mittels anodischem Bonden oder mittels eines Fügevorgangs hermetisch verbunden, um die zumindest eine abgeschlossene Kavität oder die Mehrzahl von abgeschlossenen Kavitäten zwischen dem Abdeckungssubstrat und dem Formsubstrat zu bilden. Die zumindest eine abgeschlossene Kavität wird damit beispielsweise durch die in dem Abdeckungssubstrat angeordnete(n) Vertiefung(en) bzw. Struktur(en) ausgebildet.

Gemäß einem weiteren, alternativen Ausführungsbeispiel können sowohl das Formsubstrat als auch das Abdeckungssubstrat einen strukturierten, mit Vertiefungen versehenen Oberflächenbereich aufweisen, um gemeinsam die zumindest eine abgeschlossene Kavität zwischen dem Abdeckungssubstrat und dem Formsubstrat zu bilden. Dabei kann beispielsweise bei dem (ausgerichteten) Anordnen des Abdeckungssubstrats an dem Formsubstrat die jeweils in dem Abdeckungssubstrat und dem Formsubstrat vorgesehene Vertiefung in Ausrichtung zueinander gebracht werden, um dann bei dem Schritt des Verbindens, z. B. des hermetischen Verbindens mittels anodischem Bonden, die abgeschlossene Kavität(en) zwischen dem Abdeckungssubstrat und dem Formsubstrat zu bilden.

Gemäß einem Ausführungsbeispiel des Verfahrens wird das (hermetische) Verbinden des Abdeckungssubstrats mit dem Formsubstrat in einer Atmosphäre mit einem definierten atmosphärischen Umgebungsdruck durchgeführt, um einen definierten atmosphärischen Druck in den abgeschlossenen Kavitäten einzuschließen. In diesem Zusammenhang wird beispielsweise auch auf die anhand der Fig. 2-6 und der zugehörigen Beschreibung dargestellten Ausführungsbeispiele verwiesen.

Gemäß einem Ausführungsbeispiel des Verfahrens sind das Abdeckungssubstrat und/oder das Formsubstrat ausgebildet, um die abgeschlossene Kavität mit einer Mehrzahl von abgeschlossenen Kavitätsbereichen zwischen dem Abdeckungssubstrat und dem Formsubstrat zu bilden, wobei die abgeschlossenen Kavitätsbereiche fluidisch getrennt voneinander angeordnet sind. Gemäß einem weiteren Ausführungsbeispiel sind ferner Gasaustauschkanäle zwischen den von der Umgebungsatmosphäre abgeschlossenen Kavitätsbereichen vorgesehen, um diese fluidisch miteinander zu verbinden, um einen gemeinsamen definierten atmosphärischen Druck in den verbunden Kavitätsbereichen gegenüber der Umgebungsatmosphäre zu erhalten. In diesem Zusammenhang wird beispielsweise auch auf die Fig. 2-6 und die zugehörige Beschreibung verwiesen.

Gemäß einem Ausführungsbeispiel des Verfahrens 100 wird der Schritt des Temperns und des Bereitstellens eines Überdrucks als ein Glasfließprozess beispielsweise in einem Unterdruckofen durchgeführt, um in der abgeschlossenen Kavität einen definierten atmosphärischen Überdruck gegenüber der umgebenden Atmosphäre zu erhalten. In diesem Zusammenhang wird beispielsweise auch auf die Fig. 2-6 und die zugehörige Beschreibung verwiesen.

Gemäß einem Ausführungsbeispiel weist das Verfahren 100 ferner folgende Schritte auf: Abkühlen des Anschlagelements, des Formsubstrats und des geformten Abdeckungssubstrats, und anschließendes Entfernern des Formsubstrats mittels eines Ätzvorgangs, z. B. mittels eines Halbleiter-Ätzvorgangs oder eines Silizium-Ätzvorgangs des Halbleitermaterials oder des Silizium-Materials des Formsubstrats. In diesem Zusammenhang wird beispielsweise auch auf die Fig. 2-6 und die zugehörige Beschreibung verwiesen.

Gemäß einem Ausführungsbeispiel weist das Verfahren ferner folgenden Schritt auf: anschließendes Entfernen des Anschlagelements mittels eines Ätzvorgangs. In diesem Zusammenhang wird beispielsweise auch auf die Fig. 2-6 mit zugehöriger Beschreibung verwiesen.

Gemäß einem Ausführungsbeispiel des Verfahrens wird das Abdeckungssubstrat bei dem Schritt des Temperns und des Bereitstellens eines Überdrucks im Bereich der abgeschlossenen Kavität bis zu einer Höhe, die durch den vertikalen Abstand der Anschlagsfläche ("ebenen Anschlagsfläche") zu dem Abdeckungssubstrat vorgegeben ist, ausgewölbt bzw. ausgeblasen. In diesem Zusammenhang wird beispielsweise auch auf die Fig. 2-6 und die zugehörige Beschreibung verwiesen.

Gemäß einem Ausführungsbeispiel des Verfahrens 100 ist der der Kavität oder den Kavitätsbereichen gegenüberliegende Bereich der Anschlagfläche des Anschlagelements eben und parallel zu dem Hauptoberflächenbereich des Abdeckungssubstrats (parallel zur Referenzebene) ausgebildet, um bei dem Schritt des Temperns und des Bereitstellens eines Überdrucks einen ebenen Deckenbereich des Deckelelements zu bilden. In diesem Zusammenhang wird beispielsweise auch auf die Fig. 2-6 und die zugehörige Beschreibung verwiesen.

Gemäß einem Ausführungsbeispiel des Verfahrens wird bei dem Abkühlen des geformten Abdeckungssubstrats in einem Temperaturbereich über 650 °C, z. B. zwischen 650 °C und 950 °C oder zwischen 650 °C und 750 °C, ein atmosphärischer Überdruck in den abgeschlossenen Kavitäten gegenüber der umgebenden Atmosphäre bewirkt, um eine (z. B. konvexe) Wölbung der Seitenwandbereiche (= Seitenfenster = "optisch passive" Seitenfenster) des Deckelelements des geformten Abdeckungssubstrats nach außen zu erzeugen.

Gemäß einem Ausführungsbeispiel des Verfahrens 100 wird der Schritt des Temperns und des Bereitstellens eines Überdrucks in einem Unterdruckofen durchgeführt, wobei der atmosphärische Überdruck in den abgeschlossenen Kavitäten gegenüber der umgebenden Atmosphäre durch einen verringerten atmosphärischen Druck in dem Unterdruckofen erhalten wird. In diesem Zusammenhang wird beispielsweise auch auf die Fig. 2-6 und die zugehörige Beschreibung verwiesen.

Gemäß einem Ausführungsbeispiel des Verfahrens wird bei dem Abkühlen des geformten Abdeckungssubstrats in einem Temperaturbereich über 650 °C, z. B. zwischen 650 °C und 950 °C oder zwischen 650 °C und 750 °C, ein atmosphärischer Unterdruck in den abgeschlossenen Kavitäten gegenüber der umgebenden Atmosphäre bewirkt, um eine (konkave) Wölbung der Seitenwandbereiche (= Seitenfenster) des Deckelelements des geformten Abdeckungssubstrats nach innen zu erzeugen.

Gemäß einem Ausführungsbeispiel des Verfahrens 100 wird der Schritt des Temperns und des Bereitstellens eines Überdrucks in einem Unterdruckofen durchgeführt, wobei ferner der atmosphärische Unterdruck in den abgeschlossenen Kavitäten gegenüber der umgebenden Atmosphäre durch einen erhöhten atmosphärischen Druck in dem Unterdruckofen erhalten wird. In diesem Zusammenhang wird beispielsweise auf die Fig. 2-6 und die zugehörige Beschreibung verwiesen.

Gemäß einem Ausführungsbeispiel des Verfahrens 100 ist das Anschlagelement (= Chuck) als ein wiederverwendbares Werkzeug ausgeführt und weist eine Antihaftbeschichtung für das Glasmaterial des Abdeckungssubstrats zumindest an dem der Kavität gegenüberliegenden Bereich der Anschlagfläche oder einer gesamten Anschlagfläche auf. In diesem Zusammenhang wird beispielsweise auch auf die Fig. 2-6 und die zugehörige Beschreibung verwiesen.

Das Anschlagelement kann beispielsweise ein Halbleitermaterial, wie z. B. Silizium, aufweisen oder daraus bestehen, und eine zumindest bereichsweise oder auch vollständig ebene (plane) Anschlagfläche gegenüberliegend zu dem Abdeckungssubstrat aufweisen. Neben einem Halbleiterbauelement kann das Anschlagelement beispielsweise auch andere Materialien, wie z. B. Siliziumkarbid (SiC), Graphit oder Aluminiumnitrid (AIN) aufweisen oder daraus bestehen.

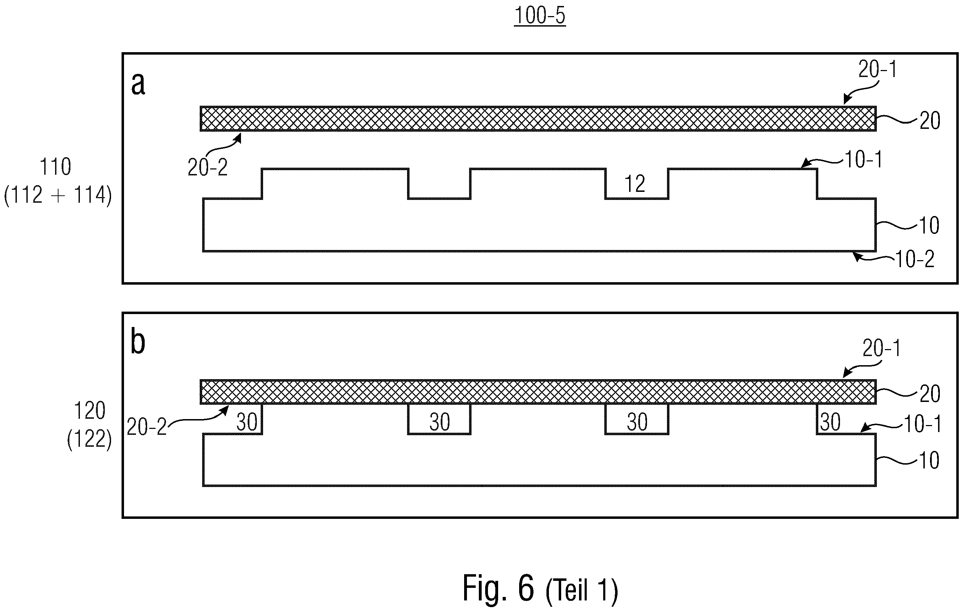

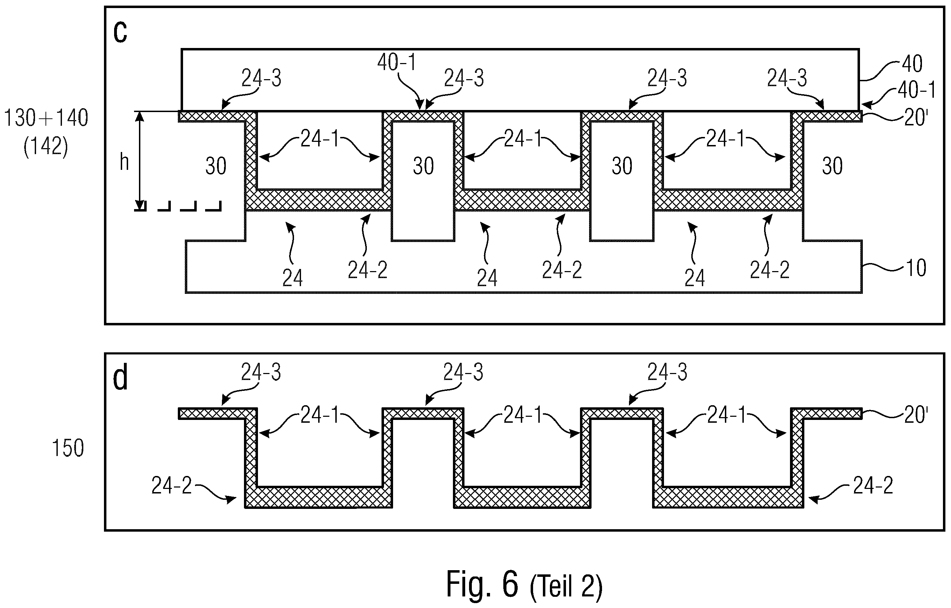

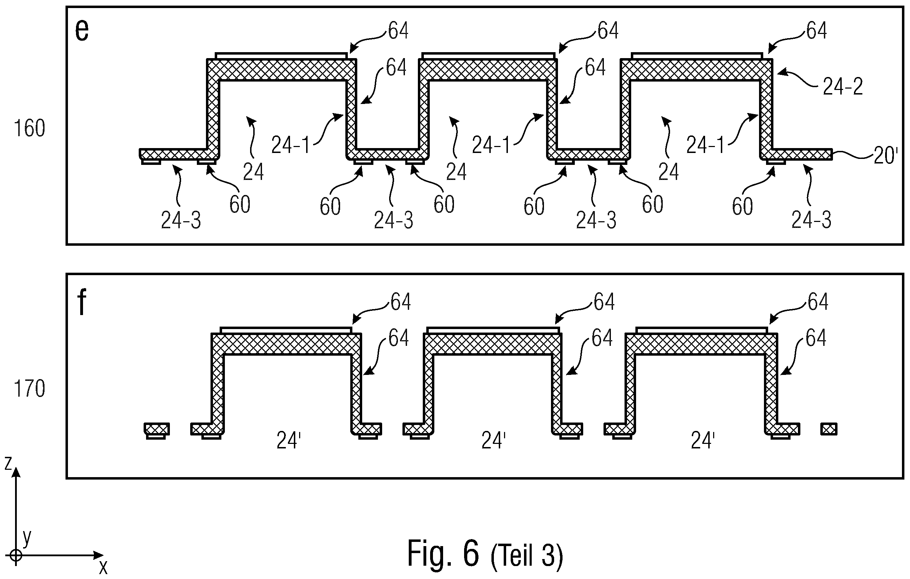

Die ebene Anschlagfläche in diesem Verfahren 100 kann als wiederverwendbares Werkzeug (siehe auch Fig. 6) mehrfach eingesetzt werden. Mehrere Materialien kommen für die Herstellung einer solchen Anschlagfläche prinzipiell in Frage, unter anderem temperaturfeste Stähle und Keramiken (beispielsweise SiC, Glaskohlenstoff oder andere), insbesondere dann, wenn diese Anschlagflächen zusätzlich mit einer Beschichtung, z.B. Graphit oder Bornitrid (BN), versehen werden, die ein Ankleben der Glasmasse verhindert. Durch Aufbringen einer solchen abweisenden Schutzschicht kann für ein Verfahren gemäß den Figuren 1 bis 6 auch eine solche Anschlagfläche aus Silizium gefertigt werden.

Gemäß einem Ausführungsbeispiel weist das Verfahren 100 ferner den Schritt des Aufbringens, wie z. B. Abscheidens, einer Metallisierung als eine zusammenhängende Rahmenstruktur (= einen Versiegelungsrahmen) auf Verbindungsbereichen an nicht-ausgewölbten Bereichen (= Sockelbereichen) des geformten Abdeckungssubstrats (= des Deckelsubstrats) auf. In diesem Zusammenhang wird beispielsweise auch auf die Fig. 2-6 und die zugehörige Beschreibung verwiesen.

Gemäß einem Ausführungsbeispiel des Verfahrens kann das Abdeckungssubstrat eine bereichsweise ausgebildete Ausnehmung (= bereichsweise Ausdünnung) in dem ersten Hauptoberflächenbereich aufweisen. Diese bereichsweise Ausnehmung kann nun vorgesehen sein, um beispielsweise den (bei dem Ausblasvorgang nicht-ausgewölbten) Sockelbereich der Deckelelemente des geformten Abdeckungssubstrats möglichst dünn auszugestalten. In diesem Zusammenhang wird beispielsweise auch auf die Fig. 2a und die zugehörige Beschreibung verwiesen.

Gemäß einem Ausführungsbeispiel des Verfahrens 100 wird eine Antireflexions-Beschichtung auf einem Bereich (Deckenbereich und/oder Seitenwandbereich) des Deckelelements des geformten Abdeckungssubstrats aufgebracht bzw. abgeschieden. In diesem Zusammenhang wird beispielsweise auch auf die Fig. 2-6 und die zugehörige Beschreibung verwiesen.

Im Folgenden werden nun noch einige weitere technische Erläuterungen zu den oben dargestellten unterschiedlichen Schritten des Herstellungsverfahrens 100 sowie den genannten Elementen bzw. Strukturen beispielhaft dargestellt. Diese nachfolgenden Ausführungen sind, sofern dies nicht anders angegeben ist) auf alle Ausführungsbeispiele anwendbar und als alternative oder zusätzliche Ausgestaltungen einzelner Verfahrensschritte bzw. einzelner Elemente oder Strukturen anzusehen.

Im Rahmen der vorliegenden Beschreibung wird das Formsubstrat beispielsweise mit einem topographisch strukturierten Oberflächenbereich (ersten Hauptoberflächenbereich) bereitgestellt. Das bedeutet, dass ein Oberflächenbereich (der erste Hauptoberflächenbereich) des Formsubstrats eine oder mehrere Vertiefungen aufweist. Dabei kann der Oberflächenbereich des Formsubstrats über seine gesamte laterale Ausdehnung bis einige Millimeter an bzw. vor dem Rand betrachtet die Vertiefungen aufweisen, um die Kavitäten und/oder Gasaustauschkanäle bei dem hermetischen Verbinden des Formsubstrats mit dem Abdeckungssubstrat zu erhalten. Das Formsubstrat kann also eine negative Topographie aufweisen.

Ferner können erste Vertiefungen (Kavitätsbereiche) in dem Formsubstrat dafür vorgesehen sein, Kavitäten bzw. Auswölbungen für ein optoelektronisches (strahlungsemittierendes oder strahlungsempfangendes) Bauelement in dem Deckelsubstrat durch Ausblasen während des Glasfließprozesses auszubilden. Ferner können benachbarte zweite Kavitätsbereiche dafür ausgebildet sein, einen Hohlraum für eine Vereinzelungsstraße (dicing lane) zu bilden, bzw. dazu zu dienen, bei nachfolgenden Prozessschritten die elektrischen Anschlusspads im Gehäuse freilegen zu können.

Gemäß der vorliegenden Beschreibung ist ferner auch eine Invertierung oder invertierte Anordnung dieser Funktionseinheiten möglich. So kann ein Kavitätsbereich bzw. eine Vertiefung gemäß der vorliegenden Beschreibung eine zur Substratoberfläche vertiefte Fläche oder Grabenstruktur sein, die durch einen Ätzprozess in das Formsubstrat eingebracht wurde. Grundgeometrien für die Kavitätsbereiche können von der erforderlichen Kappengeometrie (Deckelsubstratgeometrie) abhängen und sind im Wesentlichen geometrisch frei wählbar. So sind quadratische, rechteckige, Trapezoid-förmige und linear gestreckte Formen mit gegebenenfalls nicht unbedingt rechteckigen Ecken sowie auch andere Formen mit linearen Kantenabschnitten möglich. Ferner sind auch kreisförmige oder ellipsoide Grundformen möglich.

Unter Tempern (siehe Schritt 130) versteht man im Zusammenhang der vorliegenden Beschreibung ein Temperaturbehandeln, beispielsweise ein zeitlich kontrolliertes, homogenes Erhitzen oder Abkühlen, wobei dieser Temper-Schritt beispielsweise in einer definiert regelbaren Druckumgebung durchgeführt wird, d.h. mit definierten Umgebungsdruckbedingungen. Gemäß einem Ausführungsbeispiel kann der Schritt 130 des Temperns in einem Temperaturbereich über 650°C, z.B. zwischen 650°C und 955°C oder zwischen 650°C und 750°C durchgeführt werden.

Ein Glasmaterial im Sinne der vorliegenden Beschreibung ist beispielsweise ein amorpher anorganischer Werkstoff, dessen Viskosität sich bei steigender Temperatur (z. B. kontinuierlich) verringert.

Bei dem dargestellten Herstellungsverfahren 100 wird ein Deckelsubstrat (geformtes Abdeckungssubstrat) mit einem oder mehreren Deckelelementen erzeugt, wobei das Deckelelement einen seitlichen und einen oberen Seitenwandbereich aufweist, die auch als optische Fensterbereiche wirksam sein können. Diese optischen Fensterbereiche erlauben eine zum Trägersubstrat laterale bis vertikale Strahlaus- und/oder Strahleinkopplung.

Gemäß dem dargestellten Herstellungsverfahren 100, wird das Deckelsubstrat, das auch als Kappen- oder Deckelwafer bezeichnet werden kann, mit den lateralen, optisch passiven Fensterflächen aus Glas beispielsweise für eine Vielzahl von Gehäusen hergestellt. Die lateralen, optisch passiven Fensterflächen können somit beispielsweise vertikal (= sich vertikal erstreckend) zu dem ursprünglichen Hauptoberflächenbereich des Abdeckungssubstrats ausgebildet werden.

Das dargestellte Verfahren basiert wesentlich auf Techniken des sogenannten Glasflie-βens. Bei den Ausführungsformen kann es sich bei dem Glasmaterial des Abdeckungssubstrats um Borofloat^{®} -Glas oder ein anderes Glas wie z.B. Schott AF32, Corning Eagle XG, Hoya SD2 handeln. Der thermische Ausdehnungskoeffizient (CTE = coefficient of thermal expansion) der Glasmaterialien wird z.B. gewählt, um zum verwendeten Halbleitermaterial zu passen, da sowohl die Herstellung des Deckelwafers (Deckelsubstrats) als auch das Bonden des Deckelwafers auf dem Halbleitermaterial des Formsubstrats, beispielsweise auf einem Siliziumsubstrat, erfolgen. Zu große Unterschiede des thermischen Ausdehnungskoeffizienten könnten ansonsten zu sehr großen thermomechanischen Spannungen oder zur Zerstörung der beteiligten Elemente führen, wenn der CTE des Glasmaterials des Abdeckungssubstrats nicht (z.B. innerhalb eines Toleranzbereichs von kleiner 1%, 5% oder 10%) an den CTE des Halbleitermaterials des Formsubstrats angepasst ist. Angepasst bedeutet dabei beispielsweise, dass das CTE des Glasmaterials in Ausführungsformen nicht um mehr als 1 - 2 ppm/K von dem CTE des Halbleitermaterials abweicht. In den Ausführungsformen weicht das CTE des Glasmaterials beispielweise um weniger als 0,5 ppm/K von dem CTE des Halbleitermaterials ab.

Das Abdeckungssubstrat 20 weist beispielsweise eine Dicke von 100µm bis 1500µm oder von 300µm bis 800µm auf. Damit kann eine Dicke der Fensterelemente 24-1, d.h. der für den Lichtdurchtritt wirksamen Bereiche der Fensterelemente 24-1, von 20µm bis 1200µm oder von 20µm bis 300µm erreicht werden. Eine Fensterdicke von 20µm bis 300µm wird z.B. für optische Durchtrittsfenster 24-1 vorgesehen. Der vertikale Abstand h der (ebenen) Anschlagsfläche 40-1 des Anschlagselement 40 zu dem (unverformten) Abdeckungssubstrat 20 beträgt z.B. 1.2 mm bis 10mm.

Eine mögliche Prozessabfolge bei der Herstellung dieser Deckelwafer mit optischen Fensterflächen wird beispielsweise nachfolgend anhand der Figuren 2-6 beschrieben. Dabei können diese Deckelwafer, also die Deckelsubstrate, mit integrierten vertikalen, konvexen oder konkaven optischen Fensterflächen hergestellt werden. Als optische Fensterflächen werden beispielsweise solche Bereiche des Deckelwafers angesehen, deren Wanddickenhomogenität über den vom Strahl ausgeleuchteten Bereich sich nicht mehr als 15% unterscheidet und/oder deren Oberflächen eine Rauigkeit kleiner 50 nm aufweisen. Optische Fensterflächen können geometrisch sehr unterschiedlich ausgeformt sein: sowohl vertikal plan, vertikal konkav, vertikal konvex, uni-axial geneigt, rotationssymmetrisch geneigt und ggfs. mit Offset, und planparallel zur Basisebene des Deckelwafers. Die optischen Fensterflächen dienen der Strahlauskopplung und/oder Strahleinkopplung für mindestens ein Strahlungs- bzw. Licht-emittierendes Bauelement und optional für einen oder mehrere Photodetektoren. Beispielsweise können auch mehrere optische Seitenfenster im gleichen Deckelelement an verschiedenen Seiten vorgesehen sein um z.B. eine laterale Strahlauskopplung und/oder Strahleinkopplung in unterschiedlichen Richtungen zu erlauben.

Bei den unterschiedlichen Ausführungsformen (z.B. den nachfolgend dargestellten Prozessabläufen in Fig. 2-6) des Verfahrens 100 ist vorgesehen, dass die Deckelelemente (= Glasdeckel) durch einen Temperprozess geformt werden. Die am Ende des Prozesses erzielte Geometrie wird von vier Größen beeinflusst, dem eingeschlossenen Gasvolumen, dem Temperaturverlauf, dem Druck im Ofen, sowie dem Abstand des Anschlags.

In einer möglichen (einfachen) Realisierung des Prozessablaufs ist der Druck im Ofen über die gesamte Zeit konstant, wobei der in der Kavität eingeschlossene Druck zumindest zeitweise größer ist als der Druck im Ofen. Die Ofentemperatur sollte einem Profil folgen, mit (bestehend aus) einer Erwärmungsphase, einer Prozessphase und einer Abkühlphase. Die Temperatur der Prozessphase sollte oberhalb der Erweichungstemperatur des Glases liegen, damit der Druck des eingeschlossenen Gases die Kavität aufblasen kann. Ist der Druck innerhalb der Kavität stets größer als der Druck im Ofen stellt sich eine konvexe Oberfläche der Wand ein. Wird der Prozess hingegen so geführt, dass sich der Druck in der aufgeblasenen Kavität an den Ofendruck annähert (Gleichgewichtszustand), kann durch eine Abkühlung des Ofens eine Druckumkehr erzielt werden, so dass der Druck im Ofen größer ist als innerhalb der Kavität. Dies führt zu einer Deformation der konvexen Oberfläche, so dass eine zumindest in Teilbereichen eine flache, fast plane Wand erzielt werden kann. Eine Geometriekontrolle wird jedoch durch das Aufblasen gegen einen Anschlag wesentlich erhöht. Im Extremfall ist es möglich, so auch einen konvexen Querschnitt der Wand zu erzielen. Abgesehen von dem beschriebenen Effekt der Temperaturänderung kann eine solche Umkehr der Druckverhältnisse auch durch eine Änderung des, z.B. geregelten, Ofendrucks erfolgen.

Eine weitere Möglichkeit die Geometrie der Kappe (des Deckelelements) zu beeinflussen ist die Bewegung des Anschlags während des Temperns. Wird das Glas zunächst auf eine Kugelform aufgeblasen bevor der Anschlag durch eine Verringerung des Abstands zum Substrat in Kontakt gebracht wird, entsteht ein Deckel der Kavität mit einer sehr homogenen Dicke. Wird die Distanz zwischen dem Substrat und dem Anschlag wieder vergrößert, nachdem das Glas mit ihm in Kontakt gekommen ist, führt dies zu einer Streckung der Wände. Der zunächst konvexe Querschnitt der Wände wird dadurch abgeflacht. Bei weiterer Vergrößerung der Distanz kommt es zu einer Einschnürung des Querschnitts im Bereich der Wände, wodurch diese einen konvexen Querschnitt erhalten.

Die Kombination der mechanischen Bewegung mit den zuvor beschriebenen Druck und Temperaturänderungen ermöglicht die gezielte Beeinflussung der Kappengeometrie und insbesondere des Wandquerschnitts.

Bei den unterschiedlichen Ausführungsformen (z.B. den nachfolgend dargestellten Prozessabläufen in Fig. 2-6) des Verfahrens 100 ist vorgesehen, dass bei den Schritten 110 und 112 das Formsubstrat und das Abdeckungssubstrat bereitgestellt werden und dieselben anodisch gebondet werden.

Gemäß einem Ausführungsbeispiel kann das Verfahren 100 hinsichtlich des Bereitstellens 110 des Formsubstrats folgende Schritte umfassen: Bereitstellen eines Halbleiterwafers mit einer Passivierungsschicht auf einer Oberfläche (= erster Hauptoberflächenbereich), Lithographieren der Passivierungsschicht, sodass die Lackschicht dort auf der Oberfläche entfernt wird, wo die Vertiefungen und Gaskanäle vorgesehen sind, Ätzen der Passivierungsschicht auf der Oberfläche des Halbleiterwafers hinsichtlich der lithographierten Bereiche, Entfernung der Lackschicht, Ätzen des exponierten Halbleitermaterials, sodass eine Dicke des Halbleiterwafers senkrecht zu den lithographierten Bereichen der Oberfläche verringert wird, um den Oberflächenbereich zu strukturieren und somit Vertiefungen, z.B. Kavitäten und Gaskanäle, vorzugeben, und vollständiges Entfernen der Passivierungsschicht.

Dadurch kann beispielsweise das Formsubstrat mit einem zweckmäßig strukturierten Oberflächenbereich hergestellt und bereitgestellt werden. Beispielsweise ist der Halbleiterwafer ein Siliziumwafer. Der Halbleiterwafer kann mit einer ätzfesten Passivierung beschichtet werden, beispielsweise aus LP-Nitrid (LP = low pressure) bei einem LP-CVD-Prozess (LP-CVD = low pressure chemical vapor deposition). Anschließend wird die Lithographie durchgeführt. Die Passivierung wird durch Plasmaätzen geöffnet. Die lithographierten Bereiche können durch plasmaunterstütztes Gasphasenätzen, beispielsweise anisotrophes Hochratenätzen oder isotrophes Naßätzen bearbeitet werden, sodass die Oberfläche des Halbleiterwafers hinsichtlich der lithographierten Bereiche geätzt wird. Schließlich wird die Passivierungsschicht beispielsweise dadurch vollständig entfernt, dass sie selektiv abgeätzt wird.

Gemäß einem Ausführungsbeispiel des ersten Verfahrens ist vorgesehen, dass das Verfahren bei dem Anordnen 112 und Verbinden 114 des Abdeckungssubstrats folgenden Schritt umfasst: Flächiges anodisches Bonden des mit Vertiefungen strukturierten Oberflächenbereichs des Formsubstrats mit dem aufliegenden Oberflächenbereich des Abdeckungssubstrats. Ein Glaswafer, der als Abdeckungssubstrat geeignet ist, kann beispielsweise (aus) Pyrex, (aus) Borofloat^{®} 33 oder ähnliche(n) Glasmaterialien mit niedrigem CTE aufweisen (bestehen). Derartige Glasmaterialien können sich dadurch auszeichnen, dass sie besonders gut in Glasfließprozessen verwendet werden können.

Gemäß einem Ausführungsbeispiel kann der Überdruck zum Auswölben des Glasmaterials des Abdeckungssubstrats erhalten werden, indem in den abgeschlossenen Kavitäten 30 zwischen dem Abdeckungssubstrat 20 und dem Formsubstrat 10 ein erhöhter Gasdruck eingeschlossen wird, um den Überdruck in den Kavitäten 30 gegenüber der umgebenden Atmosphäre zu erhalten. So kann beispielsweise der Bondvorgang 114 des Abdeckungssubstrats 20 und des Formsubstrats 10 in einer definierten Atmosphäre durchgeführt werden, um einen so hohen, definierten Gasdruck in den Kavitäten und Kanalstrukturen 30 einzuschließen, so dass der nachfolgende Prozess des Auswölbens des Glasmaterials des Abdeckungssubstrats auch bei einem normalen Umgebungsdruck oder einem entsprechenden (reduzierten) Unterdruck der Umgebungsatmosphäre durchgeführt werden kann. Ein eingeschlossener Gasdruck in den Kavitäten 30 kann also vorgesehen sein, um das Ausblasen des Glasmaterials durch eine Druckdifferenz zu bewirken oder (zumindest) zu unterstützen.

Alternativ oder zusätzlich kann der atmosphärische Überdruck in den abgeschlossenen Kavitäten 30 gegenüber der Umgebungsatmosphäre auch in einen sog. Unterdruckofen erhalten werden, indem der Unterdruckofen die umgebende Atmosphäre für den Herstellungsprozess mit einem atmosphärischen Unterdruck (gegenüber dem eingestellten Gasdruck in den Kavitäten 30) bereitstellt.

Im Folgenden werden nun anhand der Fig. 2-6 beispielhafte Prozessfolgen bzw. Prozessabläufe zur Implementierung des in Fig. 1 dargestellten, prinzipiellen Herstellungsverfahrens 100 beschrieben. In den Fig. 2-6 erstreckt sich die Zeichenebene parallel zu der x-z-Ebene.

Alle nachfolgend beschriebenen Prozessalternativen des Verfahrens 100 basieren auf dem grundlegenden Konzept, dass ein Deckelsubstrat zum Häusen eines oder einer Mehrzahl von optischen (optoelektronischen) Bauelementen mittels eines heißviskosen Glasfließverfahrens hergestellt wird, wobei das geformte Abdeckungssubstrat das Deckelsubstrat mit dem zumindest einen optisch neutralen Deckelelement bildet. Das Deckelelement weist ein optisch neutrales (passives) Seitenfenster (= Glasfenster) auf. Dabei werden hermetisch abgeschlossene Kavitäten zwischen dem Abdeckungssubstrat und dem Formsubstrat genutzt, um beim Tempern des Abdeckungssubstrats und des Formsubstrats durch die Verringerung der Viskosität des Glasmaterials des Abdeckungssubstrats und durch das Bereitstellen eines Überdrucks in der abgeschlossenen Kavität gegenüber der umgebenden Atmosphäre ein definiertes Auswölben des Glasmaterials des Abdeckungssubstrats ausgehend von der abgeschlossenen Kavität bis zu einer von dem Abdeckungssubstrat beabstandeten Anschlagfläche zu bewirken. Dadurch wird das geformte Abdeckungssubstrat mit dem Deckelelement bzw. der Auswölbung erhalten. Dieses Deckelelement mit dem optisch passiven Glasfenster kann nun zur Häusung von optoelektronischen Bauelementen, wie z. B. strahlungsemittierenden und/oder strahlungsempfangenden Bauelementen, eingesetzt werden.

Fig. 2 zeigt nun ein beispielhaftes Ablaufdiagramm 100-1 des erfindungsgemäßen Herstellungsverfahrens 100 zur Herstellung eines Deckelsubstrats, das beispielsweise zum Häusen eines oder einer Mehrzahl von optischen bzw. optoelektronischen Bauelementen eingesetzt werden kann Die Fensterelemente können damit beispielsweise als aufgestellte Seitenfenster gebildet werden.

Bei Schritt 110 werden zunächst das Formsubstrat 10, z. B. ein Halbleiter- oder Silizium-Wafer, mit dem strukturierten Oberflächenbereich 10-1 bereitgestellt, d.h. das Formsubstrat 10 ist mit zumindest einer Vertiefung bzw. Ausnehmung 12 versehen. Ferner wird das Abdeckungssubstrat 20, z. B. ein Glaswafer, bereitgestellt.

Gemäß einem Ausführungsbeispiel kann das Formsubstrat 10 als ein Halbleitersubstrat (Halbleiter-Wafer oder Silizium-Wafer) und das Abdeckungssubstrat 20 als ein Glassubstrat bzw. Glaswafer ausgebildet sein. Das Formsubstrat 10 ist beispielsweise ein geformtes Substrat mit einer Form, Kontur oder Topographie, wie z. B. ein topographisch strukturiertes Substrat. Das Formsubstrat kann beispielsweise als ein Halbleiter-Wafer, z. B. ein Silizium-Wafer, ausgebildet sein, wobei die Oberflächenstrukturierung bzw. die Topographie des Formsubstrats mittels Halbleiterbearbeitungsprozessschritten bzw. Siliziumbearbeitungsprozessschritten äußerst exakt erhalten werden kann. Das Abdeckungssubstrat 20 weist beispielsweise ein einziges homogenes Material bzw. Glasmaterial auf, um mit den folgenden Herstellungsschritten daraus das geformte Abdeckungssubstrat 20 als Deckelsubstrat bzw. Glaskappe einstückig zu bilden.

Bei einem Schritt 112 wird das Abdeckungssubstrat 20 auf dem strukturierten Oberflächenbereich 10-1 des Formsubstrats 10 ausgerichtet angeordnet. So kann beispielsweise der zweite Hauptoberflächenbereich 20-2 des Abdeckungssubstrats 20, der an dem Formsubstrat 10, d.h. an den erhöhten Bereichen des strukturierten Oberflächenbereichs 10-1 des Formsubstrats 10 anliegt, eben bzw. plan sein und somit ohne Ausnehmungen oder Vertiefungen ausgebildet sein.

Bei einem Schritt 114 wird dann das Abdeckungssubstrat 20 mit dem Formsubstrat 10 verbunden bzw. gefügt, z. B. mittels anodischen Bondens hermetisch verbunden, um zumindest eine abgeschlossene Kavität 30 zwischen dem Abdeckungssubstrat 20 und dem Formsubstrat 10 zu bilden. Dabei bildet die in dem Formsubstrat 10 angeordnete Vertiefung 12 bzw. bilden die in dem Formsubstrat 10 angeordneten Vertiefungen 12 dann jeweils die zumindest eine abgeschlossene Kavität 30 zwischen dem Abdeckungssubstrat 20 und dem Formsubstrat 10.

Gemäß einem Ausführungsbeispiel des Ablaufdiagramms 100-1 des Verfahrens 100 wird das (hermetische) Verbinden 114 des Abdeckungssubstrats 20 mit dem Formsubstrat 10 in einer Atmosphäre mit einem definierten atmosphärischen Umgebungsdruck durchgeführt, um einen definierten atmosphärischen Druck in den abgeschlossenen Kavitäten 30 einzuschließen.

In der Vorbereitung des eigentlichen Herstellungsprozesses wird also das Formsubstrat 10, z.B. ein Silizium-Formsubstrat, mit einseitigen Kavitäten und Kanalstrukturen 12 (= Ausnehmungen oder Vertiefungen) versehen. Der Glaswafer 20 wird zu dem Formsubstrat 10 ausgerichtet und in einer definierten Atmosphäre beispielsweise anodisch gebondet, um einen (definierten) Gasdruck in den Kavitäten und Kanalstrukturen 30 einzuschließen.

Gemäß einem Ausführungsbeispiel des Ablaufdiagramms 100-1 des Verfahrens 100 sind das Abdeckungssubstrat 20 und/oder das Formsubstrat 10 ausgebildet sind, um die abgeschlossene Kavität 30 mit einer Mehrzahl von abgeschlossenen Kavitätsbereichen 30 zwischen dem Abdeckungssubstrat 20 und dem Formsubstrat 10 zu bilden, wobei die abgeschlossenen Kavitätsbereiche 30 fluidisch getrennt voneinander angeordnet sind, oder wobei ferner Gasaustauschkanäle 30-1 zwischen den von der Umgebungsatmosphäre abgeschlossenen Kavitätsbereichen 30 vorgesehen sind, um diese fluidisch miteinander zu verbinden, um einen gemeinsamen definierten atmosphärischen Druck in den verbundenen Kavitätsbereichen 30 zu erhalten.

Bei Schritt 120 werden also das Formsubstrat 10 und das Abdeckungssubstrat 20, die miteinander verbunden sind, bereitgestellt, wobei der Oberflächenbereich 10-1 des Formsubstrats 10 strukturiert (mit Vertiefungen oder Kanalstrukturen 12 ausgebildet) ist, um die zumindest eine abgeschlossene Kavität 30 zwischen dem Abdeckungssubstrat 20 und dem Formsubstrat 10 zu bilden. Bei Schritt 120 wird also beispielweise ein anodisch gebondetes Glas-Silizium- Deckelsubstrat 10, 20 erhalten bzw. bereitgestellt.

Bei einem (nachfolgenden) Schritt 130 wird nun das Abdeckungssubstrat 20 und das Formsubstrat 10 getempert, d.h. einer Temperaturbehandlung unterzogen bzw. erhitzt (erwärmt), um die Viskosität des Glasmaterials des Abdeckungssubstrats 20 zu verringern. Ferner wird bei einem Schritt 140 ein Überdruck in der (zumindest einen) abgeschlossenen Kavität bzw. den abgeschlossenen Kavitäten 30 gegenüber der umgebenden Atmosphäre bereitgestellt, um basierend auf der verringerten Viskosität des Glasmaterials des Abdeckungssubstrats 20 und dem Überdruck in der abgeschlossenen Kavität 30 gegenüber der umgebenden Atmosphäre ein definiertes Auswölben, z. B. Ausblasen oder Verformen, des Glasmaterials des Abdeckungssubstrats 20 ausgehend von der abgeschlossenen Kavität 30 bis zu einer von dem Abdeckungssubstrat 20 beabstandeten Anschlagfläche 40-1 eines Anschlagelements 40 zu bewirken. Das definierte Auswölben des Glasmaterials des Abdeckungssubstrats 20 aufgrund des Überdrucks in der abgeschlossenen Kavität 30 und der verringerten Viskosität des Glasmaterials kann auch als Ausblasen oder Verformen des Glasmaterials bezeichnet werden. Durch das definierte Auswölben des Glasmaterials des Abdeckungssubstrats 20 wird somit ein geformtes Abdeckungssubstrat 20' mit (zumindest) einem Deckelelement 24 (= Auswölbung oder Verformung) erhalten. Als Deckelelement 24 wird somit die erhaltene Auswölbung oder Verformung des geformten Abdeckungssubstrats (= Deckelsubstrat) 20' bezeichnet. Gemäß einem Ausführungsbeispiel kann der Schritt 130 des Temperns in einem Temperaturbereich über 650°C, z.B. zwischen 650°C und 955°C oder zwischen 650°C und 750°C durchgeführt werden.

Ferner wird durch das definierte Auswölben des Abdeckungssubstrats 20 das Ausbilden der Seitenfenster 24-1 an dem Deckelelement 24 bewirkt bzw. diese geformt. Der Seitenbereich des Deckelelements 24 wird auch als (optisch passives bzw. neutrales) Fensterelement oder optisch passives Glasfenster 24-1 (= laterales Fensterelement) bezeichnet.

Gemäß einem Ausführungsbeispiel des Ablaufdiagramms 100-1 des Verfahrens 100 wird der Schritt des Temperns 130 und des Bereitstellens 140 eines Überdrucks als ein Glasfließprozess in einem Unterdruckofen 50 durchgeführt, um in der abgeschlossenen Kavität 30 einen definierten atmosphärischen Überdruck gegenüber der umgebenden Atmosphäre zu erhalten
Gemäß einem Ausführungsbeispiel des Ablaufdiagramms 100-1 des Verfahrens 100 wird das Abdeckungssubstrat 20 bei dem Schritt des Temperns 130 und des Bereitstellens 140 eines Überdrucks im Bereich der abgeschlossenen Kavität 30 bis zu einer Höhe h, die durch den vertikalen Abstand der Anschlagfläche 40-1 des Anschlags 40 zu dem ersten Hauptoberflächenbereich 20-1 des Abdeckungssubstrats 20 vorgegeben ist, ausgewölbt bzw. ausgeblasen.

Gemäß einem Ausführungsbeispiel des Ablaufdiagramms 100-1 des Verfahrens 100 ist der der Kavität 30 oder den Kavitätsbereichen 30 gegenüberliegende Bereich der Anschlagfläche 40-1 des Anschlagelements 40 eben und parallel zu dem Hauptoberflächenbereich 20-1 des Abdeckungssubstrats 20 (= parallel zur Referenzebene) ausgebildet, um bei dem Schritt des Temperns 130 und des Bereitstellens 140 eines Überdrucks einen ebenen Deckenbereich 24-2 des Deckelelements 24 zu bilden. Gemäß einem Ausführungsbeispiel kann das Anschlagelement 40 als ein wiederverwendbares Werkzeug ausgeführt sein.

Die Durchführung des Glasfließprozesses 130, 140 kann also in einem druckkontrollierten Ofen 50 erfolgen. Der Glaswafer (Abdeckungssubstrat) 20 wird im Bereich der Kavitäten 30 ausgeblasen bis zu der Höhe h, die durch eine Anschlagfläche 40-1 des Anschlagelements 40 bestimmt werden kann. Der Anschlag 40 und damit die Anschlagfläche 40-1 ist beispielsweise eben ausgeführt. Nach dem Glasfließprozesses 130, 140 erfolgt beispielsweise ein Abkühlen des Deckelsubstrats 20' und Entnahme des Deckelsubstrats 20' aus dem Ofen 50. Nach dem Glasfließprozesses 130, 140 werden also die Wafer 10, 20` in dem ausgeblasenem Zustand abgekühlt.

Gemäß einem Ausführungsbeispiel des Ablaufdiagramms 100-1 des Verfahrens 100 kann bei einem Schritt 142 das Abkühlen des geformten Abdeckungssubstrats 20' definiert durchgeführt werden, um eine konvexe oder eine konkave Wölbung der Seitenwandbereiche (Seitenfenster) 24-1 des Deckelelements 24 des geformten Abdeckungssubstrats 20' zu erzeugen.

Bei einem nachfolgenden Schritt 150 wird nun das Anschlagelement 40 und das Formsubstrat 10 von dem geformten Abdeckungssubstrat 20' entfernt, wobei nun das geformte Abdeckungssubstrat 20' das Deckelsubstrat 20' mit dem zumindest einen Deckelelement 24 bildet. Das Deckelsubstrat 20' kann z.B. zum Häusen eines oder einer Mehrzahl von optischen oder optoelektronischen Bauelementen eingesetzt werden.

Gemäß einem Ausführungsbeispiel kann das Ablaufdiagramm 100-1 des Verfahrens 100 ferner den Schritt 142 des Abkühlens des Anschlagelements 40, des Formsubstrats 10 und des geformten Abdeckungssubstrats 20' aufweisen, wobei dann bei dem Schritt 150 anschließend das Formsubstrat 10 mittels eines Ätzvorgangs, z.B. eines Silizium- oder Halbleiter-Ätzvorgangs des Silizium- oder Halbleiter-Material des Formsubstrats, entfernt wird.

Gemäß einem Ausführungsbeispiel wird der Schritt 150 des Entfernens des Anschlagelements 40 auch mittels eines Ätzvorgangs durchgeführt, z.B. mittels eines Silizium- oder Halbleiter-Ätzvorgangs des Silizium- oder Halbleiter-Materials des Anschlags 40.

Da das Abdeckungssubstrat 20 gemäß einem Ausführungsbeispiel ein einziges homogenes Material, z. B. ein Glasmaterial, aufweist, ist auch das geformte Abdeckungssubstrat 20', d. h. das Deckelsubstrat bzw. die Glaskappe, mit dem zumindest einen Deckelelement 24 einteilig (einstückig) und aus einem einzigen homogenen Material, z. B. dem Glasmaterial, ausgebildet.

Bei Schritt 150 wird somit z.B. ein Glas-Deckelsubstrat 20' mit den Seitenfenstern 24-1 der Glaskappen 24 nach der beidseitigen Entfernung des Siliziums des Formsubstrats 10 und des Anschlagelements 50 erhalten. Die Seitenfenstern 24-1 können umlaufend oder segmentiert ausgebildet sein.

Bei einem (optionalen) nachfolgenden Schritt 160 kann der Prozessablauf 100-1 des Verfahrens 100 ferner ein Aufbringen bzw. Abscheiden einer Metallisierung 60 als eine (zusammenhängende) Rahmenstruktur bzw. als ein Versiegelungsrahmen auf Verbindungsbereichen 62 an dem zweiten Hauptoberflächenbereich 20-2 an nicht-ausgewölbten Bereichen (Sockelbereichen) 24-3 der Deckelelemente 24 des geformten Abdeckungssubstrats (des Deckelsubstrats) 20' aufweisen.

Gemäß einem Ausführungsbeispiel kann bei Schritt 160 ferner eine Antireflexions-Beschichtung 64 auf einen innenseitigen und/oder außenseitigen Bereich, z.B. innenseitig und/oder außenseitig auf den Deckenbereich 24-2 und/oder Seitenwandbereich 24-1, des Deckelelements 24 des geformten Abdeckungssubstrats 20' aufgebracht oder abgeschieden werden.

Bei dem optionalen Schritt 160 kann somit eine Abscheidung von Versiegelungsrahmen 60 und/oder optionale Antireflexbeschichtungen 64 auf das Deckelsubstrat 20' erfolgen. Mit diesem Glas-Deckelsubstrat 20' können dann optische Aufbauten auf Waferebene hermetisch versiegelt werden, wie dies nachfolgend noch erläutert wird.

Bei einem (optionalen) nachfolgenden Schritt 170 kann der Prozessablauf 100-1 des Verfahrens 100 ferner ein Vereinzeln des geformten Abdeckungssubstrats 20' aufweisen, um vereinzelte Deckelelemente 24` zu erhalten. Das Vereinzeln 170 des Glas-Deckelsubstrats 20' kann beispielsweise durch Sägen oder Lasertrennung erfolgen. Mit den vereinzelten Kappen 24` können optische Aufbauten auf Einzelsubstratebene oder auf Waferebene durch Einzelverkappung hermetisch versiegelt werden, wie dies nachfolgend noch erläutert wird.

Im Folgenden werden nun nochmals einige Verfahrensschritte des Prozessablaufs 100-1 des Verfahrens 100 von Fig. 2 nochmals zusammengefasst dargestellt.

Fig. 2 zeigt also ein Flussdiagramm 100-1, das anhand der Schritte 110 bis 170 einen ersten Prozessablauf 100-1 zur Herstellung eines Deckelsubstrats 20' veranschaulicht. Das aus dem Herstellungsverfahren 100-1 resultierende Deckelsubstrat 20' weist nach dem Prozessablauf beispielsweise ein optisch passives (neutrales) Seitenfenster 24-1 auf, das integraler Bestandteil des Deckelelements 24 (Kappe) ist und eine laterale Strahlauskopplung und/oder Strahleinkopplung erlaubt. Beispielsweise können auch mehrere laterale (seitliche) Seitenfenster 24-1 (z.B. mit vertikaler Erstreckung) vorgesehen sein, die integraler Bestandteil des Deckelelements 24 (Kappe) des Deckelsubstrats 20' sind und eine laterale Strahlauskopplung bzw. Strahleinkopplung in unterschiedlichen Richtungen, z. B. in unterschiedlichen Richtungen parallel zur Referenzebene (x-y-Ebene), erlauben. Beispielsweise kann auch ein vertikales (oberes) Seitenfenster 24-2 (z.B. mit lateraler Erstreckung) vorgesehen sein, das integraler Bestandteil des Deckelelements 24 (Kappe) des Deckelsubstrats 20' ist und eine vertikale Strahlauskopplung bzw. Strahleinkopplung, z. B. senkrecht zur Referenzebene (x-y-Ebene), erlauben.

Der Prozessablauf 100-1 von Fig. 2 umfasst also als einen Schritt 110 des Bereitstellens des Formsubstrats mit einem strukturierten (mit Vertiefungen versehenen) Oberflächenbereich, wobei das Formsubstrat ein Halbleitermaterial, wie z. B. Silizium, aufweist, oder aus dem Halbleitermaterial, z. B. Silizium, besteht. Es folgt darauf das Anordnen des unstrukturierten Abdeckungssubstrats auf dem strukturierten Oberflächenbereich des Formsubstrats. Das Abdeckungssubstrat weist ein Glasmaterial auf oder besteht aus einem Glasmaterial. Bei dem Anordnen des Abdeckungssubstrats an dem Formsubstrat wird die strukturierte Oberfläche des Formsubstrats mit einer Oberfläche des Abdeckungssubstrats mindestens teilweise überdeckend angeordnet und bei dem Verbinden des Abdeckungssubstrats mit dem Formsubstrat z.B. anodisch gebondet oder hermetisch gefügt. Dabei wird die strukturierte Oberfläche des Formsubstrats mit der Oberfläche des Abdeckungssubstrats z. B. gasdicht mit einer definierten eingeschlossenen Innenatmosphäre in den Vertiefungen (Kavitäten) verbunden.

Darauf folgt beispielsweise das Tempern 130 der verbundenen Substrate 10, 20 in einem Unterdruckofen derart, dass ein Ausblasen des Glasmaterials des Abdeckungssubstrats im Bereich der Vertiefungen durch den eingeschlossenen Druck in Relation zum Ofendruck bewirkt wird. Die Temperaturen werden dabei so gewählt, dass sich die Viskosität des Glasmaterials stark verringert und sich das Glasmaterial im Fensterbereich gut kontrolliert ausdehnen kann aber nicht zerfließt.

Um das Ausblasen zu unterstützen, kann eine, z.B. eingestellte, Druckdifferenz zwischen den Innenräumen bzw. Kavitäten, die zwischen den Substraten angeordnet sind, und der Umgebungsatmosphäre im Ofen vorliegen. Ein eingeschlossener Gasdruck in den Innenräumen kann vorgesehen sein, um das Ausblasen des Glasmaterials durch eine Druckdifferenz zu bewirken oder (zumindest) zu unterstützen. Dadurch kann der Vorgang in einem Temperschritt ausgeführt werden. Die vorliegende Druckdifferenz zwischen dem eingeschlossenen Gasdruck in den vertieften Innenräumen und dem kontrollierten Vakuum (Unterdruck) der Ofenatmosphäre unterstützt den ganzen Fließvorgang.

Bei dem Glasfließvorgang erfolgt ein Stopp der Fließfront an der Anschlagfläche 40-1 des Anschlagelements 40 in einstellbarem Abstand h im Unterdruckofen, wobei das Anschlagelement 40 mit der Anschlagfläche 40-1 z.B. einen Siliziumwafer aufweist oder aus einem Siliziumwafer besteht. Der Fließprozess mit Anschlagfläche 40-1 in einem statischen Abstand basiert also auf der verringerten Viskosität des Glasmaterials des Abdeckungssubstrats 20 und dem Überdruck in der abgeschlossenen Kavität 30 gegenüber der umgebenden Atmosphäre, wobei das Auswölben (Ausblasen / Verformen) des Glasmaterials des Abdeckungssubstrats 20 ausgehend von der abgeschlossenen Kavität 30 bis zu der von dem Abdeckungssubstrat 20 beabstandeten Anschlagfläche 40-1 des Anschlagelements 40 bewirkt wird, um das geformte Abdeckungssubstrat 20' mit dem (zumindest) einem Deckelelement (= Auswölbung) 24 zu erhalten.

Bei dem Glasfließvorgang 130, 140 erfolgt eine Abkühlung der verbundenen Substrate unter reproduzierbarer Temperatur- und Druckrampe und schließlich eine Entnahme des Deckelsubstrats 20' mit dem Formsubstrat und z.B. dem Anschlagelement 40 aus dem Ofen 50.

Dann erfolgt ein Entfernen 150 des Anschlagelements 40 und des Formsubstrates 10, um das aus dem Abdeckungssubstrat 20 durch den Ausblasprozess gewonnene strukturierte Deckelsubstrat 20' zu erhalten. Das Entfernen 150 kann ein Trennen oder ein selektives Abätzen des Halbleitermaterials des Formsubstrats 10 und/oder des Anschlagelements 40 mittels eines Ätzvorgangs (Silizium- oder Halbleiter-Ätzvorgang des Silizium- oder Halbleiter-Materials) bedeuten, z.B. in heißer Kalilauge. Auf diese Weise wird ein effektives Verfahren zur Herstellung eines Deckelsubstrats 20' zur Verkappung von strahlungsemittierenden Bauelementen bereitgestellt, da das Deckelsubstrat 20', das durch das Verfahren 100, wie es in Fig. 2-6 schematisch beschrieben ist, erhalten wird, ein (optisch passives) Auskoppelfenster 24-1 umfasst, das mittels des Fensterbauelements (Deckelelements) 24 gebildet wird.

Bei einer Ausführungsform des Verfahrens 100 zur Herstellung eines Deckelsubstrats 20' weist das resultierende Deckelsubstrat 20' beispielsweise ein Seitenfenster 24-1 auf, das integraler Bestandteil der Kappe (des Deckelelements) 24 ist und eine laterale (= seitliche) Strahlauskopplung erlaubt. Beispielsweise können auch mehrere Seitenfenster 24-1 vorgesehen sein, die integraler Bestandteil der Kappe 24 sind und eine laterale Strahlauskopplung in unterschiedlichen Richtungen, z.B. jeweils in einer unterschiedlichen Richtung, erlauben.

Bei dem optionalen Schritt 160 kann ferner ein Aufbringen (Abscheiden) der Metallisierung 60 als eine (zusammenhängende) Rahmenstruktur (ein Versiegelungsrahmen) auf Verbindungsbereichen 62 auf den zweiten Hauptoberflächenbereich 20-2 an den nicht-ausgewölbten Bereichen (Sockelbereichen) 62 des geformten Abdeckungssubstrats (Deckelsubstrats) 20' durchgeführt werden. Bei dem optionalen Schritt 160 kann ferner eine Antireflexions-Beschichtung 64 auf einen Bereich (Deckenbereich und/oder Seitenwandbereich) des Deckelelements 24 des geformten Abdeckungssubstrats 20' aufgebracht oder abgeschieden werden. Bei einem weiteren optionalen Schritt 170 kann das geformte Abdeckungssubstrat 20' vereinzelt werden, um vereinzelte Deckelelemente 24` zu erhalten.

Das im vorhergehenden dargestellte Herstellungsverfahren 100 mit dem beispielhaften Prozessablauf von Fig. 2 ist eine sehr effektive und einfache Vorgehensweise der Seitenfensteraufstellung an Seitenbereichen 24-1 des jeweiligen Deckelelements 24.

Hinsichtlich des in Fig. 2 dargestellten Herstellungsverfahrens 100 mittels des Flussdiagramms 100-1 wird nun in Fig. 2a eine weitere alternative Ausgestaltung des Abdeckungssubstrats 20 mit einem bereichsweise ausgebildeten Ausnehmung (= bereichsweise Ausdünnung) 20-3 in dem ersten Hauptoberflächenbereich 20-1 des Abdeckungssubstrats 20 dargestellt.

Diese bereichsweise Ausnehmung 20-3 kann nun vorgesehen sein, um beispielsweise den (nicht-ausgewölbten) Sockelbereich 24-3 der Deckelelemente 24 des geformten Abdeckungssubstrats (= Deckelsubstrat) 20' möglichst dünn auszugestalten, das heißt, um den Sockelbereich 24-3 zumindest angrenzend an den lateralen Strahlaustrittsbereich 24-1 möglichst dünn bzw. flach auszugestalten. Dadurch kann erreicht werden, dass bei einer (nachfolgenden) Häusung eines an einem Bauelementesubstrat angeordneten optischen Bauelements (Sende- und/oder Empfangsbauelements) eine möglichst niedrige, erforderliche Aufbauhöhe des optischen Bauelements oberhalb der Bauelementsubstratebene erhalten wird. Damit kann bei dem optoelektronischen Bauelement erreicht werden, dass dieses Bauelement (z. B. ein Laseremitter oder eine Photodiode) nicht mit zusätzlichem Aufwand z.B. erhöht auf einem Submount aufgebaut werden braucht, um eine Kollision der Sende- oder Empfangsstrahlung des optischen Bauelements mit einem ansonsten erhöhten Glassockel zu vermeiden.

Gemäß diesem Ausführungsbeispiel kann den Sockelbereich 24-3 des Deckelelements 24 zumindest in Richtung des lateralen Strahldurchgangs der Sende- oder Empfangsstrahlung des optoelektronischen Bauelements (relativ) flach ausgebildet werden, um das optoelektronische Bauelement nicht auf einer zusätzlichen Erhöhung, z.B. auf einem (erhöhten) Submount, auf dem Bauelementsubstrat aufbauen zu brauchen, damit die Sende- und/oder Empfangsstrahlung des optoelektronischen Bauelements 1 nicht mit dem Sockelbereich (Glassockel) 24-3 des Deckelelements kollidiert bzw. von diesem gestört wird.

Hierzu wird das Glasmaterial des Abdeckungssubstrats 20 bereits mit einem ausgedünnten Bereich 20-3 an der Oberseite (= an dem ersten Hauptoberflächenbereich) 20-1 auf das Formsubstrat 10 aufgelegt, wobei sich diese Ausdünnung 20-3 mindestens in der Strahlauskoppelrichtung bis in den Rahmenbereich des Abdeckungselements (der Glaskappe) 24 oder z.B. bis hin zum Vereinzelungsbereich des Abdeckungssubstrats 20' erstreckt.

Diese Ausdünnung 20-3 kann sich auch in den Bereich der noch auszublasenden Fensterfläche 24-1 erstrecken, die nach dem Auswölbungsvorgang z.B. vertikal stehend angeordnet ist, um z.B. im Strahldurchtrittsbereich ein besonders dünnwandiges Fensterelement mit einer geringen optischen Wirkung zu erzeugen. Zudem weist das dünnwandige Fensterelement aufgrund des flach ausgebildeten Sockelbereichs 24-3 einen großen Strahldurchtrittsbereich auf, ohne bei dem Ausblasvorgang der Glaskappe (des Abdeckungssubstrats) 20 dieses besonders hoch ausblasen zu brauchen.

Fig. 2a zeigt beispielhaft ein solches mit Ausdünnungsbereichen 20-3 versehenes Abdeckungssubstrat bei dem Schritt 110 des Bereitstellens und ferner nach Durchlaufen des Herstellungsverfahrens 100 bei den Schritt 160, 170, wobei deutlich die verringerte Dicke des Sockelbereichs 24-3 des Deckelsubstrats 20' dargestellt wird.

Das Vorsehen dieser Ausdünnungsbereiche 20-3 in dem Deckelsubstrat ist auf die nachfolgend dargestellten unterschiedlichen Prozessabläufe des Herstellungsverfahrens 100 gleichermaßen anwendbar, wobei die Ausdünnungsbereiche 20-3 des Abdeckungssubstrats 20 dort vorgesehen werden, um eine gezielte, dünne Ausgestaltung des resultierenden Deckelelements 24 in den gewünschten Seitenwandbereichen und die daraus resultierenden (verbesserten) optischen Eigenschaften zu erhalten.

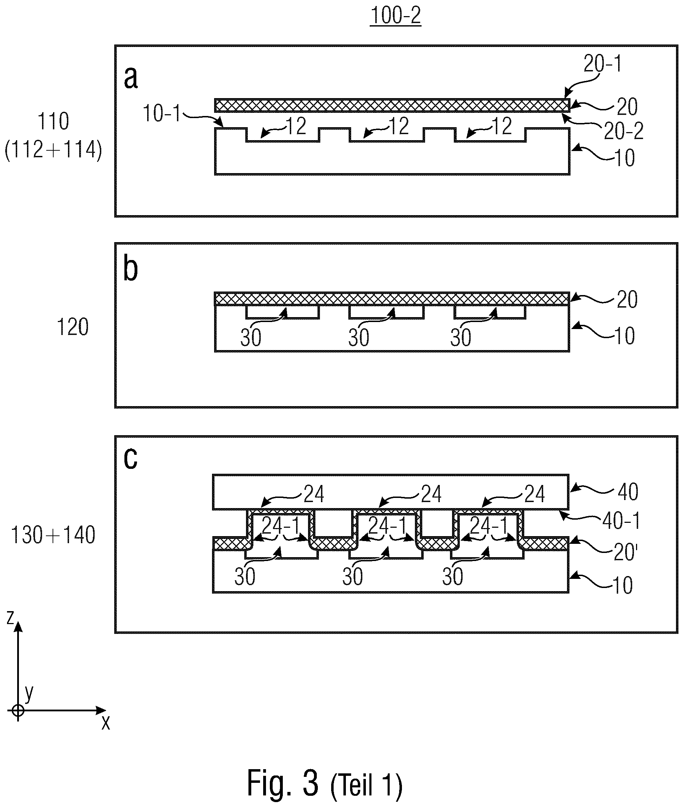

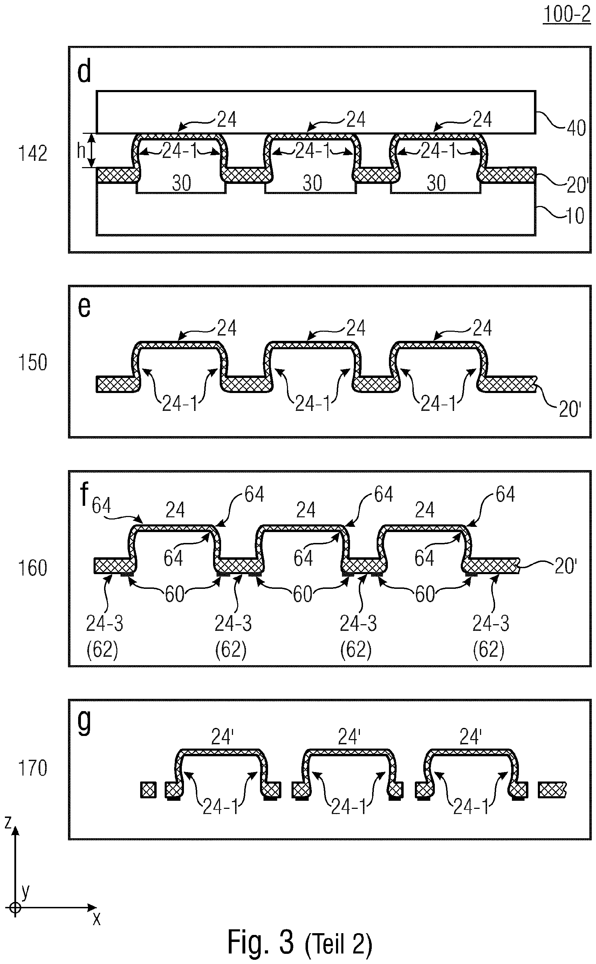

Fig. 3 zeigt nun ein weiteres beispielhaftes prinzipielles Ablaufdiagramm 100-2 des erfindungsgemäßen Herstellungsverfahrens 100 gemäß einem weiteren Ausführungsbeispiel. Im Folgenden werden im wesentlichen Unterschiede bzw. unterschiedliche Verfahrensschritte des Ablaufdiagramms 100-2 von Fig. 3 gegenüber dem Ablaufdiagramm 100-1 von Fig. 2 dargestellt. Daher kann die obige Beschreibung der Fig. 1 und 2 entsprechend auf die nachfolgende Beschreibung des Ausführungsbeispiels von Fig. 3 angewendet werden, wobei in der nachfolgenden Beschreibung vor allem die Unterschiede, wie z.B. unterschiedliche (= alternative und/oder zusätzliche) Prozessschritte und/oder Elemente, zu dem Prozessablauf 100-1 von Fig. 2 und die daraus resultierenden technischen Effekte beschrieben werden.

Fig. 3 zeigt nun ein beispielhaftes Ablaufdiagramm 100-2 des erfindungsgemäßen Herstellungsverfahrens 100 zur Herstellung eines Deckelsubstrats, das beispielsweise zum Häusen eines oder einer Mehrzahl von optischen bzw. optoelektronischen Bauelementen eingesetzt werden kann. Die Fensterelemente können damit beispielsweise als aufgestellte konvexe (nach außen gewölbte) Seitenfenster gebildet werden.

Bei Schritt 110 werden zunächst das Formsubstrat 10, z. B. ein Halbleiter- oder Silizium-Wafer, mit dem strukturierten Oberflächenbereich 10-1 bereitgestellt, d.h. das Formsubstrat 10 ist mit zumindest einer Vertiefung bzw. Ausnehmung 12 versehen. Ferner wird das Abdeckungssubstrat 20, z. B. ein Glaswafer, bereitgestellt.

Bei einem Schritt 112 wird das Abdeckungssubstrat 20 auf dem strukturierten Oberflächenbereich 10-1 des Formsubstrats 10 ausgerichtet angeordnet. So kann beispielsweise der zweite Hauptoberflächenbereich 20-2 des Abdeckungssubstrats 20, der an dem Formsubstrat 10, d.h. an den erhöhten Bereichen des strukturierten Oberflächenbereichs 10-1 des Formsubstrats 10 anliegt, eben bzw. plan sein und somit ohne Ausnehmungen oder Vertiefungen ausgebildet sein.

Bei einem Schritt 114 wird dann das Abdeckungssubstrat 20 mit dem Formsubstrat 10 verbunden bzw. gefügt, z. B. mittels anodischen Bondens hermetisch verbunden, um zumindest eine abgeschlossene Kavität 30 zwischen dem Abdeckungssubstrat 20 und dem Formsubstrat 10 zu bilden. Dabei bildet die in dem Formsubstrat 10 angeordnete Vertiefung 12 bzw. bilden die in dem Formsubstrat 10 angeordneten Vertiefungen 12 dann jeweils die zumindest eine abgeschlossene Kavität 30 zwischen dem Abdeckungssubstrat 20 und dem Formsubstrat 10.

Gemäß einem Ausführungsbeispiel des Ablaufdiagramms 100-2 des Verfahrens 100 wird das (hermetische) Verbinden 114 des Abdeckungssubstrats 20 mit dem Formsubstrat 10 in einer Atmosphäre mit einem definierten atmosphärischen Umgebungsdruck durchgeführt, um einen definierten atmosphärischen Druck in den abgeschlossenen Kavitäten 30 einzuschließen.

In der Vorbereitung des eigentlichen Herstellungsprozesses wird also das Formsubstrat 10, z.B. ein Silizium-Formsubstrat, mit einseitigen Kavitäten und Kanalstrukturen 12 (= Ausnehmungen oder Vertiefungen) versehen. Der Glaswafer 20 wird zu dem Formsubstrat 10 ausgerichtet und in einer definierten Atmosphäre beispielsweise anodisch gebondet, um einen (definierten) Gasdruck in den Kavitäten und Kanalstrukturen 30 einzuschließen.

Bei Schritt 120 werden also das Formsubstrat 10 und das Abdeckungssubstrat 20, die miteinander verbunden sind, bereitgestellt, wobei der Oberflächenbereich 10-1 des Formsubstrats 10 strukturiert (mit Vertiefungen oder Kanalstrukturen 12 ausgebildet) ist, um die zumindest eine abgeschlossene Kavität 30 zwischen dem Abdeckungssubstrat 20 und dem Formsubstrat 10 zu bilden. Bei Schritt 120 wird also beispielweise ein anodisch gebondetes Glas-Silizium- Deckelsubstrat 10, 20 erhalten bzw. bereitgestellt.

Bei einem (nachfolgenden) Schritt 130 wird nun das Abdeckungssubstrat 20 und das Formsubstrat 10 getempert, d.h. einer Temperaturbehandlung unterzogen bzw. erhitzt (erwärmt), um die Viskosität des Glasmaterials des Abdeckungssubstrats 20 zu verringern. Ferner wird bei einem Schritt 140 ein Überdruck in der (zumindest einen) abgeschlossenen Kavität bzw. den abgeschlossenen Kavitäten 30 gegenüber der umgebenden Atmosphäre bereitgestellt, um basierend auf der verringerten Viskosität des Glasmaterials des Abdeckungssubstrats 20 und dem Überdruck in der abgeschlossenen Kavität 30 gegenüber der umgebenden Atmosphäre ein definiertes Auswölben, z. B. Ausblasen oder Verformen, des Glasmaterials des Abdeckungssubstrats 20 ausgehend von der abgeschlossenen Kavität 30 bis zu einer von dem Abdeckungssubstrat 20 beabstandeten Anschlagfläche 40-1 eines Anschlagelements 40 zu bewirken. Das definierte Auswölben des Glasmaterials des Abdeckungssubstrats 20 aufgrund des Überdrucks in der abgeschlossenen Kavität 30 und der verringerten Viskosität des Glasmaterials kann auch als Ausblasen oder Verformen des Glasmaterials bezeichnet werden. Durch das definierte Auswölben des Glasmaterials des Abdeckungssubstrats 20 wird somit ein geformtes Abdeckungssubstrat 20' mit (zumindest) einem Deckelelement 24 (= Auswölbung oder Verformung) erhalten. Als Deckelelement 24 wird somit die erhaltene Auswölbung oder Verformung des geformten Abdeckungssubstrats (= Deckelsubstrat) 20' bezeichnet. Gemäß einem Ausführungsbeispiel kann der Schritt 130 des Temperns in einem Temperaturbereich über 650°C, z.B. zwischen 650°C und 955°C oder zwischen 650°C und 750°C durchgeführt werden.

Ferner wird durch das definierte Auswölben des Abdeckungssubstrats 20 das Ausbilden der Seitenfenster 24-1 an dem Deckelelement 24 bewirkt bzw. diese geformt. Der Seitenbereich des Deckelelements 24 wird auch als (optisch passives) Fensterelement oder optisch passives Glasfenster 24-1 bezeichnet.

Gemäß einem Ausführungsbeispiel des Ablaufdiagramms 100-2 des Verfahrens 100 wird der Schritt des Temperns 130 und des Bereitstellens 140 eines Überdrucks als ein Glasfließprozess in einem Unterdruckofen 50 durchgeführt, um in der abgeschlossenen Kavität 30 einen definierten atmosphärischen Überdruck gegenüber der umgebenden Atmosphäre zu erhalten

Gemäß einem Ausführungsbeispiel des Ablaufdiagramms 100-2 des Verfahrens 100 wird das Abdeckungssubstrat 20 bei dem Schritt des Temperns 130 und des Bereitstellens 140 eines Überdrucks im Bereich der abgeschlossenen Kavität 30 bis zu einer Höhe h, die durch den vertikalen Abstand der Anschlagfläche 40-1 des Anschlags 40 zu dem ersten Hauptoberflächenbereich 20-1 des Abdeckungssubstrats 20 vorgegeben ist, ausgewölbt bzw. ausgeblasen.

Gemäß einem Ausführungsbeispiel des Ablaufdiagramms 100-2 des Verfahrens 100 ist der der Kavität 30 oder den Kavitätsbereichen 30 gegenüberliegende Bereich der Anschlagfläche 40-1 des Anschlagelements 40 eben und parallel zu dem Hauptoberflächenbereich 20-1 des Abdeckungssubstrats 20 (= parallel zur Referenzebene) ausgebildet, um bei dem Schritt des Temperns 130 und des Bereitstellens 140 eines Überdrucks einen ebenen Deckenbereich 24-2 des Deckelelements 24 zu bilden.

Gemäß einem Ausführungsbeispiel des Ablaufdiagramms 100-2 des Verfahrens 100 kann bei einem Schritt 142 des (definierten) Abkühlens des geformten Abdeckungssubstrats 20' in einem Temperaturbereich über 650°C, z.B. zwischen 650°C und 955°C oder zwischen 650°C und 750°C, ein atmosphärischer Überdruck in den abgeschlossenen Kavitäten 30 gegenüber der umgebenden Atmosphäre bewirkt werden, um eine konvexe Wölbung der Seitenwandbereiche (Seitenfenster) 24-1 des Deckelelements 24 des geformten Abdeckungssubstrats 20' nach außen zu erzeugen. Gemäß einem Ausführungsbeispiel des Verfahrens kann der Schritt des Temperns 130 und des Bereitstellens 140 eines Überdrucks in einem Unterdruckofen 50 durchgeführt, wobei der atmosphärische Überdruck in den abgeschlossenen Kavitäten 30 gegenüber der umgebenden Atmosphäre durch einen verringerten atmosphärischen Druck in dem Unterdruckofen 50 erhalten wird.

Bei einem nachfolgenden Schritt 150 wird nun das Anschlagelement 40 und das Formsubstrat 10 von dem geformten Abdeckungssubstrat 20' entfernt, wobei nun das geformte Abdeckungssubstrat 20' das Deckelsubstrat 20' mit dem zumindest einen Deckelelement 24 bildet. Das Deckelsubstrat 20' kann z.B. zum Häusen eines oder einer Mehrzahl von optischen oder optoelektronischen Bauelementen eingesetzt werden.

Gemäß einem Ausführungsbeispiel kann das Ablaufdiagramm 100-2 des Verfahrens 100 ferner den Schritt 142 des Abkühlens des Anschlagelements 40, des Formsubstrats 10 und des geformten Abdeckungssubstrats 20' aufweisen, wobei dann bei dem Schritt 150 anschließend das Formsubstrat 10 mittels eines Ätzvorgangs, z.B. eines Silizium- oder Halbleiter-Ätzvorgangs des Silizium- oder Halbleiter-Material des Formsubstrats, entfernt wird.

Bei einem (optionalen) nachfolgenden Schritt 160 kann der Prozessablauf 100-2 des Verfahrens 100 ferner ein Aufbringen bzw. Abscheiden einer Metallisierung 60 als eine (zusammenhängende) Rahmenstruktur bzw. als ein Versiegelungsrahmen auf Verbindungsbereichen 62 an dem zweiten Hauptoberflächenbereich 20-2 an nicht-ausgewölbten Bereichen (Sockelbereichen) 24-3 der Deckelelemente 24 des geformten Abdeckungssubstrats (des Deckelsubstrats) 20' aufweisen.

Gemäß einem Ausführungsbeispiel kann bei Schritt 160 ferner eine Antireflexions-Beschichtung 64 auf einen innenseitigen und/oder außenseitigen Bereich, z.B. innenseitig und/oder außenseitig auf den Deckenbereich 24-2 und/oder Seitenwandbereich 24-1, des Deckelelements 24 des geformten Abdeckungssubstrats 20' aufgebracht oder abgeschieden werden.

Bei einem (optionalen) nachfolgenden Schritt 170 kann der Prozessablauf 100-2 des Verfahrens 100 ferner ein Vereinzeln des geformten Abdeckungssubstrats 20' aufweisen, um vereinzelte Deckelelemente 24` zu erhalten. Das Vereinzeln 170 des Glas-Deckelsubstrats 20' kann beispielsweise durch Sägen oder Lasertrennung erfolgen. Mit den vereinzelten Kappen 24' können optische Aufbauten auf Einzelsubstratebene oder auf Waferebene durch Einzelverkappung hermetisch versiegelt werden, wie dies nachfolgend noch erläutert wird.

Im Folgenden werden nun nochmals einige Verfahrensschritte des Prozessablaufs 100-2 des Verfahrens 100 von Fig. 3 nochmals zusammengefasst dargestellt.

Fig. 3 zeigt also ein Flussdiagramm 100-2, das anhand der Schritte 110 bis 170 einen ersten Prozessablauf 100-2 zur Herstellung eines Deckelsubstrats 20' veranschaulicht. Das aus dem Herstellungsverfahren 100-2 resultierende Deckelsubstrat 20' weist nach dem Prozessablauf beispielsweise (zumindest) ein optisch passives Seitenfenster 24-1 auf, das integraler Bestandteil des Deckelelements 24 (Kappe) ist und eine laterale Strahlauskopplung und/oder Strahleinkopplung erlaubt.

Der Prozessablauf 100-2 von Fig. 3 umfasst also als einen Schritt 110 das Bereitstellen des Formsubstrats mit einem strukturierten (mit Vertiefungen versehenen) Oberflächenbereich, wobei das Formsubstrat ein Halbleitermaterial, wie z. B. Silizium, aufweist, oder aus dem Halbleitermaterial, z. B. Silizium, besteht. Es folgt darauf das Anordnen des unstrukturierten Abdeckungssubstrats auf dem strukturierten Oberflächenbereich des Formsubstrats. Das Abdeckungssubstrat weist ein Glasmaterial auf oder besteht aus einem Glasmaterial. Bei dem Anordnen des Abdeckungssubstrats an dem Formsubstrat wird die strukturierte Oberfläche des Formsubstrats mit einer Oberfläche des Abdeckungssubstrats mindestens teilweise überdeckend angeordnet und bei dem Verbinden des Abdeckungssubstrats mit dem Formsubstrat z.B. anodisch gebondet oder hermetisch gefügt. Dabei wird die strukturierte Oberfläche des Formsubstrats mit der Oberfläche des Abdeckungssubstrats z. B. gasdicht mit einer definierten eingeschlossenen Innenatmosphäre in den Vertiefungen (Kavitäten) verbunden.

Darauf folgt beispielsweise das Tempern 130 der verbundenen Substrate 10, 20 in einem Unterdruckofen derart, dass ein Ausblasen des Glasmaterials des Abdeckungssubstrats im Bereich der Vertiefungen durch den eingeschlossenen Druck in Relation zum Ofendruck bewirkt wird.

Bei dem Glasfließvorgang erfolgt ein Stopp der Fließfront an der Anschlagfläche 40-1 des Anschlagelements 40 in einstellbarem Abstand h im Unterdruckofen, wobei das Anschlagelement 40 mit der Anschlagfläche 40-1 z.B. einen Siliziumwafer aufweist oder aus einem Siliziumwafer besteht.

Bei dem Glasfließvorgang 130, 140 erfolgt eine Abkühlung der verbundenen Substrate unter reproduzierbarer Temperatur- und Druckrampe, um die konvexe Fensterausformung zu erzeugen. Schließlich erfolgt eine Entnahme des Deckelsubstrats 20' mit dem Formsubstrat und z.B. dem Anschlagelement 40 aus dem Ofen 50.

Dann erfolgt ein Entfernen 150 des Anschlagelements 40 und des Formsubstrates 10, um das aus dem Abdeckungssubstrat 20 durch den Ausblasprozess gewonnene strukturierte Deckelsubstrat 20' zu erhalten.

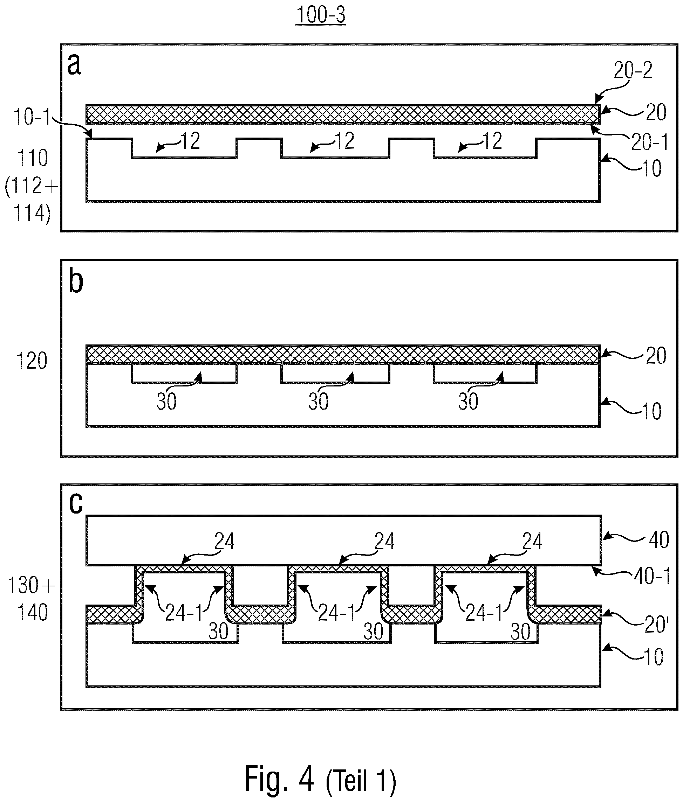

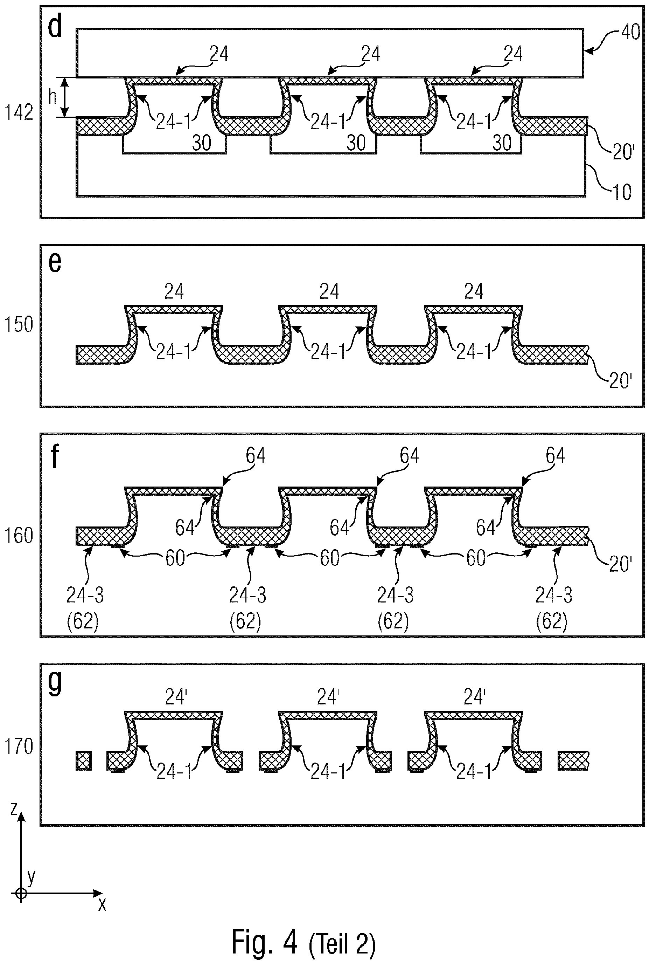

Fig. 4 zeigt nun ein beispielhaftes Ablaufdiagramm 100-3 des erfindungsgemäßen Herstellungsverfahrens 100 zur Herstellung eines Deckelsubstrats, das beispielsweise zum Häusen eines oder einer Mehrzahl von optischen bzw. optoelektronischen Bauelementen eingesetzt werden kann. Die Fensterelemente können damit beispielsweise als aufgestellte konkave (nach innen gewölbte) Seitenfenster gebildet werden.

Bei Schritt 110 werden zunächst das Formsubstrat 10, z. B. ein Halbleiter- oder Silizium-Wafer, mit dem strukturierten Oberflächenbereich 10-1 bereitgestellt, d.h. das Formsubstrat 10 ist mit zumindest einer Vertiefung bzw. Ausnehmung 12 versehen. Ferner wird das Abdeckungssubstrat 20, z. B. ein Glaswafer, bereitgestellt.

Bei einem Schritt 112 wird das Abdeckungssubstrat 20 auf dem strukturierten Oberflächenbereich 10-1 des Formsubstrats 10 ausgerichtet angeordnet. So kann beispielsweise der zweite Hauptoberflächenbereich 20-2 des Abdeckungssubstrats 20, der an dem Formsubstrat 10, d.h. an den erhöhten Bereichen des strukturierten Oberflächenbereichs 10-1 des Formsubstrats 10 anliegt, eben bzw. plan sein und somit ohne Ausnehmungen oder Vertiefungen ausgebildet sein.

Bei einem Schritt 114 wird dann das Abdeckungssubstrat 20 mit dem Formsubstrat 10 verbunden bzw. gefügt, z. B. mittels anodischen Bondens hermetisch verbunden, um zumindest eine abgeschlossene Kavität 30 zwischen dem Abdeckungssubstrat 20 und dem Formsubstrat 10 zu bilden. Dabei bildet die in dem Formsubstrat 10 angeordnete Vertiefung 12 bzw. bilden die in dem Formsubstrat 10 angeordneten Vertiefungen 12 dann jeweils die zumindest eine abgeschlossene Kavität 30 zwischen dem Abdeckungssubstrat 20 und dem Formsubstrat 10.

Gemäß einem Ausführungsbeispiel des Ablaufdiagramms 100-3 des Verfahrens 100 wird das (hermetische) Verbinden 114 des Abdeckungssubstrats 20 mit dem Formsubstrat 10 in einer Atmosphäre mit einem definierten atmosphärischen Umgebungsdruck durchgeführt, um einen definierten atmosphärischen Druck in den abgeschlossenen Kavitäten 30 einzuschließen.

In der Vorbereitung des eigentlichen Herstellungsprozesses wird also das Formsubstrat 10, z.B. ein Silizium-Formsubstrat, mit einseitigen Kavitäten und Kanalstrukturen 12 (= Ausnehmungen oder Vertiefungen) versehen. Der Glaswafer 20 wird zu dem Formsubstrat 10 ausgerichtet und in einer definierten Atmosphäre beispielsweise anodisch gebondet, um einen (definierten) Gasdruck in den Kavitäten und Kanalstrukturen 30 einzuschließen.

Bei Schritt 120 werden also das Formsubstrat 10 und das Abdeckungssubstrat 20, die miteinander verbunden sind, bereitgestellt, wobei der Oberflächenbereich 10-1 des Formsubstrats 10 strukturiert (mit Vertiefungen oder Kanalstrukturen 12 ausgebildet) ist, um die zumindest eine abgeschlossene Kavität 30 zwischen dem Abdeckungssubstrat 20 und dem Formsubstrat 10 zu bilden. Bei Schritt 120 wird also beispielweise ein anodisch gebondetes Glas-Silizium- Deckelsubstrat 10, 20 erhalten bzw. bereitgestellt.

Bei einem (nachfolgenden) Schritt 130 wird nun das Abdeckungssubstrat 20 und das Formsubstrat 10 getempert, d.h. einer Temperaturbehandlung unterzogen bzw. erhitzt (erwärmt), um die Viskosität des Glasmaterials des Abdeckungssubstrats 20 zu verringern. Ferner wird bei einem Schritt 140 ein Überdruck in der (zumindest einen) abgeschlossenen Kavität bzw. den abgeschlossenen Kavitäten 30 gegenüber der umgebenden Atmosphäre bereitgestellt, um basierend auf der verringerten Viskosität des Glasmaterials des Abdeckungssubstrats 20 und dem Überdruck in der abgeschlossenen Kavität 30 gegenüber der umgebenden Atmosphäre ein definiertes Auswölben, z. B. Ausblasen oder Verformen, des Glasmaterials des Abdeckungssubstrats 20 ausgehend von der abgeschlossenen Kavität 30 bis zu einer von dem Abdeckungssubstrat 20 beabstandeten Anschlagfläche 40-1 eines Anschlagelements 40 zu bewirken. Das definierte Auswölben des Glasmaterials des Abdeckungssubstrats 20 aufgrund des Überdrucks in der abgeschlossenen Kavität 30 und der verringerten Viskosität des Glasmaterials kann auch als Ausblasen oder Verformen des Glasmaterials bezeichnet werden. Durch das definierte Auswölben des Glasmaterials des Abdeckungssubstrats 20 wird somit ein geformtes Abdeckungssubstrat 20' mit (zumindest) einem Deckelelement 24 (= Auswölbung oder Verformung) erhalten. Als Deckelelement 24 wird somit die erhaltene Auswölbung oder Verformung des geformten Abdeckungssubstrats (= Deckelsubstrat) 20' bezeichnet. Gemäß einem Ausführungsbeispiel kann der Schritt 130 des Temperns in einem Temperaturbereich über 650°C, z.B. zwischen 650°C und 955°C oder zwischen 650°C und 750°C durchgeführt werden.

Ferner wird durch das definierte Auswölben des Abdeckungssubstrats 20 das Ausbilden der Seitenfenster 24-1 an dem Deckelelement 24 bewirkt bzw. diese geformt. Der Seitenbereich des Deckelelements 24 wird auch als (optisch passives) Fensterelement oder optisch passives Glasfenster 24-1 bezeichnet.

Gemäß einem Ausführungsbeispiel des Ablaufdiagramms 100-3 des Verfahrens 100 wird der Schritt des Temperns 130 und des Bereitstellens 140 eines Überdrucks als ein Glasfließprozess in einem Unterdruckofen 50 durchgeführt, um in der abgeschlossenen Kavität 30 einen definierten atmosphärischen Überdruck gegenüber der umgebenden Atmosphäre zu erhalten

Gemäß einem Ausführungsbeispiel des Ablaufdiagramms 100-3 des Verfahrens 100 wird das Abdeckungssubstrat 20 bei dem Schritt des Temperns 130 und des Bereitstellens 140 eines Überdrucks im Bereich der abgeschlossenen Kavität 30 bis zu einer Höhe h, die durch den vertikalen Abstand der Anschlagfläche 40-1 des Anschlags 40 zu dem ersten Hauptoberflächenbereich 20-1 des Abdeckungssubstrats 20 vorgegeben ist, ausgewölbt bzw. ausgeblasen.

Gemäß einem Ausführungsbeispiel des Ablaufdiagramms 1003 des Verfahrens 100 ist der der Kavität 30 oder den Kavitätsbereichen 30 gegenüberliegende Bereich der Anschlagfläche 40-1 des Anschlagelements 40 eben und parallel zu dem Hauptoberflächenbereich 20-1 des Abdeckungssubstrats 20 (= parallel zur Referenzebene) ausgebildet, um bei dem Schritt des Temperns 130 und des Bereitstellens 140 eines Überdrucks einen ebenen Deckenbereich 24-2 des Deckelelements 24 zu bilden.

Gemäß einem weiteren Ausführungsbeispiel des Ablaufdiagramms 100-3 des Verfahrens 100 kann bei dem Schritt 142 des (definierten) Abkühlens des geformten Abdeckungssubstrats 20' in einem Temperaturbereich über 650°C, z.B. zwischen 650°C und 955°C oder zwischen 650°C und 750°C, ein atmosphärischer Unterdruck in den abgeschlossenen Kavitäten 30 gegenüber der umgebenden Atmosphäre bewirkt, um eine konkave Wölbung der Seitenwandbereiche (Seitenfenster) 24-1 des Deckelelements 24 des geformten Abdeckungssubstrats 20' nach innen zu erzeugen. Gemäß einem Ausführungsbeispiel des Verfahrens 100-3 wird der Schritt des Temperns 130 und des Bereitstellens 140 des Überdrucks in dem Unterdruckofen 50 durchgeführt, wobei ferner der atmosphärische Unterdruck P in den abgeschlossenen Kavitäten 30 gegenüber der umgebenden Atmosphäre durch einen erhöhten atmosphärischen Druck in dem Unterdruckofen 50 erhalten wird.

Bei einem nachfolgenden Schritt 150 wird nun das Anschlagelement 40 und das Formsubstrat 10 von dem geformten Abdeckungssubstrat 20' entfernt, wobei nun das geformte Abdeckungssubstrat 20' das Deckelsubstrat 20' mit dem zumindest einen Deckelelement 24 bildet. Das Deckelsubstrat 20' kann z.B. zum Häusen eines oder einer Mehrzahl von optischen oder optoelektronischen Bauelementen eingesetzt werden.

Gemäß einem Ausführungsbeispiel kann das Ablaufdiagramm 100-3 des Verfahrens 100 ferner den Schritt 142 des Abkühlens des Anschlagelements 40, des Formsubstrats 10 und des geformten Abdeckungssubstrats 20' aufweisen, wobei dann bei dem Schritt 150 anschließend das Formsubstrat 10 mittels eines Ätzvorgangs, z.B. eines Silizium- oder Halbleiter-Ätzvorgangs des Silizium- oder Halbleiter-Material des Formsubstrats, entfernt wird.

Bei einem (optionalen) nachfolgenden Schritt 160 kann der Prozessablauf 100-3 des Verfahrens 100 ferner ein Aufbringen bzw. Abscheiden einer Metallisierung 60 als eine (zusammenhängende) Rahmenstruktur bzw. als ein Versiegelungsrahmen auf Verbindungsbereichen 62 an dem zweiten Hauptoberflächenbereich 20-2 an nicht-ausgewölbten Bereichen (Sockelbereichen) 24-3 der Deckelelemente 24 des geformten Abdeckungssubstrats (des Deckelsubstrats) 20' aufweisen.

Gemäß einem Ausführungsbeispiel kann bei Schritt 160 ferner eine Antireflexions-Beschichtung 64 auf einen innenseitigen und/oder außenseitigen Bereich, z.B. innenseitig und/oder außenseitig auf den Deckenbereich 24-2 und/oder Seitenwandbereich 24-1, des Deckelelements 24 des geformten Abdeckungssubstrats 20' aufgebracht oder abgeschieden werden.

Bei einem (optionalen) nachfolgenden Schritt 170 kann der Prozessablauf 100-3 des Verfahrens 100 ferner ein Vereinzeln des geformten Abdeckungssubstrats 20' aufweisen, um vereinzelte Deckelelemente 24` zu erhalten. Das Vereinzeln 170 des Glas-Deckelsubstrats 20' kann beispielsweise durch Sägen oder Lasertrennung erfolgen. Mit den vereinzelten Kappen 24` können optische Aufbauten auf Einzelsubstratebene oder auf Waferebene durch Einzelverkappung hermetisch versiegelt werden, wie dies nachfolgend noch erläutert wird.

Im Folgenden werden nun nochmals einige Verfahrensschritte des Prozessablaufs 100-3 des Verfahrens 100 von Fig. 4 nochmals zusammengefasst dargestellt.

Fig. 4 zeigt also ein Flussdiagramm 100-3, das anhand der Schritte 110 bis 170 einen ersten Prozessablauf 100-3 zur Herstellung eines Deckelsubstrats 20' veranschaulicht. Das aus dem Herstellungsverfahren 100-3 resultierende Deckelsubstrat 20' weist nach dem Prozessablauf beispielsweise (zumindest) ein optisch passives Seitenfenster 24-1 auf, das integraler Bestandteil des Deckelelements 24 (Kappe) ist und eine laterale Strahlauskopplung und/oder Strahleinkopplung erlaubt.

Der Prozessablauf 100-3 von Fig. 4 umfasst also als einen Schritt 110 das Bereitstellen des Formsubstrats mit einem strukturierten (mit Vertiefungen versehenen) Oberflächenbereich, wobei das Formsubstrat ein Halbleitermaterial, wie z. B. Silizium, aufweist, oder aus dem Halbleitermaterial, z. B. Silizium, besteht. Es folgt darauf das Anordnen des unstrukturierten Abdeckungssubstrats auf dem strukturierten Oberflächenbereich des Formsubstrats. Das Abdeckungssubstrat weist ein Glasmaterial auf oder besteht aus einem Glasmaterial. Bei dem Anordnen des Abdeckungssubstrats an dem Formsubstrat wird die strukturierte Oberfläche des Formsubstrats mit einer Oberfläche des Abdeckungssubstrats mindestens teilweise überdeckend angeordnet und bei dem Verbinden des Abdeckungssubstrats mit dem Formsubstrat z.B. anodisch gebondet oder hermetisch gefügt. Dabei wird die strukturierte Oberfläche des Formsubstrats mit der Oberfläche des Abdeckungssubstrats z. B. gasdicht mit einer definierten eingeschlossenen Innenatmosphäre in den Vertiefungen (Kavitäten) verbunden.

Darauf folgt beispielsweise das Tempern 130 der verbundenen Substrate 10, 20 in einem Unterdruckofen derart, dass ein Ausblasen des Glasmaterials des Abdeckungssubstrats im Bereich der Vertiefungen durch den eingeschlossenen Druck in Relation zum Ofendruck bewirkt wird.

Bei dem Glasfließvorgang erfolgt ein Stopp der Fließfront an der Anschlagfläche 40-1 des Anschlagelements 40 in einstellbarem Abstand h im Unterdruckofen, wobei das Anschlagelement 40 mit der Anschlagfläche 40-1 z.B. einen Siliziumwafer aufweist oder aus einem Siliziumwafer besteht.

Bei dem Glasfließvorgang 130, 140 erfolgt eine Abkühlung der verbundenen Substrate unter reproduzierbarer Temperatur- und Druckrampe, um die konkave Fensterausformung zu erzeugen. Schließlich erfolgt eine Entnahme des Deckelsubstrats 20' mit dem Formsubstrat und z.B. dem Anschlagelement 40 aus dem Ofen 50.

Dann erfolgt ein Entfernen 150 des Anschlagelements 40 und des Formsubstrates 10, um das aus dem Abdeckungssubstrat 20 durch den Ausblasprozess gewonnene strukturierte Deckelsubstrat 20' zu erhalten.

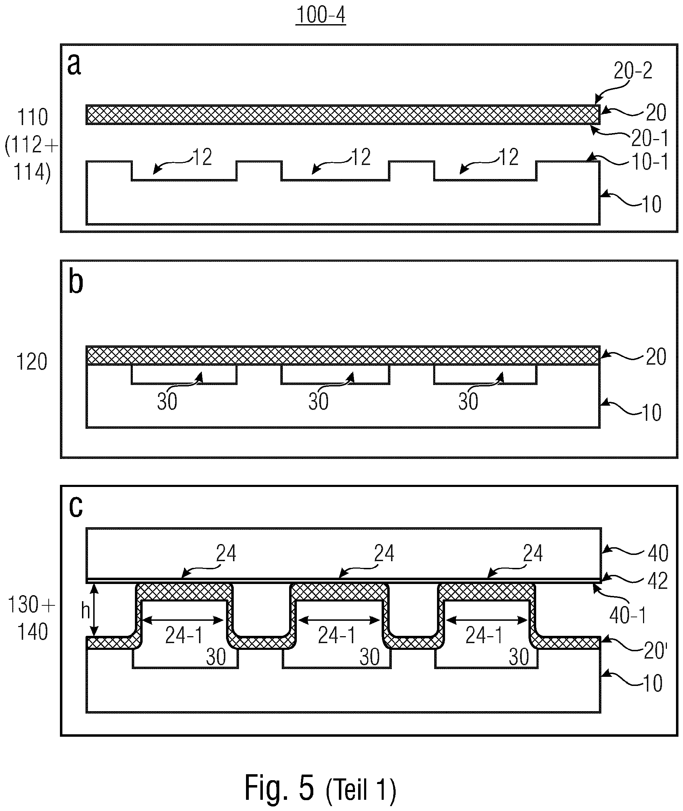

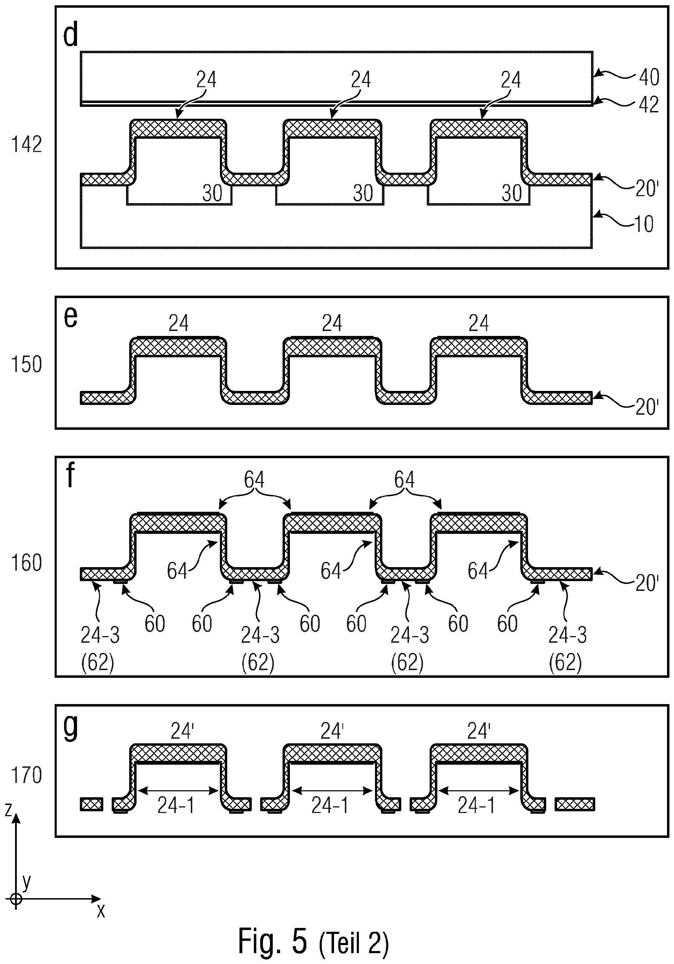

Fig. 5 zeigt nun ein beispielhaftes Ablaufdiagramm 100-4 des erfindungsgemäßen Herstellungsverfahrens 100 zur Herstellung eines Deckelsubstrats 20` einem wiederverwendbaren Anschlagelement 40 bzw. mit einer wiederverwendbaren Anschlagfläche 40.

Bei Schritt 110 werden zunächst das Formsubstrat 10, z. B. ein Halbleiter- oder Silizium-Wafer, mit dem strukturierten Oberflächenbereich 10-1 bereitgestellt, d.h. das Formsubstrat 10 ist mit zumindest einer Vertiefung bzw. Ausnehmung 12 versehen. Ferner wird das Abdeckungssubstrat 20, z. B. ein Glaswafer, bereitgestellt.

Bei einem Schritt 112 wird das Abdeckungssubstrat 20 auf dem strukturierten Oberflächenbereich 10-1 des Formsubstrats 10 ausgerichtet angeordnet. So kann beispielsweise der zweite Hauptoberflächenbereich 20-2 des Abdeckungssubstrats 20, der an dem Formsubstrat 10, d.h. an den erhöhten Bereichen des strukturierten Oberflächenbereichs 10-1 des Formsubstrats 10 anliegt, eben bzw. plan sein und somit ohne Ausnehmungen oder Vertiefungen ausgebildet sein.

Bei einem Schritt 114 wird dann das Abdeckungssubstrat 20 mit dem Formsubstrat 10 verbunden bzw. gefügt, z. B. mittels anodischen Bondens hermetisch verbunden, um zumindest eine abgeschlossene Kavität 30 zwischen dem Abdeckungssubstrat 20 und dem Formsubstrat 10 zu bilden. Dabei bildet die in dem Formsubstrat 10 angeordnete Vertiefung 12 bzw. bilden die in dem Formsubstrat 10 angeordneten Vertiefungen 12 dann jeweils die zumindest eine abgeschlossene Kavität 30 zwischen dem Abdeckungssubstrat 20 und dem Formsubstrat 10.

Bei Schritt 120 werden also das Formsubstrat 10 und das Abdeckungssubstrat 20, die miteinander verbunden sind, bereitgestellt, wobei der Oberflächenbereich 10-1 des Formsubstrats 10 strukturiert (mit Vertiefungen oder Kanalstrukturen 12 ausgebildet) ist, um die zumindest eine abgeschlossene Kavität 30 zwischen dem Abdeckungssubstrat 20 und dem Formsubstrat 10 zu bilden. Bei Schritt 120 wird also beispielweise ein anodisch gebondetes Glas-Silizium- Deckelsubstrat 10, 20 erhalten bzw. bereitgestellt.

Bei einem (nachfolgenden) Schritt 130 wird nun das Abdeckungssubstrat 20 und das Formsubstrat 10 getempert, d.h. einer Temperaturbehandlung unterzogen bzw. erhitzt (erwärmt), um die Viskosität des Glasmaterials des Abdeckungssubstrats 20 zu verringern. Ferner wird bei einem Schritt 140 ein Überdruck in der (zumindest einen) abgeschlossenen Kavität bzw. den abgeschlossenen Kavitäten 30 gegenüber der umgebenden Atmosphäre bereitgestellt, um basierend auf der verringerten Viskosität des Glasmaterials des Abdeckungssubstrats 20 und dem Überdruck in der abgeschlossenen Kavität 30 gegenüber der umgebenden Atmosphäre ein definiertes Auswölben, z. B. Ausblasen oder Verformen, des Glasmaterials des Abdeckungssubstrats 20 ausgehend von der abgeschlossenen Kavität 30 bis zu einer von dem Abdeckungssubstrat 20 beabstandeten Anschlagfläche 40-1 eines Anschlagelements 40 zu bewirken. Gemäß einem Ausführungsbeispiel kann der Schritt 130 des Temperns in einem Temperaturbereich über 650°C, z.B. zwischen 650°C und 955°C oder zwischen 650°C und 750°C durchgeführt werden.

Gemäß einem Ausführungsbeispiel des Ablaufdiagramms 100-4 des Verfahrens 100 wird der Schritt des Temperns 130 und des Bereitstellens 140 eines Überdrucks als ein Glasfließprozess in einem Unterdruckofen 50 durchgeführt, um in der abgeschlossenen Kavität 30 einen definierten atmosphärischen Überdruck gegenüber der umgebenden Atmosphäre zu erhalten

Gemäß einem Ausführungsbeispiel des Ablaufdiagramms 100-4 des Verfahrens 100 wird das Abdeckungssubstrat 20 bei dem Schritt des Temperns 130 und des Bereitstellens 140 eines Überdrucks im Bereich der abgeschlossenen Kavität 30 bis zu einer Höhe h, die durch den vertikalen Abstand der Anschlagfläche 40-1 des Anschlags 40 zu dem ersten Hauptoberflächenbereich 20-1 des Abdeckungssubstrats 20 vorgegeben ist, ausgewölbt bzw. ausgeblasen.

Gemäß einem Ausführungsbeispiel des Ablaufdiagramms 100-4 des Verfahrens 100 ist der der Kavität 30 oder den Kavitätsbereichen 30 gegenüberliegende Bereich der Anschlagfläche 40-1 des Anschlagelements 40 eben und parallel zu dem Hauptoberflächenbereich 20-1 des Abdeckungssubstrats 20 (= parallel zur Referenzebene) ausgebildet, um bei dem Schritt des Temperns 130 und des Bereitstellens 140 eines Überdrucks einen ebenen Deckenbereich 24-2 des Deckelelements 24 zu bilden.

Gemäß einem Ausführungsbeispiel kann das Anschlagelement 40 als ein wiederverwendbares Werkzeug ausgeführt sein und eine Antihaftbeschichtung 42 (als bzw. an der Anschlagfläche 40) für das Glasmaterial des Abdeckungssubstrats 20 zumindest an dem der Kavität 30 gegenüberliegenden Bereich 40-1 der Anschlagfläche 40 oder an der gesamten Anschlagfläche 40 aufweisen.

Bei einem nachfolgenden Schritt 150 wird nun das wiederverwendbare Anschlagelement 40 und das Formsubstrat 10 von dem geformten Abdeckungssubstrat 20' entfernt, wobei nun das geformte Abdeckungssubstrat 20' das Deckelsubstrat 20' mit dem zumindest einen Deckelelement 24 bildet. Das Deckelsubstrat 20' kann z.B. zum Häusen eines oder einer Mehrzahl von optischen oder optoelektronischen Bauelementen eingesetzt werden.

Gemäß einem Ausführungsbeispiel kann das Ablaufdiagramm 100-4 des Verfahrens 100 ferner den Schritt 142 des Abkühlens des Anschlagelements 40, des Formsubstrats 10 und des geformten Abdeckungssubstrats 20' aufweisen, wobei dann bei dem Schritt 150 anschließend (nur) das Formsubstrat 10 mittels eines Ätzvorgangs, z.B. eines Silizium- oder Halbleiter-Ätzvorgangs des Silizium- oder Halbleiter-Material des Formsubstrats, entfernt wird.

Bei einem (optionalen) nachfolgenden Schritt 160 kann der Prozessablauf 100-4 des Verfahrens 100 ferner ein Aufbringen bzw. Abscheiden einer Metallisierung 60 als eine (zusammenhängende) Rahmenstruktur bzw. als ein Versiegelungsrahmen auf Verbindungsbereichen 62 an dem zweiten Hauptoberflächenbereich 20-2 an nicht-ausgewölbten Bereichen (Sockelbereichen) 24-3 der Deckelelemente 24 des geformten Abdeckungssubstrats (des Deckelsubstrats) 20' aufweisen.

Gemäß einem Ausführungsbeispiel kann bei Schritt 160 ferner eine Antireflexions-Beschichtung 64 auf einen innenseitigen und/oder außenseitigen Bereich, z.B. innenseitig und/oder außenseitig auf den Deckenbereich 24-2 und/oder Seitenwandbereich 24-1, des Deckelelements 24 des geformten Abdeckungssubstrats 20' aufgebracht oder abgeschieden werden.

Bei einem (optionalen) nachfolgenden Schritt 170 kann der Prozessablauf 100-4 des Verfahrens 100 ferner ein Vereinzeln des geformten Abdeckungssubstrats 20' aufweisen, um vereinzelte Deckelelemente 24` zu erhalten. Das Vereinzeln 170 des Glas-Deckelsubstrats 20' kann beispielsweise durch Sägen oder Lasertrennung erfolgen. Mit den vereinzelten Kappen 24` können optische Aufbauten auf Einzelsubstratebene oder auf Waferebene durch Einzelverkappung hermetisch versiegelt werden, wie dies nachfolgend noch erläutert wird.

Im Folgenden werden nun nochmals einige Verfahrensschritte des Prozessablaufs 100-4 des Verfahrens 100 von Fig. 5 nochmals zusammengefasst dargestellt.

Fig. 5 zeigt also ein Flussdiagramm 100-4, das anhand der Schritte 110 bis 170 einen Prozessablauf 100-4 zur Herstellung eines Deckelsubstrats 20' veranschaulicht. Das aus dem Herstellungsverfahren 100-4 resultierende Deckelsubstrat 20' weist nach dem Prozessablauf beispielsweise (zumindest) ein optisch passives Seitenfenster 24-1 auf, das integraler Bestandteil des Deckelelements 24 (Kappe) ist und eine laterale Strahlauskopplung und/oder Strahleinkopplung erlaubt.

Der Prozessablauf 100-4 von Fig. 5 umfasst also als einen Schritt 110 das Bereitstellen des Formsubstrats mit einem strukturierten (mit Vertiefungen versehenen) Oberflächenbereich, wobei das Formsubstrat ein Halbleitermaterial, wie z. B. Silizium, aufweist, oder aus dem Halbleitermaterial, z. B. Silizium, besteht. Es folgt darauf das Anordnen des unstrukturierten Abdeckungssubstrats auf dem strukturierten Oberflächenbereich des Formsubstrats. Das Abdeckungssubstrat weist ein Glasmaterial auf oder besteht aus einem Glasmaterial. Bei dem Anordnen des Abdeckungssubstrats an dem Formsubstrat wird die strukturierte Oberfläche des Formsubstrats mit einer Oberfläche des Abdeckungssubstrats mindestens teilweise überdeckend angeordnet und bei dem Verbinden des Abdeckungssubstrats mit dem Formsubstrat z.B. anodisch gebondet oder hermetisch gefügt.

Darauf folgt beispielsweise das Tempern 130 der verbundenen Substrate 10, 20 in einem Unterdruckofen derart, dass ein Ausblasen des Glasmaterials des Abdeckungssubstrats im Bereich der Vertiefungen durch den eingeschlossenen Druck in Relation zum Ofendruck bewirkt wird.

Bei dem Glasfließvorgang erfolgt ein Stopp der Fließfront an der Anschlagfläche 42 (an dem ersten Hauptoberflächenbereich 40-1) des Anschlagelements 40 in einstellbarem Abstand h im Unterdruckofen, wobei das Anschlagelement 40 mit der Anschlagfläche 42 z.B. einen Siliziumwafer aufweist oder aus einem Siliziumwafer besteht. Das Anschlagwerkzeug 40 oder nur die Anschlagfläche 42 des Anschlagwerkzeugs 40 weist ein hochschmelzendes Material, wie z.B. Silizium, Metall, Keramik oder Glaskeramik mit einer glasabweisenden Schutzschicht z.B. auf Basis von Bornitrid, Kohlenstoff etc. auf bzw. besteht daraus, um das Anschlagwerkzeug 40 bzw. die Anschlagfläche 42 wiederverwendbar zu machen.

Gemäß einem Ausführungsbeispiel kann also ein Beschichten eines Siliziumwafers 40 an dem ersten Hauptoberflächenbereich 40-1 mit einer glasabweisenden Schicht 42 erfolgen, um die Anschlagfläche 42 zu erhalten. Somit kann ein Halbleiterwafer 40 mit einer glasabweisenden Passivierungsschicht 42 auf einer Oberfläche 40-1 bereitgestellt werden.

Bei wiederverwendbaren Anschlagelementen bzw. Anschlagflächen kann beispielsweise auch eine (wählbare oder aufwendige) negative Formgebung vorgesehen werden, um beispielsweise diese hochwertigen Formen durch den Glasfließprozess in das obere Fenster des Deckelelements zu übertragen. Damit kann für (zumindest nicht zu feine) Strukturen eine Formübertragung (von der Anschlagfläche in das obere Fenster des Deckelelements) zu 100% möglich sein. So könne z.B. Flachlinsen oder holographische Strukturen von der Anschlagfläche in das obere Fenster 24-2 des Deckelelements 24 übertragen werden.

Bei dem Glasfließvorgang 130, 140 erfolgt eine Abkühlung der verbundenen Substrate unter reproduzierbarer Temperatur- und Druckrampe, um die konkave Fensterausformung zu erzeugen. Schließlich erfolgt eine Entnahme des Deckelsubstrats 20' mit dem Formsubstrat und z.B. dem Anschlagelement 40 aus dem Ofen 50.

Dann erfolgt ein Entfernen 150 des wiederverwendbaren Anschlagelements 40 und des Formsubstrates 10, um das aus dem Abdeckungssubstrat 20 durch den Ausblasprozess gewonnene strukturierte Deckelsubstrat 20' zu erhalten.

Zusammenfassend kann also festgestellt werden, dass die Fig. 2 - 5 mögliche und optionale Teilschritte und Prozessabläufe des Verfahrens 100 zur Herstellung eines Deckelsubstrats 20' veranschaulichen, wie es anhand der Fig. 1 beschrieben wurde. Diese in Fig. 2 - 5 dargestellten Teilschritte und Prozessabläufe sind nur als beispielhaft zu sehen und können in anderen Ausführungen Variationen aufweisen. Es sind mögliche Prozessabfolgen dargestellt, wie die Herstellung des Deckelwafer 20', also der Deckelsubstrate 20`, mit den vertikalen, konvexen oder konkaven, optisch passiven Fensterflächen 24-1, 24-2 ablaufen kann. Das Verfahren 100 basiert wesentlich auf Techniken des so genannten Glasfließens. In einem Vorbereitungsschritt erfolgt ein Beschichten eines Siliziumwafers 40, also einer Anschlagfläche 40, mit einer Glas-abweisenden Schicht 42.

Das spezielle Deckelsubstrat 20' ist z.B. eine Voraussetzung für das Herstellen verbesserter gehäuster strahlungsemittierender Bauelemente 1' mit dem nachfolgend beschriebenen Verfahren 200. Die obigen Teilschritte und Prozessabläufe sind nur als beispielhaft zu sehen und können in anderen Ausführungen Variationen aufweisen. Es ist eine mögliche Prozessabfolge dargestellt, wie die Herstellung dieser Deckelwafer, also der Deckelsubstrate, mit den Fensterflächen 24-1, 24-2 ablaufen kann.

Fig. 6 zeigt nun einen weiteren prinzipiellen Prozessablauf 100-5 des erfindungsgemäßen Herstellungsverfahrens 100 gemäß einem weiteren Ausführungsbeispiel. Im Folgenden werden im Wesentlichen Unterschiede bzw. unterschiedliche Verfahrensschritte des Ablaufdiagramms 100-5 von Fig. 6 gegenüber den Ablaufdiagrammen 100-1, 100-2, 100-3, 100-4 der Fig. 2 bis 5 dargestellt. Daher kann die obige Beschreibung der Fig. 1 bis 5 entsprechend auf die nachfolgende Beschreibung des Ausführungsbeispiels von Fig. 6 angewendet werden, wobei in der nachfolgenden Beschreibung vor allem auf Unterschiede, wie z. B. unterschiedliche (= alternative und/oder zusätzliche) Prozessschritte und/oder Elemente, zu den vorherigen Prozessabläufen und auf die daraus resultierenden technischen Effekte eingegangen werden.

Bei Schritt 110 werden zunächst das Formsubstrat 10, z. B. ein Halbleiter- oder Silizium- Wafer, mit dem strukturierten Oberflächenbereich 10-1 bereitgestellt, d.h. das Formsubstrat 10 ist mit zumindest einer Vertiefung bzw. Ausnehmung 12 versehen. Ferner wird das Abdeckungssubstrat 20, z. B. ein Glaswafer, bereitgestellt. Das Abdeckungssubstrat 20 weist ein Glasmaterial auf.

Bei einem Schritt 112 wird das Abdeckungssubstrat 20 auf dem strukturierten Oberflächenbereich 10-1 des Formsubstrats 10 (ausgerichtet) angeordnet. Bei einem Schritt 114 wird dann das Abdeckungssubstrat 20 mit dem Formsubstrat 10 verbunden, z. B. mittels anodischen Bondens (beispielsweise in einer definierten Atmosphäre) hermetisch verbunden, um zumindest eine abgeschlossene Kavität 30 oder eine Mehrzahl von Teilkavitäten 30 zwischen dem Abdeckungssubstrat 20 und dem Formsubstrat 10 zu bilden. Das (hermetische) Verbinden 114 des Abdeckungssubstrats 20 mit dem Formsubstrat 10 kann in einer Atmosphäre mit einem definierten atmosphärischen Umgebungsdruck durchgeführt werden, um einen definierten atmosphärischen Druck in den abgeschlossenen Kavitäten 30 einzuschließen. Das Abdeckungssubstrat 20 und/oder das Formsubstrat 10 sind ausgebildet, um die abgeschlossene Kavität 30 mit einer oder einer Mehrzahl von abgeschlossenen Kavitätsbereichen 30 zwischen dem Abdeckungssubstrat 20 und dem Formsubstrat 10 zu bilden, wobei die abgeschlossenen Kavitätsbereiche 30 fluidisch getrennt voneinander angeordnet sind, oder wobei ferner Gasaustauschkanäle 30-1 zwischen den von der Umgebungsatmosphäre abgeschlossenen Kavitätsbereichen 30 vorgesehen sein können, um diese fluidisch miteinander zu verbinden, um einen gemeinsamen definierten atmosphärischen Druck in den verbundenen Kavitätsbereichen 30 zu erhalten.

Bei Schritt 120 werden also das Formsubstrat 10 und das Abdeckungssubstrat 20, die (fest) miteinander verbunden sind, bereitgestellt, wobei der Oberflächenbereich 10-1 des Formsubstrats 10 strukturiert (mit Vertiefungen oder Kanalstrukturen 12 ausgebildet) ist.

Bei dem (nachfolgenden) Schritt 130 wird nun das Abdeckungssubstrat 20 und das Formsubstrat 10 getempert, d.h. einer Temperaturbehandlung unterzogen bzw. erhitzt (erwärmt), um die Viskosität des Glasmaterials des Abdeckungssubstrats 20 zu verringern. Ferner wird bei einem Schritt 140 ein Überdruck in der (zumindest einen) abgeschlossenen Kavität bzw. den abgeschlossenen Kavitäten 30 gegenüber der umgebenden Atmosphäre bereitgestellt, ein definiertes Auswölben, z. B. Ausblasen oder Verformen, des Glasmaterials des Abdeckungssubstrats 20 zu bewirken. Durch das definierte Auswölben des Glasmaterials des Abdeckungssubstrats 20 wird somit ein geformtes Abdeckungssubstrat 20' mit (zumindest) einem Deckelelement 24 erhalten, wobei die Auswölbungen oder Verformungen, d.h. die ausgeblasenen Bereiche, dann die Seitenwandbereiche 24-1 und die Sockelbereiche 24-3 der resultierenden Deckelelemente 24 bilden.

Gemäß einem Ausführungsbeispiel des Ablaufdiagramms 100-5 des Verfahrens 100 wird der Schritt des Temperns 130 und des Bereitstellens 140 eines Überdrucks als ein Glasfließprozess in einem Unterdruckofen 50 durchgeführt, um in der abgeschlossenen Kavität 30 einen definierten atmosphärischen Überdruck gegenüber der umgebenden Atmosphäre zu erhalten. Gemäß einem Ausführungsbeispiel des Ablaufdiagramms 100-5 des Verfahrens 100 wird das Abdeckungssubstrat 20 bei dem Schritt des Temperns 130 und des Bereitstellens 140 eines Überdrucks im Bereich der abgeschlossenen Kavität 30 bis zu einer Höhe h, die durch den vertikalen Abstand der Anschlagfläche 40-1 des Anschlags 40 zu dem ersten Hauptoberflächenbereich 20-1 des Abdeckungssubstrats 20 vorgegeben ist, ausgewölbt bzw. ausgeblasen.

Gemäß einem Ausführungsbeispiel des Ablaufdiagramms 100-5 des Verfahrens 100 ist der der Kavität 30 oder der den Kavitätsbereichen 30 gegenüberliegende Bereich der Anschlagfläche 40-1 des Anschlagelements 40 eben und parallel zu dem Hauptoberflächenbereich 20-1 des Abdeckungssubstrats 20 ausgebildet, um bei dem Schritt des Temperns 130 und des Bereitstellens 140 eines Überdrucks einen ebenen Sockelbereich 24-3 des Deckelelements 24 zu bilden. Die Durchführung des Glasfließprozesses 130, 140 kann also in einem druckkontrollierten Ofen (z.B. in einem Unterdruckofen) 50 erfolgen. Der Glaswafer (Abdeckungssubstrat) 20 wird im Bereich der Kavitäten 30 ausgeblasen bis zu der Höhe h, die durch eine Anschlagfläche 40-1 des Anschlagelements 40 bestimmt werden kann.

Bei dem anhand von Fig. 6 dargestellten, weiteren Prozessablauf 100-5 des Herstellungsverfahrens 100 werden also die Rahmen (Seitenwandbereiche 24-1 und Sockelbereiche 24-3) der Deckelelemente 24 auf- bzw. ausgeblasen. Dadurch wird quasi eine Invertierung der Glaskappe (Kavität zeigt nach oben = z-Richtung) erhalten. Bei dieser Vorgehensweise kann erreicht werden, dass die Deckelform nicht durch den Glasfließprozess beeinträchtigt wird. Das Abdeckungssubstrat 20 wird anodisch am Formsubstrat 10 fest gebondet und die umlaufenden Kanalstrukturen bzw. Grabenstrukturen 12 im Formsubstrat 10 werden ausgeblasen und bildet die Kavität(en) 30 mit dem Abstand h.

Fig. 2 - 6 veranschaulichen mögliche und optionale Teilschritte und Prozessabläufe des Verfahrens 100 zur Herstellung eines Deckelsubstrats 20', wie es anhand der Fig. 1 beschrieben wurde. Diese in Fig. 2 - 6 dargestellten Teilschritte und Prozessabläufe sind nur als beispielhaft zu sehen und können in anderen Ausführungen Variationen aufweisen. Es sind mögliche Prozessabfolgen dargestellt, wie die Herstellung des Deckelwafer 20', also der Deckelsubstrate 20', mit den optisch neutralen Fensterflächen 24-1 ablaufen kann. Das Verfahren 100 basiert wesentlich auf Techniken des so genannten Glasfließens. In einem Vorbereitungsschritt erfolgt ein Beschichten eines Siliziumwafers 40, also einer Anschlagfläche 40-1, mit einer Glas-abweisenden Schicht.

Das spezielle Deckelsubstrat 20' ist z.B. eine Voraussetzung für das Herstellen verbesserter gehäuster strahlungsemittierender Bauelemente 1' mit dem nachfolgend beschriebenen Verfahren 200. Die obigen Teilschritte und Prozessabläufe sind nur als beispielhaft zu sehen und können in anderen Ausführungen Variationen aufweisen. Es ist eine mögliche Prozessabfolge dargestellt, wie die Herstellung dieser Deckelwafer, also der Deckelsubstrate, mit den optischen Fensterflächen 24-1 ablaufen kann.

Hinsichtlich der im vorhergehenden anhand der Fig. 2-6 dargestellten Prozessabläufe kann somit zusammengefasst werden, dass bei den Prozessabläufen 100-1, 100-2, 100-3 und 100-4 bei dem Auswölben des Glasmaterials des Abdeckungssubstrats (Schritt 140) die Seitenfenster 24-1 und Deckelbereiche 24-2 ausgewölbt (ausgeblasen bzw. verformt) werden, während bei dem Prozessablauf 100-5 bei dem Auswölben des Glasmaterials des Abdeckungssubstrats 20 die Seitenfenster 24-1 und die Sockelbereiche 24-3 ausgewölbt werden, um das geformte Abdeckungssubstrat 20' mit den Deckelelementen 24` zu erhalten.

Gemäß einem Ausführungsbeispiel des Verfahrens werden also bei dem Schritt des Temperns 130 und des Bereitstellens eines Überdrucks 140 entweder die Seitenfenster 24-1 und der Deckelbereich 24-2 (bei den Prozessen 100-1, 100-2, 100-3, 100-4) oder die Seitenfenster 24-1 und die Sockelbereiche 24-3 (bei dem Prozess 100-5) mit dem Glasmaterial des Abdeckungssubstrats 20 ausgehend von der abgeschlossenen Kavität 30 bis zu der beabstandeten Anschlagsfläche 40-1 des Anschlagselements 40 ausgewölbt.

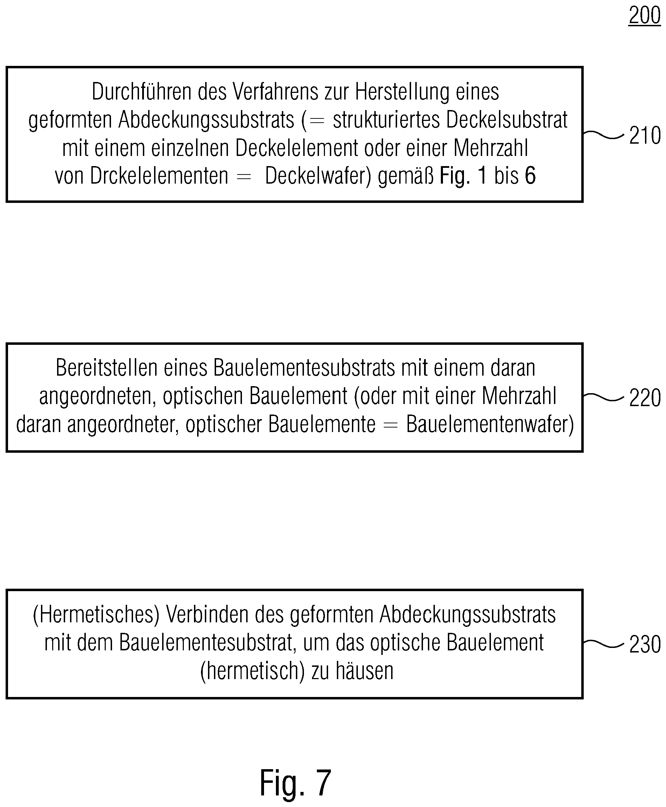

Fig. 7 zeigt nun beispielsweise ein schematisches Flussdiagramm eines erfindungsgemäßen Verfahrens 200 zur Herstellung eines hermetisch gehäusten, optischen oder optoelektronischen Bauelements 1' gemäß einem weiteren Ausführungsbeispiel.

Bevor die nachfolgenden Ausführungsbeispiele im Detail anhand der Zeichnungen näher erläutert werden, wird nochmals darauf hingewiesen, dass identische, funktionsgleiche oder gleichwirkende Elemente, Objekte, Funktionsblöcke und/oder Verfahrensschritte in den unterschiedlichen Figuren mit den gleichen Bezugszeichen versehen sind, so dass die in unterschiedlichen Ausführungsbeispielen dargestellte Beschreibung dieser Elemente, Objekte, Funktionsblöcke und/oder Verfahrensschritte untereinander austauschbar ist bzw. aufeinander angewendet werden kann.

Bei dem Verfahren 200 zur Herstellung eines hermetisch gehäusten, optischen Bauelements, z.B. eine optoelektronischen Sende- und/oder Empfangsbauelements, werden nun folgende Schritte durchgeführt. So wird zunächst bei Schritt 210 das oben beschriebene Verfahren 100 mit den beispielhaften Prozessabläufen 100-1, 100-2, 100-3, 100-4, 100-5 zur Herstellung eines geformten Abdeckungssubstrats (= strukturiertes Deckelsubstrat) 20' durchgeführt. Dabei kann das geformte Abdeckungssubstrat 20' ein einzelnes oder vereinzeltes Deckelelement 24' aufweisen oder kann auch eine Mehrzahl bzw. eine Vielzahl von Deckelelementen 24 (z.B. e Deckelwafer auf Waferebene) aufweisen.

Ferner wird bei Schritt 220 ein Bauelementsubstrat 2 mit zumindest einem daran angeordneten, optoelektronischen Bauelement 1 (= Sende- und/oder Empfangsbauelement) bereitgestellt. Gemäß einem Ausführungsbeispiel kann ein Bauelementsubstrat 2 mit einem einzelnen optoelektronischen Bauelement 1 oder als ein Bauelement-Wafer 2 mit einer Mehrzahl daran angeordneter, optoelektronischer Bauelemente 1 bereitgestellt werden.

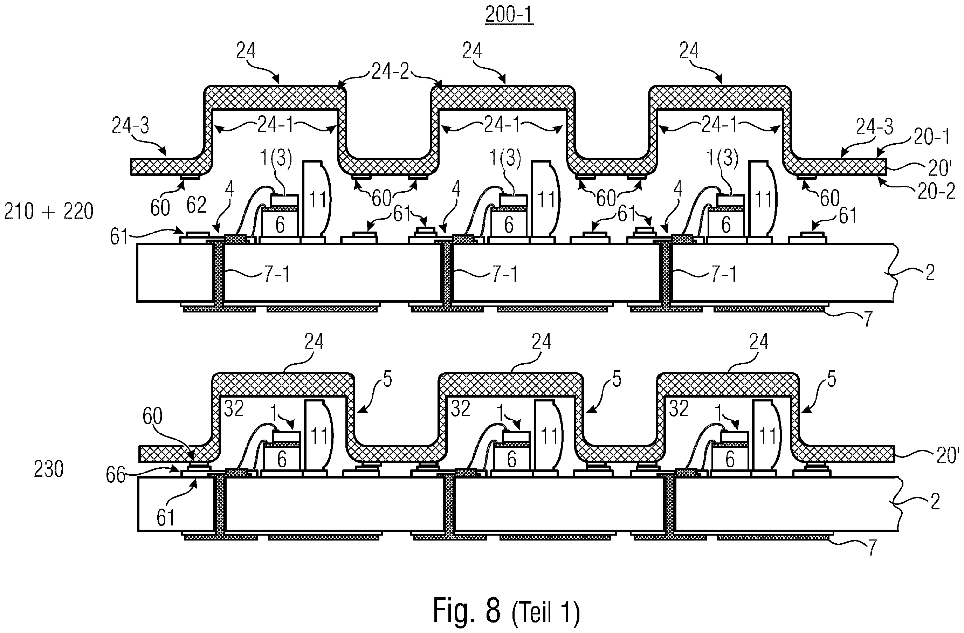

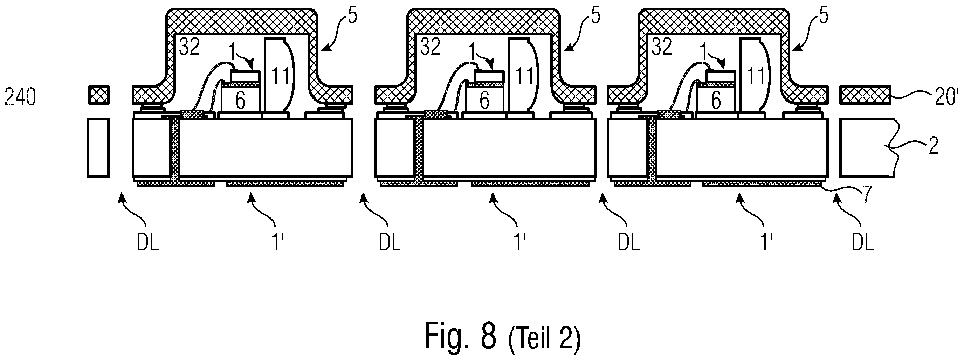

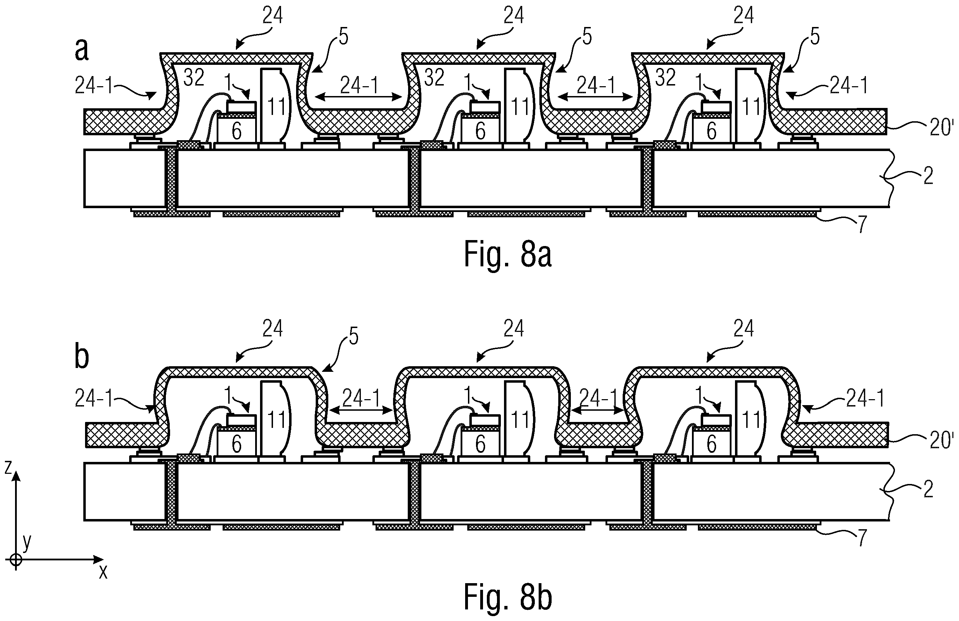

Gemäß einem Ausführungsbeispiel kann beispielsweise der Schritt 210 des Durchführens des Verfahrens 100 auf Waferebene durchgeführt werden, wobei eine Vielzahl von optischen Bauelementen 1 an dem Bauelementesubstrat 2 (Bauelementwafer) angeordnet sind, und wobei das geformte Abdeckungssubstrat 20' (Deckelwafer) eine Vielzahl von Deckelelementen 24 aufweist. In diesem Zusammenhang wird beispielsweise auch auf die Fig. 8 - 10 und die zugehörige Beschreibung verwiesen.

Gemäß einem Ausführungsbeispiel umfasst der Schritt 230 des Verfahrens 200 beispielsweise ferner einen Schritt des Verbindens bzw. hermetischen Verbindens des Bauelementesubstrats 2 und des geformten Abdeckungssubstrats 20' entlang eines dazwischenliegenden Verbindungsbereichs 60, 61, wie z.B. eines Bondrahmens. In diesem Zusammenhang wird beispielsweise auch auf die Fig. 8 - 10 und die zugehörige Beschreibung verwiesen.

Gemäß einem Ausführungsbeispiel des Verfahrens 20 weist der Verbindungbereich 60 an dem zweiten Hauptoberflächenbereich 20-2 z.B. eine Metallisierung auf, um eine Rahmenstruktur, z.B. eine zusammenhängende Rahmenstruktur, auf nicht-ausgewölbten Bereichen 24-3 (= Sockelbereichen) des geformten Abdeckungssubstrats 20' auszubilden, wobei das Verfahren 200 beispielsweise ferner einen Schritt 230 des Verbindens des geformten Abdeckungssubstrats 20' und des Bauelementesubstrats 2 mittels eines Bondrahmens 60 aufweist. Der Bondrahmen 60 kann beispielsweise ein metallisches Lotmaterial 66 aufweisen. In diesem Zusammenhang wird beispielsweise auch auf die Fig. 8 - 10 und die zugehörige Beschreibung verwiesen.

Gemäß einem Ausführungsbeispiel umfasst der Schritt 230 des Verfahrens 200 beispielsweise ferner einen Schritt des Verbindens des Bauelementesubstrat 2 und des Abdeckungssubstrats 20' mittels Laserdirektschweißens, Laserlötens, eutektischen Lötverbindens, Thermokompressionsbondens, Glasfritbondens, reaktiven Nano-Metallschicht-Lötens (RMS) oder Induktionslötens entlang des Verbindungsbereichs 62. In diesem Zusammenhang wird beispielsweise auch auf die Fig. 8 - 10 und die zugehörige Beschreibung verwiesen.

Gemäß einem Ausführungsbeispiel umfasst das Verfahren 200 beispielsweise ferner die Schritte des Vereinzelns 170 des geformten Abdeckungssubstrats 20', um vereinzelte Deckelelemente 24` zu erhalten, und des (hermetischen) Verbindens 230 des vereinzelten Deckelelements 24' mit einem Bauelementesubstrat 2, um das gehäuste, optische Bauelement 1' zu erhalten. In diesem Zusammenhang wird beispielsweise auch auf die Fig. 8 - 10 und die zugehörige Beschreibung verwiesen.

Gemäß einem Ausführungsbeispiel umfasst das Verfahren 200 beispielsweise ferner die Schritte des (hermetischen) Verbindens 230 des geformten Abdeckungssubstrats 20' mit der Vielzahl von Deckelelementen 24 mit dem Bauelementesubstrat 2, das eine Vielzahl von optoelektronischen Bauelementen 1 aufweist, um eine Vielzahl von gehäusten, optischen Bauelementen 1' (auf Waferebene) zu erhalten, und ferner den Schritt des Vereinzelns 240 der Vielzahl von gehäusten, optischen Bauelementen 1', um vereinzelte, hermetisch gehäuste optische Bauelemente 1' zu erhalten. Der Schritt des Vereinzelns 240 kann beispielsweise durch Sägen oder durch Lasertrennung erfolgen. In diesem Zusammenhang wird beispielsweise auch auf die Fig. 8 - 10 und die zugehörige Beschreibung verwiesen.

Gemäß einem Ausführungsbeispiel umfasst das Verfahren 200 beispielsweise ferner die Schritte des Vereinzelns des geformten Abdeckungssubstrats 20', um vereinzelte Deckelelemente 24` zu erhalten, des Vereinzelns des Bauelementesubstrats 2, um vereinzelte Bauelemente 1 auf den vereinzelten Bauelementsubstraten 2' zu erhalten, und des (hermetischen) Verbindens 230 jeweils des vereinzelten Deckelelements 24' mit dem vereinzelten Bauelement 1, um ein gehäustes, optisches Bauelement 1' zu erhalten. In diesem Zusammenhang wird beispielsweise auch auf die Fig. 8 - 10 und die zugehörige Beschreibung verwiesen.

Bei dem Verfahren 200 zur Herstellung eines gehäusten strahlungsemittierenden Bauelementes 1, das beispielsweise auf Waferebene durchgeführt werden kann, ist es gemäß einem Ausführungsbeispiel ebenfalls vorgesehen, dass das Anordnen und hermetische Bonden 230 der Substrate 2, 20', d.h. des Bauelementesubstrats 2 und des geformten Abdeckungssubstrats 20', unter einer vorgegebenen Atmosphäre erfolgt. So kann sichergestellt werden, dass das Gehäuse 2, 20' bzw. dessen Innenvolumen (Kavität) 32 völlig frei von organischen Substanzen oder Wasserdampf ist, so dass die Lebensdauer der optoelektronischen Bauelemente 1, wie z.B. Leuchtdioden bzw. Laserdioden, nicht beeinträchtigt wird.

In der Kavität 32 befindet sich beispielsweise trockene Luft (= reaktive Atmosphäre), Stickstoff oder eine andere Art inerte Atmosphäre, aber auch ein Unterdruck oder gar ein vollständiges Vakuum kann prinzipiell eingestellt werden und zusätzlich durch Einbringung besonderer Getterschichten 4 auch über lange Zeiträume erhalten werden. Als Vakuum kann ein reduzierter atmosphärischer Druck (Unterduck) in der Kavität 32 von etwa 100 Torr, 50 Torr, 5 Torr oder 1 Torr oder darunterliegende Druckwerte angesehen werden. Die Kavität 32 kann auch gegenüber dem Eindringen von Wasserdampf hermetisch dicht ausgebildet sein. In diesem Zusammenhang wird beispielsweise auch auf die Fig. 8 - 10 und die zugehörige Beschreibung verwiesen.

Bei einigen Ausführungsformen ist das gehäuste optoelektronische (strahlungsemittierende oder strahlungsempfindliche) Bauelement 1 derart ausgeführt, dass das Bauelementesubstrat 2 als ein Gehäusesockel und als eine Lagerfläche für das strahlungsemittierende Bauelement 1 dient, wobei das Deckelsubstrat 20' mit dem Gehäusesockel 2 zusammenwirkt, um die Kavität 32 des Gehäuses 5 hermetisch abzudichten. In diesem Zusammenhang wird beispielsweise auch auf die Fig. 8 - 10 und die zugehörige Beschreibung verwiesen.

Bei einigen Ausführungsformen ist das gehäuste strahlungsemittierende Bauelement 1' derart ausgeführt, dass der Gehäusesockel 2 (Bauelementesubstrat) als ein Sockelwafer, der mehrere Gehäusesockelelemente 2' umfasst, ausgebildet ist und/oder das Deckelsubstrat 20' als einem Deckelwafer, der mehrere Deckelelemente 24 umfasst, ausgebildet ist. In diesem Zusammenhang wird beispielsweise auch auf die Fig. 8 - 10 und die zugehörige Beschreibung verwiesen.

Bei einigen Ausführungsformen ist das gehäuste strahlungsemittierende Bauelement 1' derart ausgeführt, dass zwischen dem Bauelementesubstrat 2 und dem strahlungsemittierenden Bauelement 1 ein Zwischenträger 6 für das strahlungsemittierende Bauelement 1 angeordnet ist, so dass das Bauelementesubstrat 2 das strahlungsemittierende Bauelement 1 mittelbar (über den Zwischenträger 6) trägt. In diesem Zusammenhang wird beispielsweise auch auf die Fig. 8 - 10 und die zugehörige Beschreibung verwiesen.

Bei einigen Ausführungsformen ist das gehäuste strahlungsemittierende Bauelement 1' derart ausgeführt, dass das Bauelementesubstrat 2 und das Deckelsubstrat 20' mittels eines Bondrahmens 60, 61, der ein metallisches Lotmaterial 66 aufweist, aneinander befestigt sind. Der Bondrahmen 60, 61 kann die gegenüberliegenden Metallsierungen 60, 61 an dem Deckelsubstrat 20' (auf dem zweiten Hauptoberflächenbereich 20-2) und dem Bauelementesubstrat 2 (auf dem ersten Hauptoberflächenbereich 2-1) mit dem dazwischenliegenden Lotmaterial 66, das eine mechanische und elektrische Verbindung zwischen den Metallisierungen 60, 61 herstellt. In diesem Zusammenhang wird beispielsweise auch auf die Fig. 8 - 10 und die zugehörige Beschreibung verwiesen.

Bei einigen Ausführungsformen ist das gehäuste strahlungsemittierende Bauelement 1' derart ausgeführt, dass eine Leiterbahn 7 zum elektrischen Anbinden des strahlungsemittierenden Bauelements 1 seitens des Bauelementesubstrats 2 angeordnet ist und die Leiterbahn 7 zwischen dem Deckelsubstrat 20' und dem Bauelementesubstrat 2 aus der Kavität 32, z.B. seitlich, herausgeführt ist. In diesem Zusammenhang wird beispielsweise auch auf die Fig. 8 - 10 und die zugehörige Beschreibung verwiesen.

Bei einigen Ausführungsformen ist das gehäuste strahlungsemittierende Bauelement 1' derart ausgeführt, dass eine Leiterbahn 7 zum elektrischen Anbinden des strahlungsemittierenden Bauelements 1 seitens des Bauelementesubstrats 2 angeordnet ist und die Leiterbahn 7 durch das Bauelementesubstrat 2 aus der Kavität 32 nach unten herausgeführt ist. Dazu kann beispielsweise eine TSV- und/oder TGV-Anordnung 7-1 (Through silicon vias (TSV) oder Through Glass Via (TGV)) eingesetzt werden. In diesem Zusammenhang wird beispielsweise auch auf die Fig. 8 - 10 und die zugehörige Beschreibung verwiesen.

Bei einigen Ausführungsformen ist das gehäuste strahlungsemittierende Bauelement 1' derart ausgeführt, dass dem optischen Auskoppelfenster (optisches Seitenfenster) 24-1 seitens des Bauelementesubstrats 2 eine optische Bank 8 mit einem oder mehreren zusätzlichen optischen Elementen 8-1, z.B. diskreten Linsenelementen, vorgelagert ist, so dass das optische Auskoppelfenster 24-1 zwischen der optischen Bank 8 mit dem zusätzlichen optischen Element 8-1 und dem strahlungsemittierenden Bauelement 1 angeordnet ist. In diesem Zusammenhang wird beispielsweise auch auf die Fig. 8 - 10 und die zugehörige Beschreibung verwiesen.

Bei einigen Ausführungsformen ist das gehäuste strahlungsemittierende Bauelement 1 derart ausgeführt, dass die optische Bank 8 mit dem zusätzlichen optischen Elemente 8-1, z.B. Linsen, Prismen, Spiegel, Aperturen etc., auf dem Bauelementesubstrat 2 angeordnet ist und sich in der Abstrahlrichtung des strahlungsemittierenden Bauelements 2 befindet. In diesem Zusammenhang wird beispielsweise auch auf die Fig. 8 - 10 und die zugehörige Beschreibung verwiesen.

Bei einigen Ausführungsformen ist das gehäuste strahlungsemittierende Bauelement 1 derart ausgeführt, dass es ferner ein für eine Lichtfarbenumwandlung des emittierten Lichts wirksames Element (Konversionselement) 9 aufweist, so dass das optische Auskoppelfenster 24-1 zwischen dem wirksamen Element 9 und dem strahlungsemittierenden Bauelement 1 angeordnet ist.

Bei einigen Ausführungsformen ist das gehäuste strahlungsemittierende Bauelement 1 derart ausgeführt, dass die Kavität 32 eine reaktive Atmosphäre aufweist und/oder die Kavität 32 ausschließlich anorganische Substanzen enthält. Die Kavität 32 kann auch gegenüber dem Eindringen von Wasserdampf hermetisch dicht ausgebildet sein. Dadurch kann ein langlebiger Betrieb z.B. von blauen und grünen Laserdioden gewährleitet oder zumindest unterstützt werden.

Bei einigen Ausführungsformen ist das gehäuste strahlungsemittierende Bauelement 1 derart ausgeführt, dass in der Kavität eine elektronische Treiberschaltung 3 angeordnet ist. Die eine elektronische Treiberschaltung 3 kann z.B. in dem Bestückungssubstrat 2 integriert sein.

Bei einigen Ausführungsformen befinden sich strahlungsemittierende Bauelemente und Photodetektoren in gleichen Kavitäten des Deckelsubstrats.

Bei einigen Ausführungsformen befinden sich strahlungsemittierende Bauelemente und Photodetektoren in benachbarten Kavitäten des Deckelsubstrats, derart ausgeführt, dass das Bauelementesubstrat einen gemeinsamen Gehäusesockel bildet. Gemäß Ausführungsbeispielen ist keine optische Entkopplung zwischen benachbarten Kavitäten erforderlich,
Bei einigen Ausführungsformen weist das gehäuste optoelektronische Bauelement 1 ein Detektorelement und ein Emitter-Element in einem Gehäuse 5 auf.

Den voranstehenden Ausführungen entsprechend ermöglicht das Herstellungsverfahren 200 zur hermetischen Häusung eine optoelektronischen Bauelements 1 verschiedene Ausführungsformen und Ausgestaltungen des resultierenden, hermetisch gehäusten, optoelektronischen Bauelements 1', beispielsweise:
Eine Verkappung von einzelnen Laserdioden 1 (oder allg. einzelnen optoelektronischen Bauelementen 1) auf einem Submount 6 in einem hermetisch dichten Gehäuse 5, geschaffen durch Aufbonden eines Deckels 20' mit mindestens einer seitlichen optisch neutralen Fensterfläche 24-1.

Eine Verkappung von einzelnen Laserdioden 1 direkt auf dem Substrat 2 in einem hermetisch dichten Gehäuse 5, geschaffen durch Aufbonden eines Deckels 20' mit mindestens einer seitlichen optisch neutralen Fensterfläche 24-1.

Eine Verkappung von einzelnen Laserdioden 1 und einzelnen passiven optischen Elementen in einem hermetisch dichten Gehäuse 5, geschaffen durch Aufbonden eines Deckels 20' mit mindestens einer seitlichen Fensterfläche 24-1.

Eine Verkappung von einer oder mehreren Laserdioden 1 mit "Fast-Focus-Kollimation" (fast focus collimation) durch eine gemeinsame Zylinderlinse (oben oder Seite)innerhalb des hermetisch dichten Gehäuses, optional mit jeweils einer weiteren Linse oder einer gemeinsamen Mehrfach-Zylinderlinse 8 zur Slow-Axis-Kollimation (slow axis collimation) außerhalb der hermetischen Gehäusung 5.

Eine Verkappung von einer oder mehreren Laserdioden 1 mit Strahlkollimation durch individuelle Sammellinsen innerhalb des hermetisch dichten Gehäuses (oben oder Seite), optional mit jeweils einer weiteren Linse oder einer gemeinsamen Mehrfach-Sammellinse 8 zur weiteren Strahlkollimation außerhalb der hermetischen Gehäusung 5, optional mit einer optischen Struktur zur Strahlüberlagerung und optional zur statischen Strahlablenkung.

Eine Verkappung von einer oder mehreren Laserdioden 1 mit Strahlkollimation durch individuelle Sammellinsen innerhalb des hermetisch dichten Gehäuses (oben oder Seite), optional mit jeweils einer weiteren Linse oder einer gemeinsamen Mehrfach-Sammellinse 8 zur weiteren Strahlkollimation außerhalb der hermetischen Gehäusung 5, optional mit einer optischen Struktur zur Strahlüberlagerung und optional zur statischen Strahlablenkung.

Eine Verkappung von Laserdioden auf einem Submount mit elektronischer Treiberschaltung innerhalb der hermetischen Gehäusung.

Eine Verkappung von einer oder mehreren Laserdioden 1 mit oder ohne Submount mit oder ohne Fast-Axis-Kollimation und einer Lichtfarbenumwandlung durch einen außen angeordneten Phosphorkörper, der als Formkörper fixiert oder als in einem Polymer (Epoxy oder Silikonmatrix) gebundener Phosphor aufdispensiert und ausgehärtet wird. Die außen (= außerhalb des Gehäuses 5) angeordneten optisch aktiven Bauelemente können gelötet oder durch eine Klebung fixiert werden, weil organische Ausgasungen keine Eintrübungen im Strahlaustritt erzeugen.

Eine Verkappung mindestens einer Halbleiter-basierten Lichtquelle 1 und mindestens eines Photodetektors 1-2 in dem hermetisch abgedichteten Gehäuse 5 geschaffen durch Aufbonden (= Verfahren 200) eines nach den genannten Verfahren 100 hergestellten Glasdeckels 20' z.B. mit einer vom Substrat 2 wegzeigenden optisch neutralen Fensterfläche.

Die in der Kavität 32 angeordneten Bauelemente 1 und die Verkappung 20' selbst können beispielsweise durch metallische Fügeverfahren wie Löten, eutektisch AuSn Löten, etc. gefügt werden, um organische Ausgasungen im Gehäuse 5 zu vermeiden. Flussmittel brauchen nicht verwendet zu werden.

Im Folgenden werden nun anhand der Fig. 8 - 10 beispielhafte Prozessfolgenden bzw. Prozessabläufe zur Implementierung des in Fig. 7 dargestellten, prinzipiellen Herstellungsverfahrens 200 beschrieben. In den Fig. 8 - 10 erstreckt sich die Zeichenebene wieder parallel zu der x-z-Ebene.

Alle nachfolgend beschriebenen Prozessalternativen zu dem Verfahren 200 basieren auf dem grundlegenden Konzept, dass zunächst das geformte Abdeckungssubstrat 20', d. h. das strukturierte Deckelsubstrat mit einem oder einer Mehrzahl von Deckelelementen 24, mit dem obigen Verfahren 100 durchgeführt wird. Ferner wird ein Bauelementesubstrat 2, an dem ein oder eine Mehrzahl von optoelektronischen Bauelementen 1 angeordnet ist, bereitgestellt (Schritt 220). Bei einem Schritt 230 werden nun das geformte Abdeckungssubstrat 20' und das Bauelement des Substrats 1 miteinander verbunden, z. B. hermetisch miteinander verbunden/gebondet, um das optische Bauelement 1 hermetisch zu häusen, d. h. gegenüber der Umgebungsatmosphäre bzw. gegenüber Umgebungseinflüssen hermetisch dicht in einem Gehäuse unterzubringen. Als eine hermetische oder hermetisch dichte Häusung wird eine fluidisch dichte, mechanische Verbindung (Verkappung) des Bauelementesubstrat 2 und des geformten Abdeckungssubstrats 20' angesehen.

Fig. 8 zeigt nun ein erstes beispielhaftes prinzipielles Ablaufdiagramm 200-1 des erfindungsgemäßen Verfahrens 200 zur Herstellung eines hermetisch gehäusten, optischen Bauelements 1' gemäß einem weiteren Ausführungsbeispiel. Insbesondere zeigt Fig. 8 eine Abfolge des Verkappungsprozesses 200-1 mit optischen neutralen Seitenfenstern 24-1 auf Waferebene bis hin zur Wafervereinzelung gemäß einem Ausführungsbeispiel in einer Variante mit den vertikalen seitlichen Fensterfläche 24-1, wobei die optisch neutralen Auskoppelfenster (Seitenfenster) 24-1 eine 90° Ausrichtung zur Trägersubstratebene (x-y-Ebene) aufweisen, und wobei das strahlungsemittierende Bauelement 1 beispielsweise eine Abstrahlrichtung bzw. Hauptabstrahlrichtung (bei einem divergierenden bzw. sich aufweitenden Strahl)im Wesentlichen parallel zur Trägersubstratebene (x-y-Ebene) aufweist.

Bei dem Verfahren 200 zur Herstellung eines hermetisch gehäusten, optischen Bauelements, z.B. eines optoelektronischen Sende- und/oder Empfangsbauelements, werden nun folgende Schritte durchgeführt. So wird zunächst das oben beschriebene Verfahren 100 mit den beispielhaften Prozessabläufen 100-1, 100-2, 100-3, 100-4, 100-5 zur Herstellung eines geformten Abdeckungssubstrats (= strukturiertes Deckelsubstrat) 20' durchgeführt. Dabei kann das geformte Abdeckungssubstrat 20' eine Mehrzahl bzw. Vielzahl von Deckelelementen 24 aufweisen. Ferner wird bei Schritt 220 ein Bauelementsubstrat 2, z.B. als ein Bauelement-Wafer, mit einer Mehrzahl daran angeordneter optoelektronischer Bauelemente 1 bereitgestellt. Dabei kann jeweils einem Deckelelement 24 ein optoelektronisches Bauelement 1 zugeordnet sein. Bei dem Schritt des (hermetischen) Verbindens 230 des geformten Abdeckungssubstrats 20' mit der Vielzahl von Deckelelementen 24 mit dem Bauelementesubstrat 2, das wiederum eine Vielzahl von optoelektronischen Bauelementen 1 aufweist, wird somit eine Vielzahl von gehäusten, optischen Bauelementen 1' (auf Waferebene) erhalten.

Der Schritt des Verbindens des Bauelementesubstrats 2 und des geformten Abdeckungssubstrats 20' kann beispielsweise entlang eines dazwischenliegenden Verbindungsbereichs 60, wie z.B. eines Bondrahmens, erfolgen. Der Verbindungbereich 60 kann eine Metallisierung aufweisen, um eine Rahmenstruktur, z.B. eine zusammenhängende Rahmenstruktur, auf nicht-ausgewölbten Bereichen 24-3 (= Sockelbereichen) des geformten Abdeckungssubstrats 20' auszubilden. Der Bondrahmen 60 kann beispielsweise ein metallisches Lotmaterial 66 aufweisen.

Der Schritt des Verbindens 230 des Bauelementesubstrat 2 und des Abdeckungssubstrats 20' kann auch mittels Laserdirektschweißens, Laserlötens, eutektischen Lötverbindens, Thermokompressionsbondens, Glasfritbondens, reaktiven Nano-Metallschicht-Lötens (RMS) oder Induktionslötens entlang des Verbindungsbereichs 60 durchgeführt werden.

Ferner wird ein Schritt des Vereinzelns 240 der Vielzahl von gehäusten, optischen Bauelementen 1' entlang einer Vereinzelungslinie DL (dicing line) durchgeführt, um vereinzelte, hermetisch gehäuste optische Bauelemente 1' zu erhalten. Der Schritt des Vereinzelns 240 kann beispielsweise durch Sägen oder durch Lasertrennung erfolgen.

Das Verfahren 200 zur Herstellung eines gehäusten strahlungsemittierenden Bauelementes 1 kann beispielsweise auf Waferebene durchgeführt werden kann, wobei das Anordnen und hermetische Bonden 230 der Substrate 2, 20', d.h. des Bauelementesubstrats 2 und des geformten Abdeckungssubstrats 20', unter der vorgegebenen Atmosphäre erfolgt. So kann sichergestellt werden, dass das Gehäuse 2, 20' bzw. dessen Innenvolumen 32 völlig frei von organischen Substanzen oder Wasserdampf ist, so dass die Lebensdauer der optoelektronischen Bauelemente 1, wie z.B. Leuchtdioden bzw. Laserdioden, nicht beeinträchtigt wird. In der Kavität 32 befindet sich beispielsweise trockene Luft (= reaktive Atmosphäre), Stickstoff oder eine andere Art inerte Atmosphäre, aber auch ein Unterdruck oder gar ein vollständiges Vakuum kann prinzipiell eingestellt werden und zusätzlich durch Einbringung besonderer Getterschichten 4 auch über lange Zeiträume erhalten werden. Als Vakuum kann ein reduzierter atmosphärischer Druck (Unterduck) in der Kavität 32 von etwa 100 Torr, 50 Torr, 5 Torr oder 1 Torr oder darunterliegende Druckwerte angesehen werden. Die Kavität 32 kann auch gegenüber dem Eindringen von Wasserdampf hermetisch dicht ausgebildet sein.

Ferner kann zwischen dem Bauelementesubstrat 2 und dem strahlungsemittierenden Bauelement 1 ein Zwischenträger 6 für das strahlungsemittierende Bauelement 1 angeordnet ist, so dass das Bauelementesubstrat 2 das strahlungsemittierende Bauelement 1 mittelbar (= über den Zwischenträger 6) trägt. Bei dem Ausführungsformen ist das gehäuste strahlungsemittierende Bauelement 1' derart ausgeführt, dass eine Leiterbahn 7 zum elektrischen Anbinden des strahlungsemittierenden Bauelements 1 seitens des Bauelementesubstrats 2 angeordnet ist und die Leiterbahn 7 zwischen dem Deckelsubstrat 20' und dem Bauelementesubstrat 2 aus der Kavität 32, z.B. seitlich, und/oder nach unten herausgeführt ist. Dazu kann beispielsweise eine TSV- und/oder TGV-Anordnung 7-1 (Through silicon vias (TSV) oder Through Glass Via (TGV)) eingesetzt werden.

Bei dem beispielhaften Ablaufdiagramm 200-1 des erfindungsgemäßen Verfahrens 200 zur Herstellung eines hermetisch gehäusten, optischen Bauelements 1' von Fig. 8 ist eine Abfolge eines Verkappungsprozesses mit planen Seitenfenstern auf Waferebene bis hin zur Wafervereinzelung in einer beispielhaften Variante mit einer im Gehäuse 5 positionierten Linse 11 dargestellt. Bei dem Verkappungsprozess kann eine oder können mehrere Laserdioden mit einer *"Fast-Focus-Kollimation"* (fast focus collimation) durch eine gemeinsame Zylinderlinse (Kollimationslinse) 11 innerhalb des hermetisch dichten Gehäuses 5 angeordnet sein. Diese Linse 11 wird beispielsweise an das Bauelementesubstrat 2 gelötet, um organische Ausgasungen in der Nähe der Laserdiode zu vermeiden.

Fig. 8a und 8b zeigen nun ein weitere beispielhafte Ausgestaltungen des Ablaufdiagramm 200-1 des erfindungsgemäßen Verfahrens 200 zur Herstellung eines hermetisch gehäusten, optischen Bauelements 1' gemäß einem weiteren Ausführungsbeispiel. Insbesondere zeigt Fig. 8a die Verwendung eines geformten Abdeckungssubstrats (= strukturierten Deckelsubstrats) 20' mit konkaven Seitenfenstern 24-1 bei dem Verkappungsprozess 200 auf Waferebene. Fig. 8b zeigt die Verwendung eines geformten Abdeckungssubstrats 20' mit konvexen Seitenfenstern 24-1, 24-2 bei dem Verkappungsprozess 200 auf Waferebene.

Die obige Beschreibung des Prozessablaufs 200-1 mit der Abfolge des Verkappungsprozess 200-1 in Fig. 8 ist gleichermaßen und entsprechend auch auf die Verwendung von konkaven Seitenfenstern 24-1 in Fig. 8a (bei der das optische Auskoppelfenster eine konkave Fenstergeometrie mit 90° Ausrichtung zur Trägersubstratebene aufweist) und von konvexen Seitenfenstern 24-1 in Fig. 8b (bei der das optische Auskoppelfenster eine konvexe Fenstergeometrie mit 90° Ausrichtung zur Trägersubstratebene aufweist) anwendbar.

Dies gilt ebenso für die nachfolgende Beschreibung weiterer Prozessabläufe 200 mit der Abfolge des Verkappungsprozess 200-#, d.h. die Beschreibung ist gleichermaßen und entsprechend auch auf die Verwendung von planen vertikalen, konkaven oder konvexen Seitenfenstern 24-1 anwendbar.

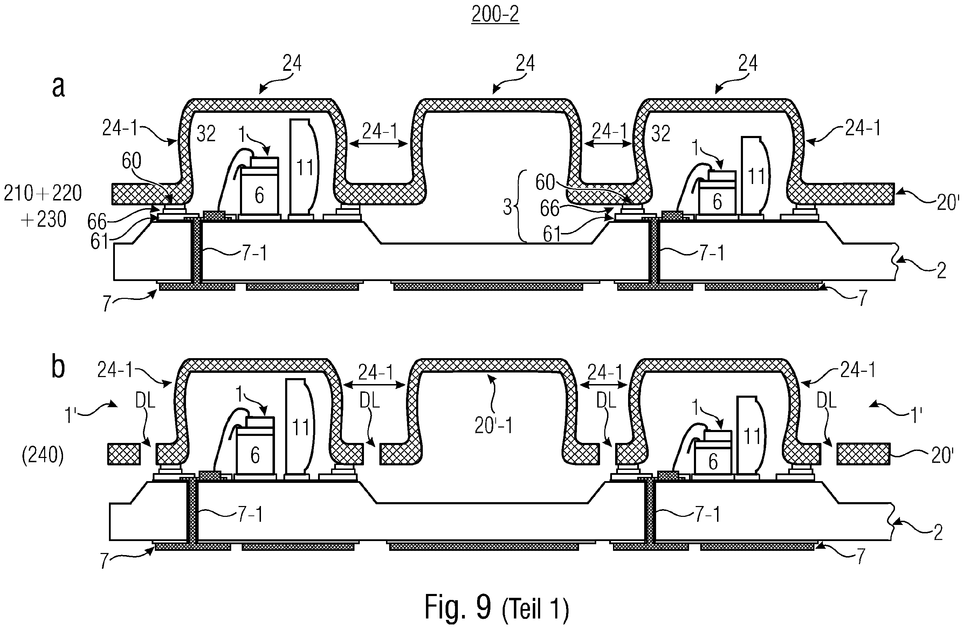

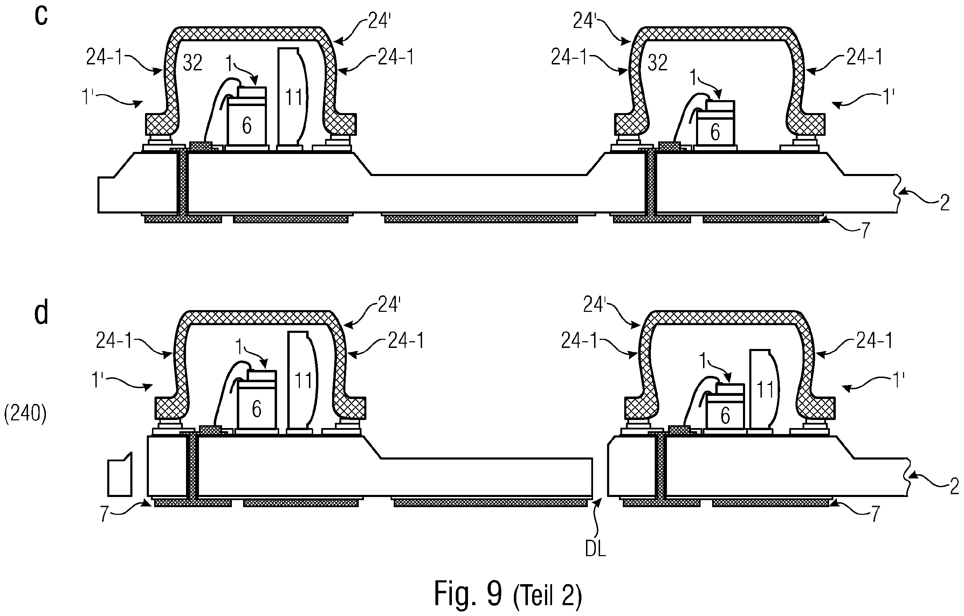

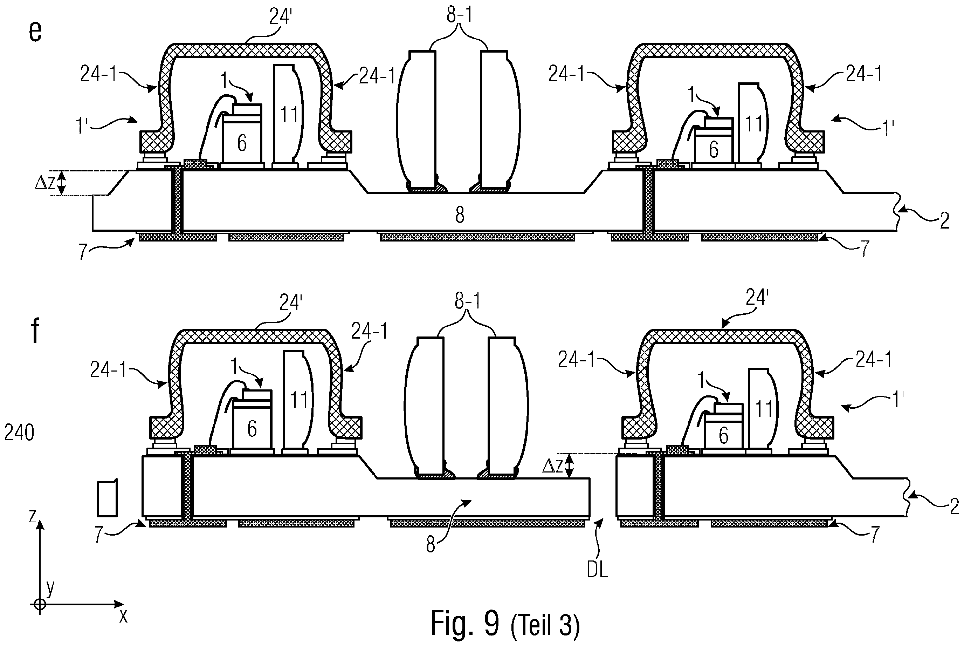

Fig. 9 zeigt nun ein weiteres beispielhaftes prinzipielles Ablaufdiagramm 200-2 des erfindungsgemäßen Verfahrens 200 zur Herstellung eines hermetisch gehäusten, optischen Bauelements 1' gemäß einem weiteren Ausführungsbeispiel. Insbesondere zeigt Fig. 9 eine Abfolge des Verkappungsprozesses 200-2 mit optisch neutralen Seitenfenstern 24-1 auf Waferebene bis hin zur Wafervereinzelung gemäß einem Ausführungsbeispiel in einer Variante, bei der das strahlungsemittierende Bauelement 1 beispielsweise eine Abstrahlrichtung bzw. Hauptabstrahlrichtung (bei einem sich aufweitenden Strahl) im Wesentlichen parallel zur Trägersubstratebene (x-y-Ebene) aufweist.

Fig. 9 zeigt eine Abfolge eines Verkappungsprozesses mit konvexen Seitenfenstern auf Waferebene bis hin zur Wafer-Vereinzelung. Die Beschreibung ist entsprechend auch auf die Verwendung von planen vertikalen oder konkaven Seitenfenstern 24-1 anwendbar. Das Trägersubstrat 2 ist mit einer optischen Bank 8-1 ausgestattet. Linsen 11 sind innerhalb des hermetischen Gehäuses 5 z.B. aufgelötet und zusätzliche optische Elemente 8-1 sind auf einer offenen optischen Bank 8 z.B. durch Klebstoff montiert.

Bei dem Verfahren 200 zur Herstellung eines hermetisch gehäusten, optischen Bauelements, z.B. eine optoelektronischen Sende- und/oder Empfangsbauelements, werden nun folgende Schritte durchgeführt. So wird zunächst das oben beschriebene Verfahren 100 mit den beispielhaften Prozessabläufen 100-1 ... 100-5 zur Herstellung eines geformten Abdeckungssubstrats (= strukturiertes Deckelsubstrat) 20' durchgeführt. Dabei kann das geformte Abdeckungssubstrat 20' eine Mehrzahl bzw. Vielzahl von Deckelelementen 24 aufweisen. Ferner wird bei Schritt 220 ein Bauelementsubstrat 2, z.B. als ein BauelementWafer, mit einer Mehrzahl daran angeordneter optoelektronischer Bauelemente 1 bereitgestellt. Dabei kann jeweils einem Deckelelement 24 ein optoelektronisches Bauelement 1 zugeordnet sein. Bei dem Schritt des (hermetischen) Verbindens 230 des geformten Abdeckungssubstrats 20' mit der Vielzahl von Deckelelementen 24 mit dem Bauelementesubstrat 2, das wiederum eine Vielzahl von optoelektronischen Bauelementen 1 aufweist, wird somit eine Vielzahl von gehäusten, optischen Bauelementen 1' (auf Waferebene) erhalten (= Fig. 9a).

Ferner wird ein Schritt des Vereinzelns 240 der Vielzahl von gehäusten, optischen Bauelementen 1' durchgeführt, um vereinzelte, hermetisch gehäuste optische Bauelemente 1' zu erhalten. Der Schritt des Vereinzelns 240 kann beispielsweise durch Sägen oder durch Lasertrennung erfolgen.

Bei dem Schritt des Vereinzelns 240 wird, wie bei Fig. 9b dargestellt ist, ein Zwischenbereich 20'-1 des Deckelsubstrats 20' beispielsweise mittels Sägen oder Lasertrennung an der Vereinzelungslinie DL abgetrennt und bei Fig. 9c von der Anordnung entfernt. Bei der Anordnung von Fig. 9c sind also die optoelektronischen Bauelementen 1 auf dem Bauelementsubstrat 2 jeweils einzeln mit einem Deckelelement 24' hermetisch gehäust.

Wie in Fig. 9d-f beispielhaft dargestellt ist, kann der Schritt des Vereinzelns 240 der Vielzahl von gehäusten optoelektronischen Bauelementen 1' in unterschiedliche Teilprozessabläufe aufgeteilt werden. Gemäß einem Ausführungsbeispiel kann das gehäuste strahlungsemittierende Bauelement 1' nun derart ausgeführt sein, dass dem optische neutralen Auskoppelfenster (optisches Seitenfenster) 24-1 seitens des Bauelementsubstrats 2 eine optische Bank 8 mit dem zusätzlichen optischen Element 8-1 vorgelagert ist, so dass das optisch neutrale Auskoppelfenster 24-1 zwischen der optischen Bank 8 und dem strahlungsemittierenden Bauelement (optoelektronischen Bauelement) 1 angeordnet ist.
1. Alternative - Prozessfolge gemäß Fig. 9a - b - c - d - f: Wie bei Fig. 9d beispielhaft dargestellt ist, können die gehäusten, optoelektronischen Bauelemente 1' vereinzelt werden, um die vereinzelten, hermetisch gehäusten, optoelektronischen Bauelemente 1' zu erhalten. Gemäß der ersten Alternative werden nun an den vereinzelten Bauelementsubstraten 2` jeweils (zumindest) eine optische Bank 8 vorgelagert zu dem Auskoppelfenster 24-1, d.h. außerhalb des Gehäuses 5 mit dem strahlungsemittierenden Bauelement (optoelektronischen Bauelement) 1, angeordnet. Somit wird die in Fig. 9f dargestellte Anordnung der vereinzelten, hermetisch gehäusten optischen Bauelementen 1' mit der vorgelagerten optischen Bank 8 auf dem Bauelementsubstrat 8 erhalten.
2. Alternative - Prozessfolge gemäß Fig. 9a - b - c - e - f: Wie bei Fig. 9c beispielhaft dargestellt ist, werden die einzeln gehäusten, optoelektronischen Bauelemente 1' auf dem gemeinsamen Bauelementsubstrat 2 erhalten. Gemäß der zweiten Alternative wird nun an dem Bauelementsubstrat 2 jeweils (zumindest) eine optische Bank 8 mit dem zusätzlichen optischen Element 8-1 vorgelagert zu dem Auskoppelfenster 24-1, d.h. außerhalb des Gehäuses 5 mit dem strahlungsemittierenden Bauelement (optoelektronischen Bauelement) 1, angeordnet, wie dies in Fig. 9e dargestellt ist. Wie bei Fig. 9f beispielhaft dargestellt ist, werden nun die gehäusten, optoelektronischen Bauelemente 1' vereinzelt, um die vereinzelten, hermetisch gehäusten, optoelektronischen Bauelemente 1' zu erhalten. Somit wird wieder die in Fig. 9f dargestellte Anordnung der vereinzelten, hermetisch gehäusten optischen Bauelementen 1' mit der vorgelagerten optischen Bank 8 mit dem zusätzlichen optischen Element 8-1 auf dem Bauelementsubstrat 8 erhalten.

Die Fig. 9a-f zeigen also eine Abfolge eines Verkappungsprozesses mit optisch neutralen Seitenfenstern 24-1 auf Waferebene bis hin zur Wafer-Vereinzelung. Das Trägersubstrat 2 ist mit einer optischen Bank 8 mit dem zusätzlichen optischen Element 8-1 ausgestattet. Fügeprozesse mit hohen Temperaturanforderungen werden zuerst auf dem Trägersubstrat durchgeführt. Die Verkappung wird auf Waferebene mit einem Glaskappenwafer ausgeführt. Der Standardablauf erfolgt von Fig. 9a-c, wobei eine Verzweigung der Prozessabfolge durch Substratvereinzelung in Fig. 9a-b-c-e-f (1. Alternative) oder Fig. 9a-b-cd-f (2. Alternative). Hier verzweigt der Prozessfluss: Die Abfolge a-b-c-d-f zeigt die Optikmontage auf der optischen Bank 8 im Fall der vorgelagerten Wafervereinzelung, während die Abfolge a-b-c-e-f die Optikmontage auf der optischen Bank 8 im Fall der nachgelagerten Wafervereinzelung zeigt. Optional sind neben den Halbleiter-Emittern 1 auch Monitordioden zur Überwachung der Laserleistung, Linsen oder andere optische Elemente innerhalb des hermetischen Gehäuses 5 montiert, z.B. aufgelötet. Der Fall gilt auch, wenn die Kappen zwar einzeln aufgesetzt werden, aber alle gemeinsam in einem Fügeprozessschritt hermetisch mit dem Trägersubstrat gefügt werden.

Die für die Strahlkollimation und Strahlkombination notwendigen optischen Funktionen können auf einer offenen, angeschlossenen optischen Bank 8 außerhalb des hermetischen Gehäuses 5 integriert bzw. angeordnet sein.

Fig. 9f zeigt somit eine verteilte Anordnung der optischen Elemente 8, 11, wobei ein Teil der optischen Funktionen innerhalb des hermetisch verschlossenen Gehäuses 5 als die Linsenelemente 11 aufgebaut ist. Hierzu werden vorzugsweise organikfreie Verbindungstechniken auf Basis von Weichloten eingesetzt. Weitere notwendige optische Elemente 8-1 sind auf der angeschlossenen optischen Bank 8 aufgebaut.

Fig. 9a-f zeigt ferner beispielhaft eine Ausführungsform, bei der das Bauelementesubstrat 2, in diesem Fall z.B. ein Siliziumträgerchip, im Bereich der Optiken 8 (optischen Bank) durch Ätzen um eine Absenkhöhe "Δz" abgesenkt wurde, um dadurch mehr vertikalen Bauraum für die Optiken 8 zu schaffen. Dabei können die Optiken 8 mittels Klebeverbindungen als die optischen Bank 8 auf dem Bauelementsubstrat 2 angeordnet sein. Wie in Fig. 9f dargestellt ist, liegt die Ebene der optischen Bank 8 auf einer anderen, (vertikal) niedrigeren Höhenebene als die Montageebene für die Laserdioden 1 bzw. dem Versiegelungsrahmen 3 (= 60, 61, 66).

Die Ebene der optischen Bank 8 mit dem zusätzlichen optischen Element 8-1 kann auch gemäß weiteren Ausführungsbeispielen auf einer anderen, vertikal höheren Höhenebene liegen als die Montageebene für die Laserdioden 1 bzw. dem Versiegelungsrahmen 3. Auch eine erhöhte Montageebene kann im Trägerwafer gebildet werden (z.B. als eine Mesastruktur).

Bei dem Verkappungsprozess von Fig. 9 kann (entsprechend zu Fig. 8 und 8a-b) ein geformtes Abdeckungssubstrat (= strukturiertes Deckelsubstrat) 20' gleichermaßen ein geformtes Abdeckungssubstrat 20' mit konkaven oder planen, vertikalen Seitenfenstern 24-1 verwendet werden.

Fig. 9a-f zeigen wie grundsätzlich die für die Strahlkollimation und Strahlkombination notwendigen optischen Funktionen auf einer offenen, angeschlossenen optischen Bank außerhalb des hermetischen Gehäuses integriert sind.

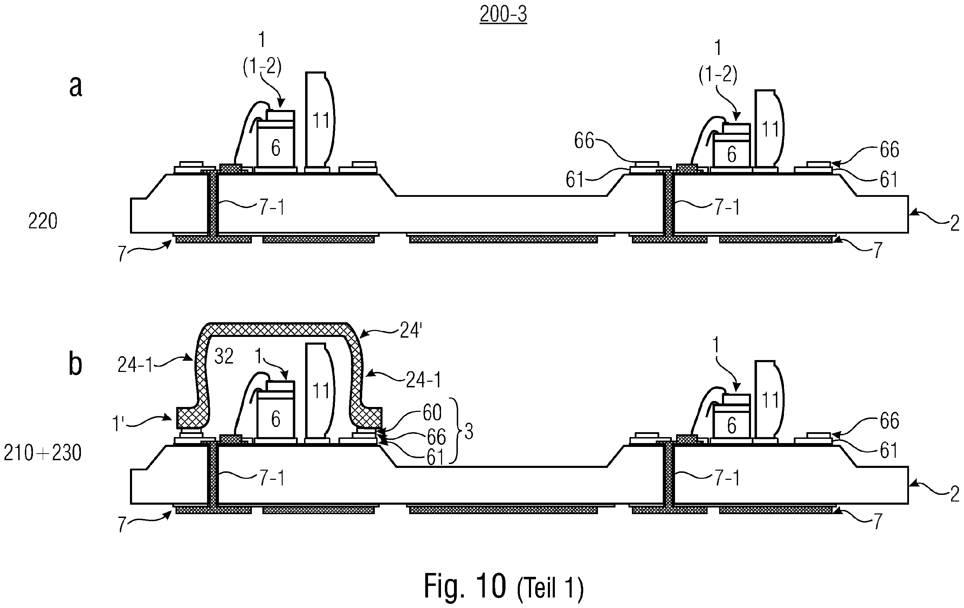

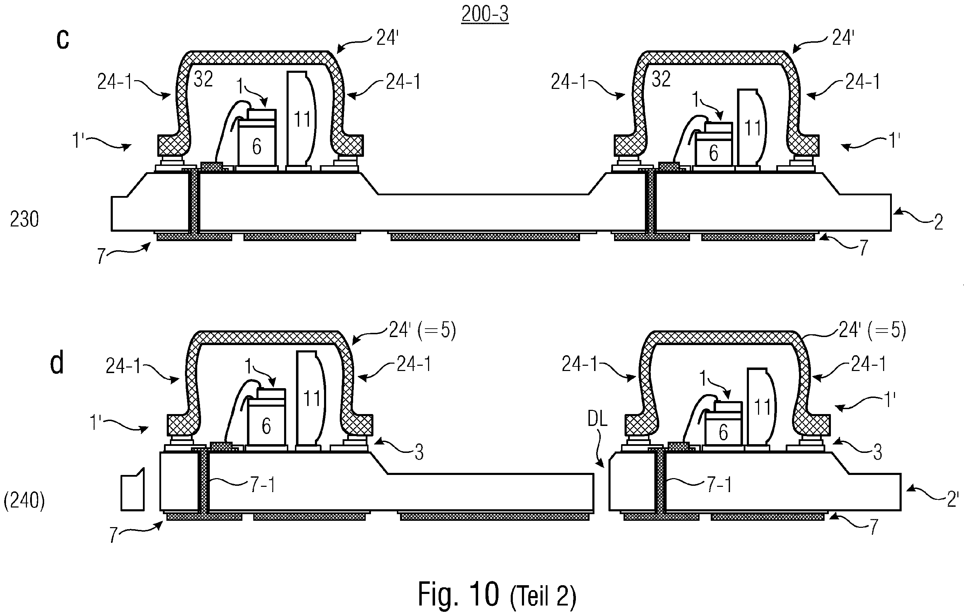

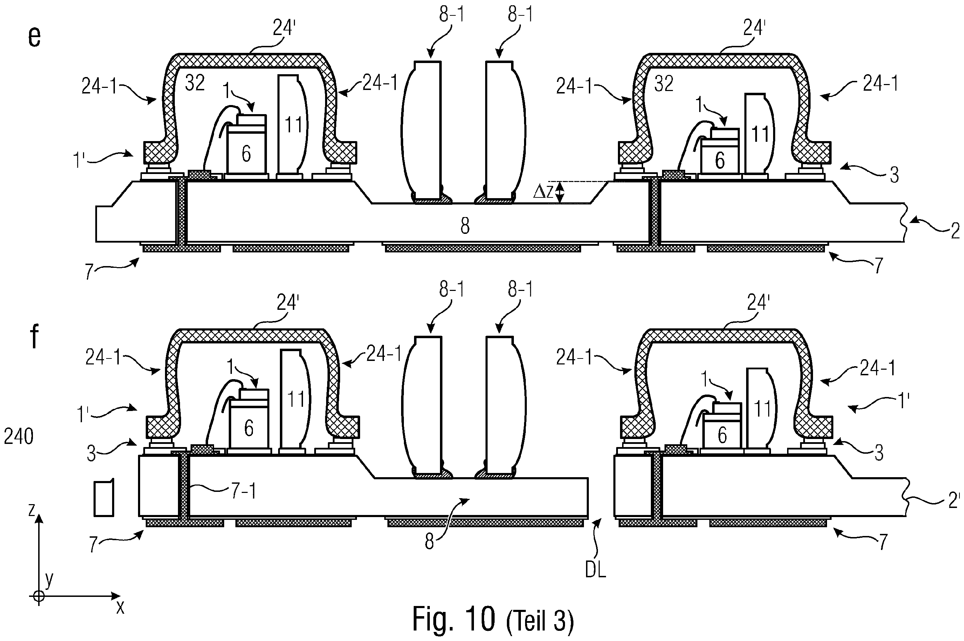

Fig. 10 zeigt nun ein weiteres beispielhaftes prinzipielles Ablaufdiagramm 200-3 des erfindungsgemäßen Verfahrens 200 zur Herstellung eines hermetisch gehäusten, optischen Bauelements 1' gemäß einem weiteren Ausführungsbeispiel. Insbesondere zeigt Fig. 10 eine Abfolge des Verkappungsprozesses 200-3 mit optisch neutralen Seitenfenstern 24-1 auf Waferebene bis hin zur Wafervereinzelung gemäß einem Ausführungsbeispiel, wobei die optisch neutralen Auskoppelfenster (Seitenfenster) 24-1 z.B. eine 90° (vertikale) Ausrichtung zur Trägersubstratebene (x-y-Ebene) aufweisen, und wobei das strahlungsemittierende Bauelement 1 beispielsweise eine Abstrahlrichtung bzw. Hauptabstrahlrichtung (bei einem divergierenden Strahl) im Wesentlichen parallel zur Trägersubstratebene (x-y-Ebene) aufweist.

Fig. 10 zeigt eine Abfolge eines Verkappungsprozesses mit konvexen Seitenfenstern auf Waferebene bis hin zur Wafer-Vereinzelung. Das Trägersubstrat 2 ist mit einer optischen Bank 8-1 ausgestattet. Linsen 11 sind innerhalb des hermetischen Gehäuses z.B. aufgelötet und zusätzliche optische Elemente 8-1 sind auf der offenen optischen Bank 8 z.B. durch Klebstoff montiert.

Bei dem Verfahren 200 mit dem Ablaufdiagramm 200-3 zur Herstellung eines hermetisch gehäusten, optischen Bauelements, z.B. eine optoelektronischen Sende- und/oder Empfangsbauelements, werden nun folgende Schritte durchgeführt. So wird zunächst das oben beschriebene Verfahren 100 mit den beispielhaften Prozessabläufen 100-1 ... 100-5 zur Herstellung eines geformten Abdeckungssubstrats (= strukturiertes Deckelsubstrat) 20' durchgeführt, wobei das geformte Abdeckungssubstrats 20' vereinzelt wird, um vereinzelte Deckelelemente 24` zu erhalten und diese für den nachfolgenden Bond-Schritt bereitzustellen. Somit kann das geformte Abdeckungssubstrat 20' jeweils ein vereinzeltes Deckelelement 24' aufweisen. Ferner wird bei Schritt 220 ein Bauelementsubstrat 2, z.B. als ein Bauelement-Wafer, mit einer Mehrzahl daran angeordneter optoelektronischer Bauelemente 1 bereitgestellt. Dabei kann jeweils einem optoelektronischen Bauelement 1 auf dem Bauelementsubstrat 2 (Bauelementwafer) ein vereinzeltes Deckelelement 24' zugeordnet sein. Bei dem Schritt des (hermetischen) Verbindens 230 werden also die vereinzelten Deckelelemente 24` des geformten Abdeckungssubstrats 20' mit dem Bauelementesubstrat 2, das eine Vielzahl von optoelektronischen Bauelementen 1 aufweist, verbunden, um die optolektronischen Bauelemente hermetisch zu häusen, und um somit eine Vielzahl von gehäusten, optischen Bauelementen 1' auf dem Bauelementsubstrat 2 erhalten.

Ferner wird ein Schritt des Vereinzelns 240 der Vielzahl von gehäusten, optischen Bauelementen 1' durchgeführt, um vereinzelte, hermetisch gehäuste optische Bauelemente 1' zu erhalten. Der Schritt des Vereinzelns 240 kann beispielsweise entlang der Vereinzelungslinie DL durch Sägen oder durch Lasertrennung erfolgen.

Bei dem Prozessablauf 200-3 von Fig. 10 erfolgt also eine Einzelverkappung der optoelektronischen Bauelemente 1 mit den vereinzelten Deckelelementen 24', wobei gegenüber dem Prozessablauf 200-4 von Fig. 9 eine Entfernung eines Mittelabschnitt 20'-1 des Deckelsubstrats 20' nicht erforderlich ist. Wie bei Fig. 10c beispielhaft dargestellt ist, werden die einzeln gehäusten, optoelektronischen Bauelemente 1' auf dem gemeinsamen Bauelementsubstrat 2 erhalten.

Wie in Fig. 10d-f beispielhaft dargestellt ist, kann der Schritt des Vereinzelns 240 der Vielzahl von gehäusten optoelektronischen Bauelementen 1' in unterschiedliche Teilprozessabläufe aufgeteilt werden. Gemäß einem Ausführungsbeispiel kann das gehäuste strahlungsemittierende Bauelement 1' nun derart ausgeführt sein, dass dem optischen Auskoppelfenster (optisches Seitenfenster) 24-1 seitens des Bauelementsubstrats 2 eine optische Bank 8 mit dem zusätzlichen optischen Element 8-1 vorgelagert ist, so dass das optische Auskoppelfenster 24-1 zwischen der optischen Bank 8 und dem strahlungsemittierenden Bauelement (optoelektronischen Bauelement) 1 angeordnet ist.

Die obige Beschreibung des Prozessablaufs 200-2 hinsichtlich der Figuren 8d-f ist mit den unterschiedlichen Alternativen ist gleichermaßen und entsprechend auch den Prozessablauf 200-3 in der Figuren 10d-f anwendbar.

Die Fig. 10a-f zeigt also eine Abfolge eines Verkappungsprozesses mit optisch neutralen Seitenfenstern 24-1 auf Waferebene bis hin zur Wafer-Vereinzelung. Das Trägersubstrat 2 ist mit einer optischen Bank 8 ausgestattet. Fügeprozesse mit hohen Temperaturanforderungen werden zuerst auf dem Trägersubstrat durchgeführt. Die Verkappung wird auf Waferebene durch einzelne Glaskappen ausgeführt. Der Standardablauf erfolgt von Fig. 10a-c, wobei eine Verzweigung der Prozessabfolge durch Substratvereinzelung in Fig. 10a-b-c-e-f (1. Alternative) oder Fig. 10a-b-c-d-f (2. Alternative). Hier verzweigt der Prozessfluss: Die Abfolge a-b-c-d-f zeigt die Optikmontage auf der optischen Bank 8 im Fall der vorgelagerten Wafervereinzelung, während die Abfolge a-b-c-e-f die Optikmontage auf der optischen Bank 8 im Fall der nachgelagerten Wafervereinzelung zeigt. Optional sind neben den Halbleiter-Emittern 1 auch Monitordioden 1-2zur Überwachung der Laserleistung, Linsen 11 oder andere optische Elemente innerhalb des hermetischen Gehäuses 24' (= 5) montiert, z.B. aufgelötet. Zusätzliche optische Elemente 8-1 sind auf der offenen optischen Bank durch Klebstoff montiert. Der Fall gilt auch, wenn die Kappen zwar einzeln aufgesetzt werden, aber alle gemeinsam in einem Fügeprozessschritt hermetisch mit dem Trägersubstrat gefügt werden.

Bei dem Verkappungsprozess von Fig. 10 können Deckelelemente 24' mit konvexen Seitenfenstern 24- verwendet werden. Gleichermaßen können auch Deckelelemente 24` mit konkaven oder planen Seitenfenstern 24-1 verwendet werden.

Fig. 10a-f zeigen eine verteilte Anordnung optischer Elemente, wobei ein Teil der optischen Funktionen innerhalb des hermetisch verschlossenen Gehäuses unter dem Glasdeckel aufgebaut ist. Hierzu werden beispielsweise organikfreie Verbindungstechniken auf Basis von Weichloten eingesetzt. Weitere notwendige optische Elemente sind auf der angeschlossenen optischen Bank aufgebaut.

Ausführungsbeispiele beschreiben somit ein Verfahren 200 zur hermetisch dichten Gehäusung von strahlungsemittierenden und strahlungsnachweisenden Bauelementen 1, also beispielsweise Laserdioden oder LEDs und PIN-Dioden, APD, SPAD, Silicon Photomultiplier, das mit WLP-IVA (wafer level packages - with integrated vertical optical apertures) bezeichnet werden kann. Günstig kann dabei insbesondere der optische Fensterbereich 24-1 sein, der eine zum Trägersubstrat 2' laterale bis vertikale Strahlaus- und Einkopplung erlaubt. Fensterbereiche mit einer reflektierenden Spiegelbeschichtung 65 sind im Sinne der vorliegenden Beschreibung zur Grundebene des Deckelsubstrats 20' geneigte, plane und gewölbte Flächen. Linsen 8, 11 im Sinnes der vorliegenden Beschreibung sind passiv abbildende Elemente z.B. uniaxiale Zylinder-Linsen, rotationssymmetrische Sammellinsen und Freiform-Linsen.

Die Montage der Laserdioden 1 und ggfs. weiterer optischer Elemente und Photodetektoren 1-2 kann beispielsweise auf einem Halbleiterwafer als Substrat, beispielsweise einem Siliziumwafer, erfolgen und der Verkappungsprozess kann für alle bis zu diesem Schritt montierten Bauelemente auf dem Substrat zusammen durch Aufbonden eines Deckelsubstrates mit Fensterbereichen zumeist mit einer gleichartigen Anordnung durchgeführt werden. Sofern zusätzliche optische Elemente 8-1 auf einer optischen Bank 8 montiert werden sollen geschieht dieser Schritt vorzugsweise nach dem Trennen des Deckelsubstrates, wodurch die Bereiche der optischen Bank für die Montage frei zugänglich werden. Aus Gründen der Anlagentechnik, der Ausbeuteanhebung und auch um den Wärmeeintrag gering zu halten kann eine Einzelverkappung durch das Aufsetzen und Versiegeln einzelner (vorvermessener) Glasdeckel realisiert werden. Die optische Bank 8 bleibt so exponiert und kann direkt mit weiteren optischen Elementen 8-1 bestückt werden. Erst danach erfolgt für beide Prozessvarianten das Trennen bzw. Vereinzeln des Trägersubstrats in einzelne Chips, genauer in einzelne Bauelemente.

Alternativ kann die Montage der Laserdioden auf einem Einzelstück eines bereits vereinzelten Halbleiterwafers, hier als Einzelsubstrat benannt, beispielsweise einem ausgesägten Chip aus einem Trägerwafer, erfolgen und der Verkappungsprozess kann für die montierten Bauelemente auf dem Einzelsubstrat durch Aufbonden eines bereits aus einem Deckelsubstrat vereinzelten Glasdeckels mit mindestens einem optischen Fenster erfolgen.

Gemäß einem Ausführungsbeispiel umfasst ein Hermetisch gehäustes, optisches Bauelement 1', das mit dem vorliegenden Herstellungsverfahren 100, 200 hergestellt wird, ein an dem Bauelementesubstrat 2' angeordnetes optisches Bauelement 1, und eines geformtes Abdeckungssubstrat 20', das eine hermetisch abgedichtete Abdeckung für das optische Bauelement 1 bereitstellt, innerhalb welcher das optische Bauelement 1 gehäust ist, wobei das geformte Abdeckungssubstrat 20' ein Deckelement 24' mit einem (seitlich planen, nach innen gewölbten oder nach außen gewölbten) Seitenwandbereich 24-1 zwischen einem Sockelbereich 24-3 und einem Deckenbereich 24-2 aufweist.

Gemäß einem Ausführungsbeispiel des hermetisch gehäusten, optischen Bauelements 1' weist der Seitenwandbereich 24-1 und/oder der Deckenbereich 24-2 des Deckelelements 24' des geformten Abdeckungssubstrats 20 ein für die Sende- oder Empfangsstrahlung des optischen Bauelements 1 durchlässigen Material auf, und ist zur Ein- und/oder Auskopplung elektromagnetischer Strahlung vorgesehen.

Gemäß einem Ausführungsbeispiel des hermetisch gehäusten, optischen Bauelements 1' weist die hermetisch abgedichtete Abdeckung 2`, 24` (mit der Kavität 32) eine reaktive Atmosphäre auf und/oder die Kavität 32 enthält ausschließlich anorganische Substanzen, **und/oder** wobei die hermetisch abgedichtete Abdeckung 2`, 24` (Kavität 32) gegenüber dem Eindringen von Wasserdampf hermetisch dicht ist.

Das gehäuste optoelektronische Bauelement 1' kann dementsprechend nach dem Verfahren 200 zur Herstellung eines gehäusten optoelektronischen Bauelements 1' auf Waferebene mit folgenden Schritten geschaffen werden: Herstellen eines Deckelsubstrats, Bereitstellen eines Bauelementesubstrats in Form eines Wafers mit einer Vielzahl von strahlungsemittierenden Bauelementen, Anordnen der Substrate aufeinander, sodass die Substrate entlang eines zwischengeschalteten Verbindungsrahmens verbunden werden, und Vereinzeln der gehäusten strahlungsemittierenden Bauelemente.

Entsprechend beschreiben Ausführungsbeispiele der vorliegenden Erfindung ein Verfahren und eine Verbindungstechnik für das hermetisch dichte Verpacken von strahlungsemittierenden und/oder strahlungsempfangenden Bauelementen 1, also beispielsweise Laserdioden oder LEDs, das mit WLP-IVA (wafer level packages - with integrated vertical optical apertures) bezeichnet werden kann. Vorteilhaft kann dabei insbesondere der optische (optisch neutrale) Fensterbereich 24-1 sein und z.B. auch eine zum Trägersubstrat 2` laterale Strahlauskopplung erlaubt. Der optische Fensterbereich 24-1 ist im Sinne der Erfindung durch einen geringen Einfluss auf die Strahlausbreitung ausgezeichnet, so das eine zusätzlich auf den Strahl aufgeprägte Divergenz beim Durchgang durch das Fenster 24-1 sich im Bereich kleiner +/- 0.5 ° oder kleiner +/- 1.0 ° bewegt.

Die Strahl-Aberration durch das Fenster 24-1 resultiert nicht nur in einer Verschiebung der Fokuslage als einzigen Fehler, wobei dieser resultierende Fehler aber momentan den größten Anteil zum Fehler beiträgt. Die weiteren auftretenden Fehler skalieren allerdings alle auch mit der Brechkraft des Fensters, so dass ein hinreichend dünnes Fenster (näherungsweise) fehlerfrei wird. Ein weiterer (wichtiger) Fakt ist aber, dass die Innen- und Außenflächen des Fensters 24-1 herstellungsbedingt immer identischer werden, wenn das Ausgangsmaterial für die Herstellung des Fensters 24-1 immer dünner wird.

Dazu kann das Abdeckungssubstrat 20 eine Dicke von 100µm bis 1500µm oder von 300µm bis 800µm aufweisen, um eine Dicke der Fensterelemente 24-1, d.h. der für den Lichtdurchtritt wirksamen Bereiche der Fensterelemente 24-1, von 20µm bis 1200µm oder von 20µm bis 300µm zu erhalten. Eine Fensterdicke von 20µm bis 300µm wird z.B. für optische Durchtrittsfenster 24-1 vorgesehen.

Unter Abbildungsfehlern oder Aberrationen werden Abweichungen von der idealen optischen Abbildung durch ein optisches System verstanden, die ein unscharfes oder verzerrtes Bild bewirken. Soweit Abbildungsfehler oder Aberrationen eine Wellenfrontdeformation von kleiner 100 nm oder kleiner 150 nm (RMS = root-mean-square = Standardabweichung) bewirken (als Summe aller Abbildungsfehler) bewirken, können diese als vernachlässigbar angesehen werden.

Die Montage der optoelektronischen Bauelement 1, z. B. Laserdioden, und ggfs. weiterer optischer Elemente kann beispielsweise auf einem Halbleiterwafer 2' als Substrat, beispielsweise einem Siliziumwafer, erfolgen und der Verkappungsprozess kann für alle montierten Bauelemente auf dem Substrat zusammen durch Aufbonden eines (gemeinsamen) Deckelsubstrates 20' mit Fensterbereichen 24-1 durchgeführt werden. Erst danach erfolgt das Trennen bzw. Vereinzeln in einzelne Chips, genauer in einzelne Gehäuse.

Gemäß einem Ausführungsbeispiel werden also eine Waferanordnung mit einer Vielzahl von gehäusten strahlungsemittierenden Bauelementen mit folgenden Merkmalen, ein Bauelementesubstrat in Form eines Wafers, der als gemeinsames Bauelementesubstrat für die daran angeordneten strahlungsemittierenden Bauelemente ausbildet ist, und ein gemeinsames Deckelsubstrat, das die Deckelsubstrate für die strahlungsemittierenden Bauelemente aufweist, bereitgestellt, wobei die Substrate so aneinander geordnet sind, dass das Deckelsubstrat und das Bauelementesubstrat entlang eines dazwischenliegenden Bondrahmens verbunden sind.

Alternativ kann die Montage der optoelektronischen Bauelement 1, z. B. Laserdioden, auf einem Einzelstück eines bereits vereinzelten Halbleiterwafers, hier als Einzelsubstrat benannt, beispielsweise einem ausgesägten Chip 2' aus einem Siliziumwafer, erfolgen und der Verkappungsprozess kann für die montierten Bauelemente auf dem Einzelsubstrat durch Aufbonden eines bereits aus einem Deckelsubstrat vereinzelten Glasdeckels mit optischem Fenster erfolgen.

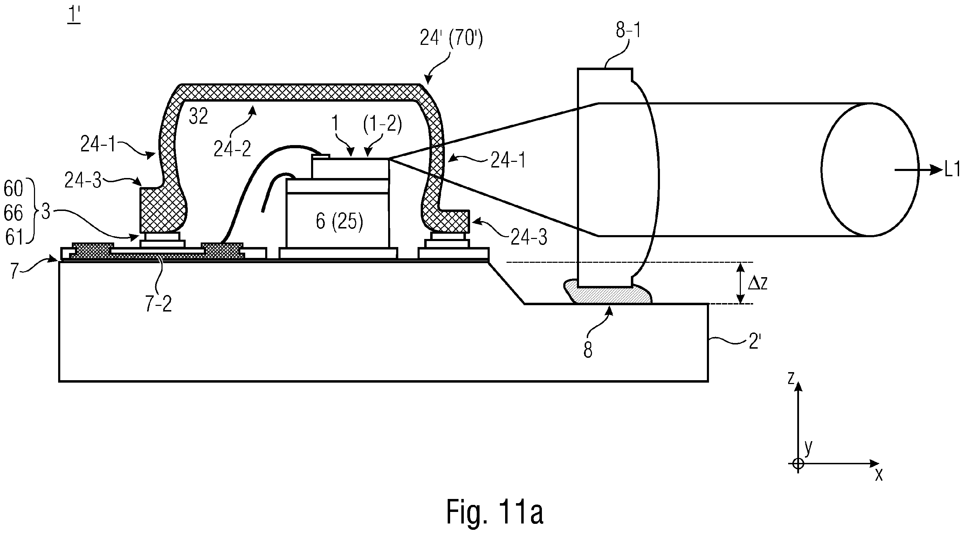

Fig. 11a-b zeigen nun eine weitere beispielhafte Ausführungsform für ein hermetisch gehäustes, optoelektronisches Bauelement 1' gemäß einem Ausführungsbeispiel, das beispielsweise mit dem oben beschriebenen Verfahren 200 hergestellt wird.

Wie in Fig. 11a-b beispielhaft dargestellt ist, weist das hermetisch gehäuste, optoelektronische Bauelement 1', das z.B. mit dem Herstellungsverfahren 200 hergestellt wird, ein an dem vereinzelten Bauelementesubstrat 2' angeordneten optischen Bauelement 1, und ferner ein geformtes Abdeckungssubstrat 20' bzw. vereinzeltes Deckelelement 24' auf, das eine hermetisch abgedichtete Abdeckung bzw. Häusung für das optische Bauelement 1 bereitstellt. Innerhalb der Häusung ist das optische Bauelement 1 untergebracht. Das geformte Abdeckungssubstrat 20' kann ein (gewölbtes) Deckelement 24' mit einem (vertikal planen, nach innen oder nach außen) gewölbten Seitenwandbereich 24-1 zwischen einem Deckenbereich 24-2 und einem Sockelbereich 24-3 aufweisen. In Fig. 11a-b ist ein nach außen gewölbter (konvexer) Seitenwandbereich 24-1 dargestellt.

Gemäß einem Ausführungsbeispiel weist der Seitenwandbereich 24-1 und/oder der Deckenbereich 24-2 des Deckelelements 24' des geformten Abdeckungssubstrats 20' ein für die Sende- oder Empfangsstrahlung des optoelektronischen Bauelements 1 durchlässigen Material auf und ist zur Ein- und/oder Auskopplung elektromagnetischer Strahlung (der Sende- oder Empfangsstrahlung) vorgesehen.

Gemäß einem Ausführungsbeispiel weist die hermetisch abgedichtete Abdeckung 24' mit der Kavität 32 eine reaktive Atmosphäre auf und/oder die Kavität 32 enthält ausschließlich anorganische Substanzen. Gemäß einem Ausführungsbeispiel ist die hermetisch abgedichtete Abdeckung 24' mit der Kavität 32 gegenüber dem Eindringen von Wasserdampf hermetisch dicht. Bei der in Fig. 11a-b gezeigten Ausführungsform wird ein hermetisch versiegelter Bereich mit Versiegelung z.B. auf einer Höhenebene erzeugt, wobei eine Variante mit optischer Bank 8 mit dem zusätzlichen optischen Element 8-1 auf Oberflächenniveau des Trägerwafers 2' beispielhaft dargestellt ist.

Fig. 11a-b zeigen eine Ausführungsform, bei der beispielhaft eine tiefergelegte optische Bank 8 auf dem vereinzelten Bauelementsubstrat 2' zur Montage passiver optischer Bauelemente 8, 26 angeordnet ist. Die Ebene der optischen Bank 8 mit dem zusätzlichen optischen Element 8-1 kann auf einer anderen Höhenebene liegen als die Montageebene für die Bauelemente 1, wie z.B. Laserdioden, bzw. dem Versiegelungsrahmen. Das Bauelementsubstrat kann im Bereich der Optiken 8 (optischen Bank) z.B. durch Ätzen um eine Absenkhöhe "Δz" abgesenkt sein. Auch eine erhöhte Montageebene kann im Trägerwafer 2` z.B. in Form einer Mesastruktur gebildet werden.

Innerhalb des Glasdeckels 24` werden beispielsweise keine Klebstoffe eingesetzt. Außerhalb werden Linsen, Prismen, Spiegel, Aperturen etc., z.B. als Teil der optischen Bank, vorzugsweise mit UV-Klebstoff assembliert. Es können auch mehrere optische Elemente 8-1 (Linsen, Prismen, Spiegel, Aperturen etc.) auf derselben optischen Bank 8 sein.

Diese Anordnung mit lateralen Vias 7-2 kann für eine oder mehrere Bauelemente 1, z.B. Laserdioden, genutzt werden und so angeordnet werden, dass sich achsenparallele Strahlen oder sich in einem Punkt kreuzende Strahlen L₁ ergeben. Zudem können die aktiven Bauelemente 1 auch über Flip-Chip-Technik elektrisch kontaktiert werden.

Die Anordnung wird durch Assemblierung, Verkappung und Vereinzelung auf Waferebene erhalten. Optische Bank auf gleichem Substrat zur Montage passiver optischer Bauelemente. Die Ebene der optischen Bank kann auf einer anderen Höhenebene liegen als die Montageebene für die Laserdioden bzw. dem Versiegelungsrahmen. Innerhalb des Glasdeckels werden keine Klebstoffe eingesetzt. Außerhalb werden Linsen, Prismen, Spiegel, Aperturen etc. vorzugsweise/beispielsweise mit UV-Klebstoff assembliert. Selbstverständlich können das mehrere optische Elemente auf derselben optischen Bank sein. Diese Anordnung kann für eine oder mehrere Laserdioden genutzt werden, so angeordnet, dass sich achsenparallele Strahlen oder sich in einem Punkt kreuzende Strahlen ergeben.

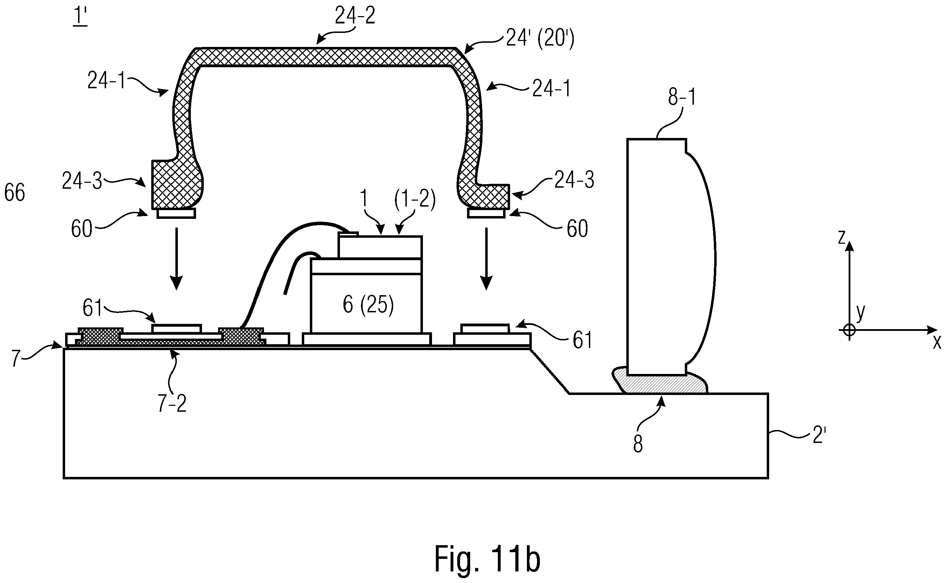

Fig. 11b zeig beispielsweise eine Ausführungsform, bei der ein hermetisch gehäustes, optoelektronisches Bauelement 1' aus vereinzelten Trägersubstraten 2' und vereinzelten Glaskappen 24' auf Einzelsubstratebene erzeugt wird.

Fig. 11a-b zeigen also eine Ausführungsform, bei der das Bauelementesubstrat 2', z.B. ein Siliziumträgerchip, im Bereich der Optiken 8-1 durch Ätzen abgesenkt wurde, um dadurch mehr vertikalen Bauraum für die Optiken 8-1 zu schaffen. Dabei sind die Optiken 8-1 beispielsweise mittels Klebeverbindungen auf der optischen Bank 8 angeordnet.

Fig. 11a-b zeigen eine ferner Ausführungsform, bei der auch weitere elektronische Komponenten in das Lasergehäuse, also in die Kavität 32, integriert sein können, was für manche Applikationen vorteilhaft ist. Konkret können dies beispielsweise (zumindest) eine zusätzliche Photodiode 1-2 zur Überwachung der Leistung des strahlungsemittierenden Bauelements 1, beispielsweise eines Lasers, oder Treiberschaltungen 25 für die strahlungsemittierenden Bauelemente 1 sein. In Fig. 11a-b sind in der Kavität ein Treiber-IC 25 und eine solche Monitor Photodiode 1-2 gezeigt. Fig. 11a-b zeigen also eine Ausführungsform, bei der in der Kavität 32 eine elektronische Treiberschaltung 25 angeordnet ist.

Bei der nachfolgenden Beschreibung weiterer Ausführungsbeispiele des hermetisch gehäusten, optoelektronischen Bauelement 1' werden im Wesentlichen die jeweiligen Unterschiede (= alternative und/oder zusätzliche Elemente) gegenüber der Anordnung von Fig. 11a-b dargestellt und die daraus resultierenden technischen Effekte beschrieben. Daher kann die obige Beschreibung der Fig. 11a-b entsprechend auch auf die nachfolgende Beschreibung der weiteren Ausführungsbeispiele angewendet werden.

Im Folgenden werden nun weitere beispielhafte Ausführungsformen für ein hermetisch gehäustes, optoelektronisches Bauelement 1', das beispielsweise mit einem oben beschriebenen Verfahren 200 hergestellt wird, beschrieben.

Bei der nachfolgenden Beschreibung der Ausführungsbeispiele des hermetisch gehäusten, optoelektronischen Bauelement werden im Wesentlichen Unterschiede (= alternative und/oder zusätzliche Elemente) gegenüber den weiteren Anordnungen dargestellt und die daraus resultierenden technischen Effekte beschrieben. Daher kann die Beschreibung eines Ausführungsbeispiels des hermetisch gehäustes, optoelektronisches Bauelements entsprechend auch auf die Beschreibung der weiteren Ausführungsbeispiele angewendet werden.

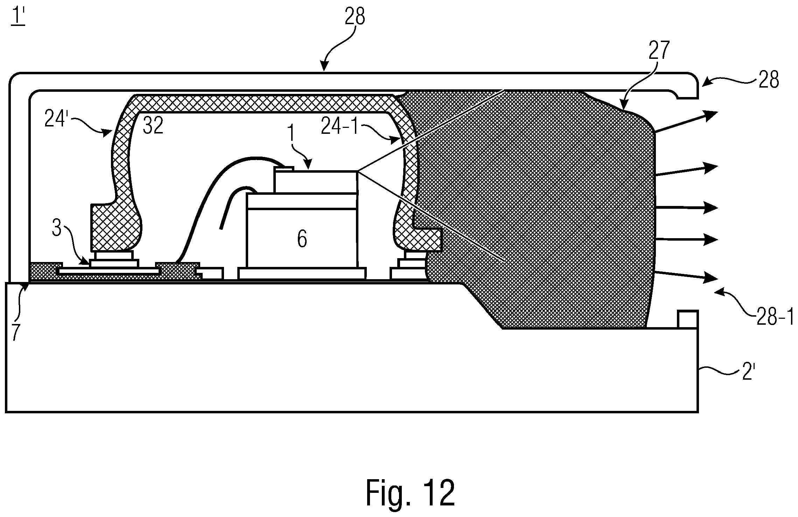

Fig. 12 zeigt eine Ausführungsform, bei der beispielhaft eine seitliche Strahlauskopplung des optoelektronischen Bauelements 1, z.B. einer Laserdiode, in einen Phosphorkonverter 27 erfolgt, um eine andere Lichtfarbe zu erzeugen und die Laserkohärenz aufzulösen. Sofern die Laser 1 so aufgebaut sind, dass sie nach oben strahlen wäre der Phosphorkonverter als nach oben abdeckende Schicht aufgebracht und das Außengehäuse 24' entsprechend mit einer oberen Fensteröffnung 24-2 ausgestattet.

Fig. 12 zeigt also eine Ausführungsform mit einem Lichtumwandlungselement (Konversionsmedium) 27, das bei der Verwendung einer kurzwelligen Laserdiode als strahlungsemittierendes (optoelektronisches) Bauelement 1 in der Kavität 32, die von dem Deckelsubstrat 24` und dem Bauelementesubstrat 2` gebildet ist, angebracht sein kann. Das Konversionsmedium 27 kann z.B. außerhalb des hermetisch dichten Lasergehäuses 2`, 24` als ein zusätzliches Epoxydharz, das entsprechende Phosphore beinhaltet, aufgebracht sein. Das gehäuste strahlungsemittierende Bauelement 1' nach Fig. 12 ist somit derart ausgeführt, dass es ein für eine Lichtfarbenumwandlung des emittierten Lichts L1 wirksames Element 27 aufweist, so dass das optische Auskoppelfenster 24-1 zwischen dem wirksamen Element 27 und dem strahlungsemittierende Bauelement 1 angeordnet ist.

Wie in Fig. 12 ferner beispielhaft dargestellt ist, kann eine Außenkappe bzw. ein Gehäuse 28 für das hermetisch gehäustes, optoelektronisches Bauelement 1' vorgesehen sein, wobei das Gehäuse 28 an dem Substrat 2' angeordnet ist und das hermetisch gehäuste, optoelektronische Bauelement 1' und bis auf ein optisches Austrittsfenster 28-1 das Lichtumwandlungselement 27 umgibt. Die Außenkappe 28 ist beispielsweise vorgesehen, um einen weiteren Schutz und/oder auch hermetische Abschirmung der gesamten hermetisch gehäusten, optoelektronischen Bauelements 1' gegenüber der Umgebung vorzusehen.

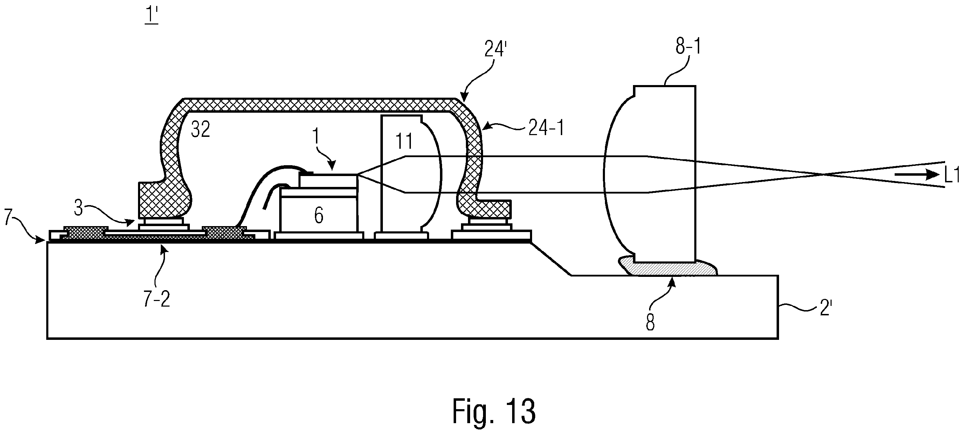

Fig. 13 zeigt nun eine weitere beispielhafte Ausführungsform für ein hermetisch gehäustes, optoelektronisches Bauelement 1' gemäß einem Ausführungsbeispiel, wobei die Anordnung 1' eine erste Linse 11 innerhalb des hermetisch verkappten Bereichs 32 aufweist.

Diese Linse 11 wird beispielsweise gelötet, um organische Ausgasungen in der Nähe des optoelektronischen Bauelements 1, z.B. einer Laserdiode, zu vermeiden. Das Trägersubstrat 2' weist hermetische laterale Durchführungen 7-2 auf, die beispielsweise sowohl für die Laserkontaktierung durch Drahtbonds aber auch durch Flip-Chip-Verbindungstechniken genutzt werden können.

Das gehäuste strahlungsemittierende Bauelement 1' ist also, wie in den Fig. 13 dargestellt ist, derart ausgeführt, dass dem optischen Auskoppelfenster 24-1 seitens des Bauelementesubstrats 2' eine optische Bank 8 vorgelagert ist, so dass das optische Auskoppelfenster 24-1 zwischen optischen Bank 8 und dem strahlungsemittierendem Bauelement 1 angeordnet ist. In den gezeigten Ausführungsformen ist das gehäuste strahlungsemittierende Bauelement 1' derart ausgeführt, dass die optische Bank 8 auf dem Bauelementesubstrat 2' angeordnet ist und sich in der Abstrahlrichtung des strahlungsemittierenden Bauelements 1 befindet.

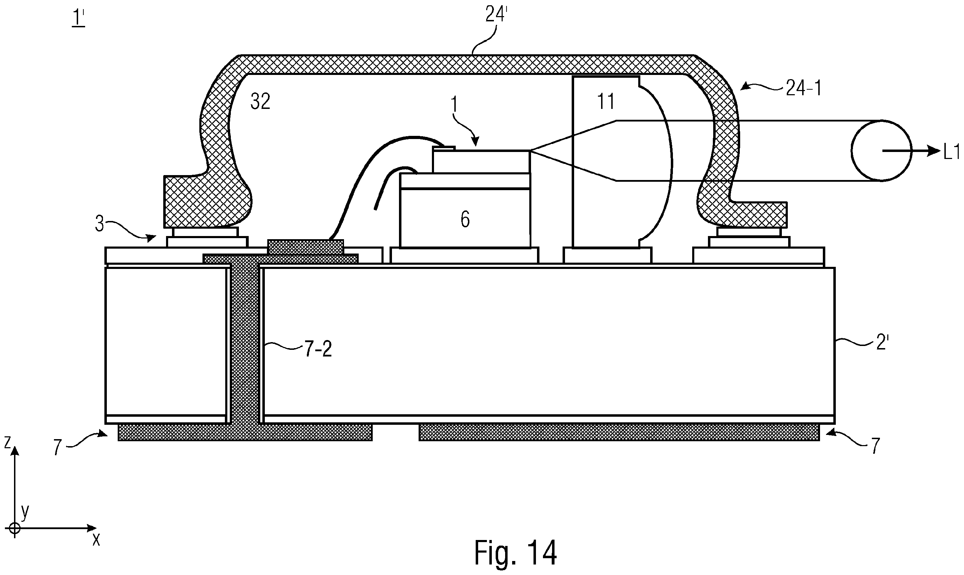

Fig. 14 zeigt nun eine weitere beispielhafte Ausführungsform für ein hermetisch gehäustes, optoelektronisches Bauelement 1' gemäß einem Ausführungsbeispiel, wobei das gehäuste strahlungsemittierende Bauelement 1' derart ausgeführt, dass eine Leiterbahn 7 zum elektrischen Anbinden des strahlungsemittierenden Bauelements 1 seitens des Bauelementesubstrats 2 angeordnet ist und die Leiterbahn 7 durch das Bauelementesubstrat 2 aus der Kavität 30 nach unten herausgeführt ist. Dazu kann beispielsweise eine TSV-und/oder TGV-Anordnung 7-1 (Through silicon vias (TSV) oder Through Glass Via (TGV)) eingesetzt werden. Diese Anordnung kann sowohl für die Laserkontaktierung durch Drahtbands aber auch durch Flip-Chip-Verbindungstechniken genutzt werden.

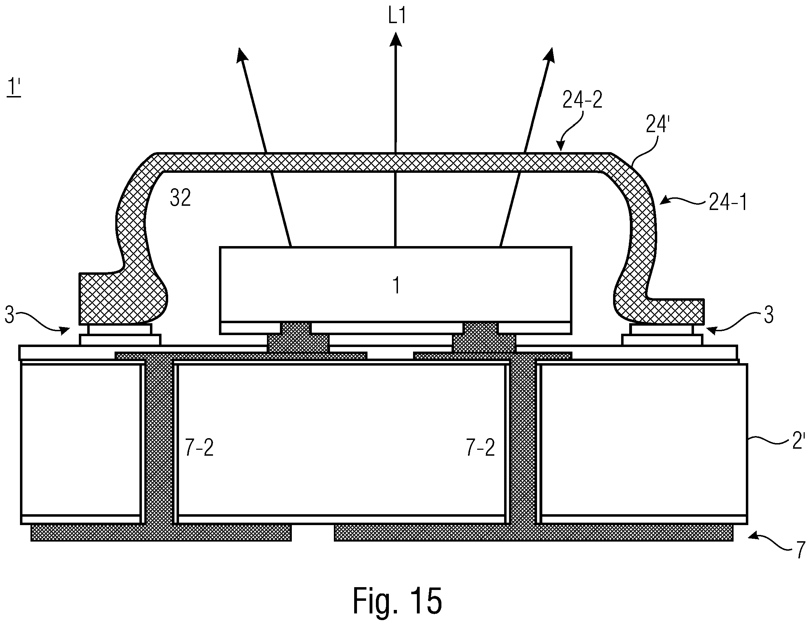

Fig. 15 zeigt nun eine weitere beispielhafte Ausführungsform für ein hermetisch gehäustes, optoelektronisches Bauelement 1' gemäß einem Ausführungsbeispiel, wobei die obere Seitenwand 24-2 des Deckelelements 24' ein für die Sende- oder Empfangsstrahlung des optischen Bauelements 1 durchlässigen Material aufweist und zur Ein- und/oder Auskopplung elektromagnetischer Strahlung L1 vorgesehen ist.

Es ist also das obere Fensterfläche 24-2 (Deckenfenster) zur Ein- und/oder Auskopplung vorgesehen, wobei das strahlungsemittierende Bauelement 1 beispielsweise eine Abstrahlrichtung bzw. Hauptabstrahlrichtung (bei einem divergierenden Strahl) mit dem ausgekoppelten Lichtstrahl L₁ im Wesentlichen senkrecht zur Trägersubstratebene (x-y-Ebene) aufweist. Bei der Anordnung von Fig. 15 ermöglichen die Glaskappen 24' (unabhängig von der Geometrie der Seitenfenster 24-1) auch die optische Auskopplung bzw. Einkopplung nach oben bzw. vom Trägersubstrat 2` (z.B. vertikal) weg zeigend.

Fig. 15 zeigt also eine Vorrichtung 1' auf Basis eines Trägersubstrates mit hermetischen, elektrischen Durchführungen 7-2 durch das Substrat 2` (Through Silicon Vias TSV). Die Kontaktflächen 7 auf der Unterseite des Trägersubstrates 2` ermöglichen eine Weiterverarbeitung als SMD Bauteil. Es können parallel mehrere Laserdioden 1 benachbart unterhalb einer Glaskappe aufgebaut sein. Die Glaskappen 24` ermöglichen (unabhängig von der Seitenfenster-Geometrie) auch die optische Auskopplung bzw. Einkopplung nach oben bzw. vom Trägersubstrat 2` weg zeigend.

Gemäß Fig. 14 und 15 wird eine Ausführungsform mit einer vorteilhaften Ausgestaltung der elektrischen Kontaktierung 7, 7-2 gezeigt. Für einen besonders kompakten Aufbau des Laserdiodengehäuses 2`, 24', also des gehäusten, optoelektronischen Bauelements 1', können die elektrischen Anschlüsse in Form vertikaler Durchführungen 7-2 durch das Bauelementesubstrat 2' zu führen. Auf der Rückseite können die notwendigen Anschlusspads 7, wie in der Fig. 14 und 15 gezeigt, mit einer lötfähigen Metallisierung versehen werden. Wenn diese Anschlussbereiche 7 besonders flächenintensiv ausgeführt werden, so eignen diese Areale sich auch dazu, die Entwärmung (Wärmeabfuhr) des Gehäuses sicherzustellen. Ansonsten sind in dem Ausführungsbeispiel nach Fig. 14 und 15 das Deckelsubstrat 20', also der Glasdeckel 24', und das Bauelementesubstrat 2', in diesem Fall z.B. ein Siliziumchip, wieder mittels eines Bondrahmens 3 miteinander verbunden, so dass eine hermetische Kavität 3 für das optoelektronische Bauelement 1, in diesem Fall z.B. eine Laserdiode, bereitgestellt ist. Die optischen Flächen z.B. sind wieder mit einer Entspiegelung 64 versehen (ARC=Anti Reflex Coating).

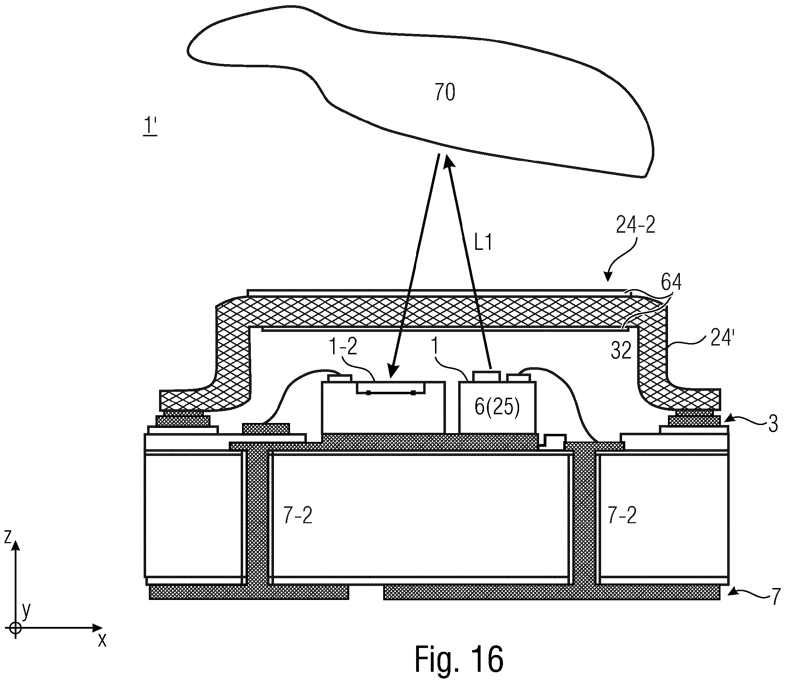

Fig. 16 zeigt nun eine weitere beispielhafte Ausführungsform für ein hermetisch gehäustes, optoelektronisches Bauelement 1' gemäß einem Ausführungsbeispiel, das beispielsweise mit einem oben beschriebenen Verfahren 200 hergestellt wird. Gemäß einem Ausführungsbeispiel des hermetisch gehäustes, optoelektronisches Bauelements 1' kann das Abdeckungssubstrat 20' optional so ausgebildet werden, dass die obere Seitenwand 24-2 des Deckelelements 24' ein für die Sende- oder Empfangsstrahlung des optischen Bauelements 1 durchlässigen Material aufweist und zur Ein- und/oder Auskopplung elektromagnetischer Strahlung L1 vorgesehen ist.

Das gehäuste optoelektronische Bauelement 1' weist beispielsweise ein strahlungsemittierendes Halbleiterbauelement 1, wie z.B. ein optoelektronisches Sendebauelement, und ein strahlungsempfindliches Halbleiterbauelement 1-2, wie z.B. ein optoelektronisches Empfangsbauelement bzw. eine Photodiode, auf. Das strahlungsemittierende Bauelement 1A weist beispielsweise eine Abstrahlrichtung bzw. Hauptabstrahlrichtung (bei einem divergierenden Strahl) mit dem ausgekoppelten Lichtstrahl L₁ von der Trägersubstratebene (x-y-Ebene) weg-zeigend auf.

Fig. 16 zeigt also eine Ausführungsform, bei der weitere elektronische Komponenten in das Gehäuse 24' für den Laser 1, also in die Kavität 32, integriert sind. Dies ist für Applikationen geeignet, wenn beispielsweise eine oder mehrere zusätzliche Photodioden 1-2 zur Überwachung der Leistung des strahlungsemittierenden Bauelements 1, beispielsweise des Lasers 1, oder der Treiberschaltungen für die strahlungsemittierenden Bauelemente 1 vorgesehen werden soll. Dabei kann von dem Empfangselement 1-2 die von dem Objekt 70 reflektierte Strahlung erfasst werden. Die optischen Flächen des Fensterelements 24-2 z.B. sind wieder mit einer Entspiegelung 64 versehen (ARC=Anti Reflex Coating).

In der Fig. 16 sind also in der Kavität 32 der Treiber-IC 25 mit dem Sendelement 1 und die Monitor-Photodiode 1-2 gezeigt. Bei der in Fig. 16 gezeigten Ausführungsform in der Kavität 32 des Deckelements 24' ist die elektronische Treiberschaltung 25 als Teil des Sendeelements 1 angeordnet.

Fig. 16 zeigt also eine "Top looking" Anordnung 1', z.B. für einen Näherungssensor mit Ausstrahlung und Empfang reflektierter Strahlung L1 an einem Objekt 70 durch die obere Glasfläche 24-2 (ggfs. mit Vergütungsschichten 64). Die Seitenwände 24-1 der Kappe 24 sind hier Teil des Gehäuses aber nicht in einer optischen Funktion eingesetzt. Das Bauteil 1' kann nach einem der vorgestellten Verkappungsverfahren hergestellt worden sein.

Die Fig. 11 -16 zeigen Ausführungsformen, bei denen auch mehrere optoelektronische (z.B. strahlungsemittierende) Bauelemente im selben Gehäuse gebildet werden können. Dies ist ein Beispiel einer Ausführung für die Montage mehrerer Laserdioden in einem Gehäuse, z.B. einer RGB-Laserquelle. Über Zwischenträger sind die z.B. drei strahlungsemittierende Bauelemente 1 jeweils mit dem Bauelementesubstrat 2' mechanisch verbunden. So wird eine günstige Wärmeableitung erreicht. Die strahlungsemittierenden Bauelemente 1 sind jeweils mittels Leiterbahnen 7 und lateraler Durchführungen 7-2, die durch einen hermetisch dichten Bondrahmen hindurch aus der Kavität 30 herausgeführt sind, elektrisch angebunden. Günstig kann es sein, die jeweiligen optischen Komponenten für die Strahlaufbereitung außerhalb des hermetisch dichten Gehäuses 5 und dem optischen Fenster, also den optischen Flächen, vorgelagert zu platzieren. Diese optische Komponenten können beispielsweise Zylinderlinsen oder andere Arten von Linsen sein. Dann können diese optischen Komponenten auch Substanzen umfassen, die in der hermetisch abgedichteten Kavität unerwünscht sind, wie beispielsweise organische Substanzen.

Obwohl einige Aspekte der vorliegenden Offenbarung als Merkmale im Zusammenhang einer Vorrichtung beschrieben wurden, ist es klar, dass eine solche Beschreibung ebenfalls als eine Beschreibung entsprechender Verfahrensmerkmale betrachtet werden kann. Obwohl einige Aspekte als Merkmale im Zusammenhang mit einem Verfahren beschrieben wurden, ist klar, dass eine solche Beschreibung auch als eine Beschreibung entsprechender Merkmale einer Vorrichtung bzw. der Funktionalität einer Vorrichtung betrachtet werden können. Einige oder alle der Verfahrensschritte können durch einen Hardware-Apparat (oder unter Verwendung eines Hardware-Apparats), wie zum Beispiel einen Mikroprozessor, einen programmierbaren Computer oder einer elektronischen Schaltung durchgeführt werden. Bei einigen Ausführungsbeispielen können einige oder mehrere der Verfahrensschritte durch einen solchen Apparat ausgeführt werden. Je nach bestimmten Implementierungsanforderungen können Ausführungsbeispiele der Erfindung in Hardware oder in Software oder zumindest teilweise in Hardware oder zumindest teilweise in Software implementiert sein.

In der vorhergehenden detaillierten Beschreibung wurden teilweise verschiedene Merkmale in Beispielen zusammen gruppiert, um die Offenbarung zu rationalisieren. Diese Art der Offenbarung soll nicht als die Absicht interpretiert werden, dass die beanspruchten Beispiele mehr Merkmale aufweisen als ausdrücklich in jedem Anspruch angegeben sind.

Obwohl spezifische Ausführungsbeispiele hierin dargestellt und beschrieben wurden, wird einem Fachmann offensichtlich sein, dass eine Vielzahl von alternativen und/oder äquivalenten Implementierungen für die spezifischen dort gezeigten und dargestellten Ausführungsbeispiele ersetzt werden können, ohne von dem Gegenstand der vorliegenden Anmeldung abzuweichen. Dieser Anmeldungstext soll alle Adaptionen und Variationen der hierin beschriebenen und erörterten spezifischen Ausführungsbeispiele abdecken. Daher ist der vorliegende Anmeldungsgegenstand lediglich durch den Wortlaut der Ansprüche begrenzt.

## Patentansprüche

1. Verfahren (100) mit folgenden Schritten:
- Bereitstellen (120) eines Formsubstrats und eines Abdeckungssubstrats, die miteinander verbunden sind, wobei ein Oberflächenbereich des Formsubstrats und/oder des Abdeckungssubstrats strukturiert ist, um eine abgeschlossene Kavität zwischen dem Abdeckungssubstrat und dem Formsubstrat zu bilden,
- Tempern (130) des Abdeckungssubstrats und des Formsubstrats, um die Viskosität des Glasmaterials des Abdeckungssubstrats zu verringern, und Bereitstellen (140) eines Überdrucks in der abgeschlossenen Kavität gegenüber der umgebenden Atmosphäre, um basierend auf der verringerten Viskosität des Glasmaterials des Abdeckungssubstrats und dem Überdruck in der abgeschlossenen Kavität gegenüber der umgebenden Atmosphäre ein Auswölben des Glasmaterials des Abdeckungssubstrats ausgehend von der abgeschlossenen Kavität bis zu einer von dem Abdeckungssubstrat beabstandeten Anschlagfläche eines Anschlagelements zu bewirken, um ein geformtes Abdeckungssubstrat mit einem Deckelelement zu erhalten; und
- Entfernen des Anschlagelements und des Formsubstrats von dem geformten Abdeckungssubstrat.

2. Verfahren nach Anspruch 1 zur Herstellung eines Deckelsubstrats zum Häusen eines oder einer Mehrzahl von optischen Bauelementen, wobei das geformte Abdeckungssubstrat das Deckelsubstrat mit dem einem Deckelelement bildet.

3. Verfahren nach Anspruch 1 oder 2, wobei das Abdeckungssubstrat ein einziges homogenes Material aufweist, um das geformte Abdeckungssubstrat aus diesem einzigen homogenen Material zu bilden.

4. Verfahren nach einem der vorhergehenden Ansprüche, wobei der Schritt des Bereitstellens eines Formsubstrats und eines Abdeckungssubstrats folgende Schritte aufweist:
Bereitstellen eines Formsubstrats mit einem strukturierten Oberflächenbereich;
- Anordnen eines Abdeckungssubstrats auf dem strukturierten Oberflächenbereich des Formsubstrats, wobei das Abdeckungssubstrat ein Glasmaterial aufweist, und
- Verbinden des Abdeckungssubstrats mit dem Formsubstrat, um die abgeschlossene Kavität zwischen dem Abdeckungssubstrat und dem Formsubstrat zu bilden.
oder
wobei der Schritt des Bereitstellens eines Formsubstrats und eines Abdeckungssubstrats folgende Schritte aufweist:
Bereitstellen eines Formsubstrats;
- Anordnen eines Abdeckungssubstrats mit einem strukturierten Oberflächenbereich auf dem Formsubstrat, wobei das Abdeckungssubstrat ein Glasmaterial aufweist,
und
- Verbinden des Abdeckungssubstrats mit dem Formsubstrat, um die abgeschlossene Kavität zwischen dem Abdeckungssubstrat und dem Formsubstrat zu bilden.

5. Verfahren nach einem der vorhergehenden Ansprüche, wobei das Verbinden des Abdeckungssubstrats mit dem Formsubstrat in einer Atmosphäre mit einem definierten atmosphärischen Umgebungsdruck durchgeführt wird, um einen definierten atmosphärischen Druck in den abgeschlossenen Kavitäten einzuschließen.

6. Verfahren nach einem der vorhergehenden Ansprüche, wobei der Schritt des Temperns und des Bereitstellens eines Überdrucks als ein Glasfließprozess in einem Unterdruckofen durchgeführt wird, um in der abgeschlossenen Kavität einen definierten atmosphärischen Überdruck gegenüber der umgebenden Atmosphäre zu erhalten.

7. Verfahren nach einem der vorhergehenden Ansprüche, wobei das Abdeckungssubstrat bei dem Schritt des Temperns und des Bereitstellens eines Überdrucks im Bereich der abgeschlossenen Kavität bis zu einer Höhe, die durch den Abstand der Anschlagfläche zu dem Abdeckungssubstrat vorgegeben ist, ausgewölbt wird.

8. Verfahren nach einem der vorhergehenden Ansprüche, wobei bei dem Abkühlen des geformten Abdeckungssubstrats in einem Temperaturbereich über 650°C ein atmosphärischer Überdruck in den abgeschlossenen Kavitäten gegenüber der umgebenden Atmosphäre bewirkt wird, um eine Wölbung der Seitenwandbereiche des Deckelelements des geformten Abdeckungssubstrats nach außen zu erzeugen.

9. Verfahren nach einem der Ansprüche 1 bis 7, wobei bei dem Abkühlen des geformten Abdeckungssubstrats in einem Temperaturbereich über 650°C ein atmosphärischer Unterdruck in den abgeschlossenen Kavitäten gegenüber der umgebenden Atmosphäre bewirkt wird, um eine Wölbung der Seitenwandbereiche des Deckelelements des geformten Abdeckungssubstrats nach innen zu erzeugen.

10. Verfahren gemäß einem der vorhergehenden Ansprüche, wobei bei dem Schritt des Temperns (130) und des Bereitstellens eines Überdrucks (140) entweder die Seitenfenster (24-1) und der Deckelbereich (24-2) oder die Seitenfenster (24-1) und die Sockelbereiche (24-3) mit dem Glasmaterial des Abdeckungssubstrats (20) ausgehend von der abgeschlossenen Kavität (30) bis zu der beabstandeten Anschlagsfläche (40-1) des Anschlagselements (40) ausgewölbt werden.

11. Verfahren (200) zur Herstellung eines hermetisch gehäusten, optischen Bauelements, mit folgenden Schritten:
Durchführen des Verfahrens (100) zur Herstellung eines geformten Abdeckungssubstrats gemäß einem der vorhergehenden Ansprüche,
Bereitstellen (220) eines Bauelementesubstrats mit einem daran angeordneten, optischen Bauelement, und
Verbinden (230) des geformten Abdeckungssubstrats mit dem Bauelementesubstrat, um das optische Bauelement zu häusen.

12. Verfahren nach Anspruch 11, ferner mit folgendem Schritt:
Durchführen des Verfahrens zur Herstellung von gehäusten, optischen Bauelementen auf Waferebene, wobei eine Vielzahl von optischen Bauelementen an dem Bauelementesubstrat angeordnet sind, und wobei das geformte Abdeckungssubstrat eine Vielzahl von Deckelelementen aufweist.

13. Hermetisch gehäustes, optisches Bauelement, das mit dem Herstellungsverfahren gemäß den Ansprüchen 11 oder 12 hergestellt wird, mit folgenden Merkmalen:
einem an dem Bauelementesubstrat angeordneten optischen Bauelement; und
einem geformten einstückigen Abdeckungssubstrat, das eine hermetisch abgedichtete Abdeckung für das optische Bauelement bereitstellt, innerhalb welcher das optische Bauelement gehäust ist, wobei das geformte Abdeckungssubstrat ein Deckelement mit einem gewölbten Seitenwandbereich zwischen einem Sockelbereich und einem Deckenbereich aufweist.

14. Hermetisch gehäustes, optisches Bauelement gemäß Anspruch 13, wobei der Seitenwandbereich und/oder der Deckenbereich des einstückigen Deckelelements des geformten Abdeckungssubstrats ein für die Sende- oder Empfangsstrahlung des optischen Bauelements durchlässigen Material aufweist, und zur Ein- und/oder Auskopplung elektromagnetischer Strahlung vorgesehen ist.

15. Gehäustes strahlungsemittierendes Bauelement nach Anspruch 13 oder 14,
wobei die hermetisch abgedichtete Abdeckung eine reaktive Atmosphäre aufweist und/oder die Kavität ausschließlich anorganische Substanzen enthält,
und/oder
wobei die hermetisch abgedichtete Abdeckung gegenüber dem Eindringen von Wasserdampf hermetisch dicht ist.

## Claims

1. A method (100), comprising:
- providing (120) a mold substrate and a cover substrate that are connected to each other, wherein a surface region of the mold substrate and/or of the cover substrate is structured so as to form an enclosed cavity between the cover substrate and the mold substrate,
- tempering (130) the cover substrate and the mold substrate so as to decrease the viscosity of the glass material of the cover substrate, and providing (140) an overpressure in the enclosed cavity compared to the surrounding atmosphere so as to cause, on the basis of the decreased viscosity of the glass material of the cover substrate and the overpressure in the enclosed cavity compared to the surrounding atmosphere, bulging of the glass material of the cover substrate starting from the enclosed cavity up to a stop area, spaced apart from the cover substrate, of a stop element so as to obtain a molded cover substrate with a cap element; and
- removing the stop element and the mold substrate from the molded cover substrate.

2. The method according to claim 1 for manufacturing a cap substrate for housing one or a plurality of optical devices, wherein the molded cover substrate forms the cap substrate with the one cap element.

3. The method according to claim 1 or 2, wherein the cover substrate comprises a single homogenous material so as to form the molded cover substrate from this single homogenous material.

4. The method according to any of the preceding claims, wherein the step of providing a mold substrate and a cover substrate comprises:
- providing a mold substrate with a structured surface region
- arranging a cover substrate on the structured surface region of the mold substrate, wherein the cover substrate comprises a glass material, and
- connecting the cover substrate to the mold substrate so as to form the enclosed cavity between the cover substrate and the mold substrate,
or wherein the step of providing a mold substrate and a cover substrate comprises:
- providing a mold substrate;
- arranging a cover substrate with a structured surface region on the mold substrate, wherein the cover substrate comprises a glass material, and
- connecting the cover substrate to the mold substrate so as to form the enclosed cavity between the cover substrate and the mold substrate.

5. The method according to any of the preceding claims, wherein connecting the cover substrate to the mold substrate is carried out in an atmosphere with a defined atmospheric ambient pressure so as to enclose a defined atmospheric pressure in the enclosed cavities.

6. The method according to any of the preceding claims, wherein the step of tempering and providing an overpressure is performed as glass flow process in a negativepressure oven to obtain in the enclosed cavity a defined atmospheric overpressure compared to the surrounding atmosphere.

7. The method according to any of the preceding claims, wherein, in the step of tempering and providing an overpressure, the cover substrate is bulged-out in the region of the enclosed cavity up to a height specified by the distance of the stop area to the cover substrate.

8. The method according to any of the preceding claims, wherein, in cooling the molded cover substrate in the temperature range of above 650°C, an atmospheric overpressure is caused in the enclosed cavities compared to the surrounding atmosphere so as to generate a bulging of the sidewall regions of the cap element of the molded cover substrate towards the outside.

9. The method according to any of claims 1 to 7, wherein, in cooling the molded cover substrate in a temperature range above 650°C, an atmospheric negative pressure in the enclosed cavities compared to the surrounding atmosphere is caused so as to generate a bulging of the side wall regions of the cap element of the molded cover substrate towards the inside.

10. The method according to any of the preceding claims, wherein, in the step of tempering (130) and providing an overpressure (140), the side windows (24-1) and the cap region (24-2) or the side windows (24-1) and the socket regions (24-3) are bulged-out with the glass material of the cover substrate (20) starting from the enclosed cavity (30) up to the spaced-apart stop area (40-1) of the stop element 40.

11. A method (200) for manufacturing a hermetically housed optical device, comprising:
performing the method (100) for manufacturing a molded cover substrate according to any of the preceding claims,
providing (220) a device substrate with an optical device arranged thereon, and
connecting (230) the molded cover substrate with the device substrate so as to house the optical device.

12. The method according to claim 11, further comprising:
performing the method for manufacturing housed optical devices on the wafer level, wherein a plurality of optical devices are arranged on the device substrate, and wherein the molded cover substrate comprises a plurality of cap elements.

13. A hermetically housed optical device manufactured with the manufacturing method according to claims 11 or 12, comprising:
an optical element arranged on the device substrate; and
a molded integral cover substrate providing a hermetically sealed cover for the optical device, within which the optical device is housed, wherein the molded cover substrate comprises a cap element with a bulged sidewall region between a socket region and a ceiling region.

14. The hermetically housed optical device according to claim 13, wherein the sidewall region and/or the ceiling region of the integral cap element of the molded cover substrate comprises a material that is permeable for transmission and/or reception radiation of the optical device, and for coupling and/or decoupling electromagnetic radiation.

15. The housed radiation-emitting device according to claim 13 or 14,
wherein the hermetically sealed cover comprises a reactive atmosphere and/or the cavity exclusively contains inorganic substances, and/or
wherein the hermetically sealed cover is hermetically sealed against the introduction of water vapor.

## Revendications

1. Procédé (100) aux étapes suivantes consistant à:
- prévoir (120) un substrat de moulage et un substrat de couverture qui sont connectés l'un à l'autre, où une zone de surface du substrat de moulage et/ou du substrat de couverture est structurée pour former une cavité fermée entre le substrat de couverture et le substrat de moulage,
- recuire (130) le substrat de couverture et le substrat de moulage pour réduire la viscosité du matériau de verre du substrat de couverture et prévoir (140) une surpression dans la cavité fermée par rapport à l'atmosphère environnante pour provoquer, sur base de la viscosité réduite du matériau de verre du substrat de couverture et de la surpression dans la cavité fermée par rapport à l'atmosphère environnante, une courbure vers l'extérieur du matériau de verre du substrat de couverture en partant de la cavité fermée jusqu'à une surface de butée d'un élément de butée distant du substrat de couverture pour obtenir un substrat de couverture moulé avec un élément de couvercle; et
- retirer l'élément de butée et le substrat de moulage du substrat de couverture moulé.

2. Procédé selon la revendication 1 permettant de réaliser un substrat de couvercle destiné à encapsuler un ou une pluralité d'éléments optiques, dans lequel le substrat de couverture moulé forme le substrat de couvercle avec l'élément de couvercle.

3. Procédé selon la revendication 1 ou 2, dans lequel le substrat de couverture présente un seul matériau homogène pour former le substrat de couverture moulé à partir de ce seul matériau homogène.

4. Procédé selon l'une des revendications précédentes, dans lequel l'étape consistant à prévoir un substrat de moulage et un substrat de couverture présente les étapes suivantes consistant à:
- prévoir un substrat de moulage avec une zone de surface structurée;
- disposer un substrat de couverture sur la zone de surface structurée du substrat de moulage, où le substrat de couverture présente un matériau de verre, et
- connecter le substrat de couverture avec le substrat de moulage pour former la cavité fermée entre le substrat de couverture et le substrat de moulage,
ou
dans lequel l'étape consistant à prévoir un substrat de moulage et un substrat de couverture présente les étapes suivantes consistant à:
- prévoir un substrat de moulage;
- disposer un substrat de couverture avec une zone de surface structurée sur le substrat de moulage, où le substrat de couverture présente un matériau de verre, et
- connecter le substrat de couverture avec le substrat de moulage pour former la cavité fermée entre le substrat de couverture et le substrat de moulage.

5. Procédé selon l'une des revendications précédentes, dans lequel la connexion du substrat de couverture avec le substrat de moulage est effectuée dans une atmosphère avec une pression ambiante atmosphérique définie pour inclure une pression atmosphérique définie dans les cavités fermées.

6. Procédé selon l'une des revendications précédentes, dans lequel l'étape consistant à recuire et à prévoir une surpression est effectuée sous forme d'un processus de flux de verre dans un four à pression négative pour obtenir dans la cavité fermée une surpression atmosphérique définie par rapport à l'atmosphère environnante.

7. Procédé selon l'une des revendications précédentes, dans lequel le substrat de couverture est courbé lors de l'étape consistant à recuire et à prévoir une surpression dans la zone de la cavité fermée jusqu'à une hauteur qui est prédéterminée par la distance entre la surface de butée et le substrat de couverture.

8. Procédé selon l'une des revendications précédentes, dans lequel est provoquée, lors du refroidissement du substrat de couverture moulé dans une plage de température supérieure à 650°C, une surpression atmosphérique dans les cavités fermées par rapport à l'atmosphère environnante, pour générer une courbure vers l'extérieur des zones de paroi latérale de l'élément de couvercle du substrat de couverture moulé.

9. Procédé selon l'une des revendications 1 à 7, dans lequel est provoquée, lors du refroidissement du substrat de couverture moulé dans une plage de température supérieure à 650°C, une pression atmosphérique négative dans les cavités fermées par rapport à l'atmosphère environnante, pour générer une courbure vers l'intérieur des zones de paroi latérale de l'élément de couvercle du substrat de couverture moulé.

10. Procédé selon l'une des revendications précédentes, dans lequel, lors de l'étape consistant à recuire (130) et à prévoir une surpression (140), soit les fenêtres latérales (24-1) et la zone de couvercle (24-2), soit les fenêtres latérales (24-1) et les zones de socle (24-3) sont courbées par le matériau de verre du substrat de couverture (20) à partir de la cavité fermée (30) jusqu'à la surface de butée (40-1) distante de l'élément de butée (40).

11. Procédé (200) permettant de fabriquer un composant optique encapsulé de manière hermétique, aux étapes suivantes consistant à:
mettre en œuvre le procédé (100) pour fabriquer un substrat de couverture moulé selon l'une des revendications précédentes,
prévoir (220) un substrat de composant avec un composant optique disposé sur ce dernier, et
connecter (230) le substrat de couverture moulé avec le substrat de composant pour encapsuler le composant optique.

12. Procédé selon la revendication 11, par ailleurs avec l'étape suivante consistant à:
mettre en oeuvre le procédé de fabrication de composants optiques encapsulés au niveau de la plaquette, où une pluralité de composants optiques sont disposés sur le substrat de composant, et où le substrat de couverture moulé présente une pluralité d'éléments de couvercle.

13. Composant optique encapsulé de manière hermétique, qui est fabriqué par le procédé de fabrication selon les revendications 11 ou 12, aux caractéristiques suivantes:
un composant optique disposé sur le substrat de composant; et
un substrat de couverture moulé d'une seule pièce qui crée une couverture fermée de manière hermétique pour le composant optique dans laquelle est encapsulé le composant optique, où le substrat de couverture moulé présente un élément de couvercle avec une zone de paroi latérale courbée entre une zone de socle et une zone de plafond.

14. Composant optique encapsulé de manière hermétique selon la revendication 13, dans lequel la zone de paroi latérale et/ou la zone de plafond de l'élément de couvercle d'une seule pièce du substrat de couverture moulé présente un matériau transparent au rayonnement de transmission ou de réception du composant optique, et est prévue pour le couplage et/ou le découplage du rayonnement électromagnétique.

15. Composant émetteur de rayonnement encapsulé selon la revendication 13 ou 14,
dans lequel la couverture fermée de manière hermétique présente une atmosphère réactive et/ou la cavité contient exclusivement des substances inorganiques,
et/ou
dans lequel la couverture fermée de manière hermétique est hermétiquement étanche à la pénétration de vapeur d'eau.
